(19) Europäisches Patentamt
European Patent Office
Office européen des brevets

(11) EP 4 344 390 B1

(12) **EUROPEAN PATENT SPECIFICATION**

(45) Date of publication and mention of the grant of the patent:
**04.03.2026 Bulletin 2026/10**

(21) Application number: **22196853.0**

(22) Date of filing: **21.09.2022**

(51) International Patent Classification (IPC):
***H10K 59/32*** (2023.01) ***H10K 50/19*** (2023.01)
***C07C 255/35*** (2006.01) ***H10K 85/60*** (2023.01)

(52) Cooperative Patent Classification (CPC):
**H10K 59/32; H10K 50/19; H10K 85/60; H10K 85/615; H10K 85/633; H10K 85/636; H10K 85/6572; H10K 85/6574;** H10K 2101/90

(54) **ORGANIC ELECTROLUMINESCENT DEVICE COMPRISING A RADIALENE OF FORMULA (I) AND A COMPOUND OF FORMULA (II), AND DISPLAY DEVICE COMPRISING THE ORGANIC ELECTROLUMINESCENT DEVICE**

ORGANISCHE ELEKTROLUMINESZENZVORRICHTUNG MIT EINEM RADIALEN DER FORMEL (I) UND EINER VERBINDUNG DER FORMEL (II) UND ANZEIGEVORRICHTUNG MIT DER ORGANISCHEN ELEKTROLUMINESZENZVORRICHTUNG

DISPOSITIF ÉLECTROLUMINESCENT ORGANIQUE COMPRENANT UN RADIALÈNE DE FORMULE (I) ET UN COMPOSÉ DE FORMULE (II), ET DISPOSITIF D’AFFICHAGE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.03.2024 Bulletin 2024/13**

(73) Proprietor: **Novaled GmbH**
**01099 Dresden (DE)**

(72) Inventors:
- **SCHULZE, Benjamin**
  **01099 Dresden (DE)**
- **ROSENOW, Thomas**
  **01099 Dresden (DE)**
- **RUNGE, Steffen**
  **01099 Dresden (DE)**
- **LUSCHTINETZ, Regina**
  **01099 Dresden (DE)**

(74) Representative: **Michalski Hüttermann & Partner Patentanwälte mbB**
**Kaistraße 16A**
**40221 Düsseldorf (DE)**

(56) References cited:
**EP-A1- 3 667 755**
**US-A1- 2022 069 258**
**US-B2- 8 603 642**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## Technical Field

The present invention relates to an electroluminescent device comprising a radialene of formula (I) and a compound of formula (II), and a display device comprising the organic electroluminescent device.

## Background Art

Organic electroluminescent devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved operating voltage stability over time and improved current efficiency.

US8603642 (B2) and EP3989305 (A1) disclose OLEDs comprising charge generation layers.

## DISCLOSURE

An aspect of the present invention provides an organic electroluminescent device comprising an anode layer, a cathode layer, a first light-emitting unit, a second light-emitting unit and at least one intermediate connecting region, wherein the at least one intermediate connecting region is arranged between the first and the second light-emitting unit,

wherein the first light-emitting unit comprises a first emission layer,
wherein the second light-emitting unit comprises a second emission layer,
wherein the at least one intermediate connecting region comprises an n-type charge generation layer, an intermediate layer, and a p-type charge generation layer,
wherein the n-type charge generation layer is arranged closer to the anode layer than the p-type charge generation layer;
wherein the p-type charge generation layer is arranged closer to the cathode layer than the n-type charge generation layer; and
wherein the intermediate layer is arranged between the n-type charge generation layer and the p-type charge generation layer
whereby
wherein the n-type charge generation layer comprises a matrix compound and a metal dopant,
wherein the p-type charge generation layer comprises a hole transport matrix compound and a radialene of formula (I),

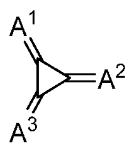

(I),

wherein in formula (I)

- $A^1$ is independently selected from a group of formula (Ia)

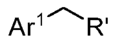

(Ia)

wherein $Ar^1$ is independently selected from substituted or unsubstituted aryl and substituted or unsubstituted heteroaryl
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Ib)

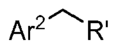

(Ib),

wherein $Ar^2$ is independently selected from substituted or unsubstituted aryl and substituted or unsubstituted heteroaryl
wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Ic)

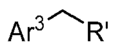

(Ic),

wherein $Ar^3$ is independently selected from substituted or unsubstituted aryl and substituted or unsubstituted heteroaryl
wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- and wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;

wherein the intermediate layer comprises at least one hole transport compound selected from an arylamine compound, diarylamine compound, triarylamine compound, a compound of formula (IIa) or a compound of formula (IIb):

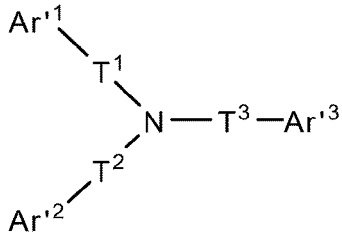 (IIa), 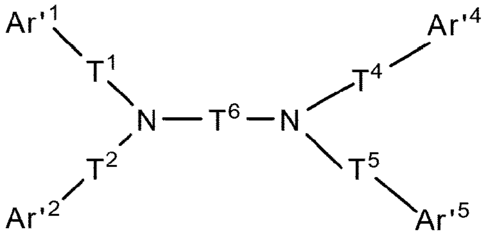 (IIb),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar'^1$, $Ar'^2$, $Ar'^3$, $Ar'^4$ and $Ar'^5$are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar'^1$, $Ar'^2$, $Ar'^3$, $Ar'^4$ and $Ar'^5$ are selected the same or different from the group comprising H, D, F, $C(=O)R'^2$, CN, $Si(R'^2)_3$, $P(=O)(R'^2)_2$, $OR'^2$, $S(=O)R'^2$, $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R'^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

It should be noted that throughout the application and the claims any $A^n$, $B^n$, $R^n$, $X^n$ etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electroluminescent device wherein the light is emitted through the cathode layer.

The term "bottom emission device" is understood to mean an organic electroluminescent device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electroluminescent device according to the invention solves the problem underlying the present invention by enabling devices in various aspects superior over the organic electroluminescent devices known in the art, in particular with respect to improved operating voltage stability over time.

According to one embodiment of the present invention, the intermediate layer essentially consists out of one or more of the hole transport compounds.

According to one embodiment, the intermediate layer is an organic intermediate layer.

The term "consisting essentially of" in the context of this invention especially means and/or includes a ratio (wt%/wt%) of ≥95 wt.-%, more preferably ≥97.0 wt.-%, more preferably ≥97.25 wt.-%, more preferably ≥97.5 wt.-%, more preferably ≥97.75 wt.-% more preferably ≥98.0 wt.-%, more preferably ≥99.0 wt.-%, more preferably ≥99.5 wt.-%, more preferably ≥99.75 wt.-%, more preferably ≥99.80 wt.-%, more preferably ≥99.85 wt.-%, more preferably ≥99.9 wt.-%, more preferably ≥99.95 wt.-% and most preferred ≥99.99 wt.-%.

According to an embodiment of the present invention the hole transport compound of the intermediate layer is selected from arylamine, diarylamine, triarylamine, formula (IIa) and formula (IIb).

According to an embodiment of the present invention the hole transport compound of the intermediate layer is selected from the compound of formula (IIa) or the compound of formula (IIb).

According to an embodiment of the present invention the hole transport compound of the intermediate layer is selected from the compound of formula (IIa).

According to one embodiment, the intermediate layer essentially consists of at least one compound selected from arylamine, diarylamine, triarylamine, formula (IIa) and formula (IIb).

According to one embodiment, the intermediate layer essentially consists of at least one compound selected from formula (IIa) and formula (IIb).

According to one embodiment, the at least one hole transport compound essentially consists of at least one compound selected from formula (IIa) and formula (IIb).

According to one embodiment, the intermediate layer essentially consists of at least one the compound of formula (IIa).

According to one embodiment, the intermediate layer essentially consists of a compound of formula (IIa).

According to one embodiment, the at least one hole transport compound is a compound of formula (IIa).

According to one embodiment, the intermediate layer has a layer thickness of ≤20 nm; ≤15 nm, ≤10 nm, ≤5 nm; ≤4 nm; ≤3 nm; ≤2 nm; ≤1 nm, ≤0.5 nm.

According to one embodiment, the intermediate layer has a layer thickness in the range of ≥ 0.05 nm to ≤20.0 nm to, ≥0.1 nm to ≤15.0 nm, ≥0.2 nm to ≤10.0 nm, ≥0.3 nm to ≤5.0 nm, ≥0.4 nm to ≤4.0 nm, ≥0.5 nm to ≤3.0 nm, ≥0.5 nm to ≤2.0 nm, ≥0.5 nm to ≤1.5 nm,. ≥0.5 nm to ≤1.25 nm, ≥0.5 nm to ≤1.0 nm.

According to one embodiment, the p-type charge generation layer is in direct contact to the intermediate layer.

According to one embodiment, the n-type charge generation layer is in direct contact to the intermediate layer.

According to one embodiment, the p-type charge generation layer is in direct contact to the intermediate layer and the n-type charge generation layer is in direct contact to the intermediate layer.

According to one embodiment, the hole transport compound(s) of the intermediate layer and the hole transport matrix compound of the p-type generation layer is/are selected the same.

According to one embodiment, the ratio of layer thickness between the intermediate layer and the p-type charge generation layer is in the range of ≥0.01 to ≤10.0, ≥0.02 to ≤5.0, ≥0.03 to ≤2.5, ≥0.04 to ≤2.0, ≥0.05 to ≤1.0, ≥0.05 to ≤0.5, ≥0.05 to ≤0.4, ≥0.05 to ≤0.3, ≥0.05 to ≤0.2, ≥0.05 to ≤0.2.

According to one embodiment, the ratio of layer thickness between the intermediate layer and the n-type charge generation layer is in the range of ≥0.01 to ≤10.0, ≥0.02 to ≤5.0, ≥0.03 to ≤2.5, ≥0.04 to ≤2.0, ≥0.05 to ≤1.0, ≥0.05 to ≤0.5, ≥0.05 to ≤0.4, ≥0.06 to ≤0.3.

According to one embodiment, the ratio of layer thickness between the intermediate layer and p-type charge generation layer is in the range of ≥0.01 to ≤10.0, ≥0.02 to ≤5.0, ≥0.03 to ≤2.5, ≥0.04 to ≤2.0, ≥0.05 to ≤1.0, ≥0.05 to ≤0.5, ≥0.05 to ≤0.4, ≥0.05 to ≤0.3, ≥0.05 to ≤0.2, ≥0.05 to ≤0.2, and ratio of layer thickness of the intermediate layer and n-type charge generation layer is in the range of ≥0.01 to ≤10.0, ≥0.02 to ≤5.0, ≥0.03 to ≤2.5, ≥0.04 to ≤2.0, ≥0.05 to ≤1.0, ≥0.05 to ≤0.5, ≥0.05 to ≤0.4, ≥0.06 to ≤0.3.

According to one embodiment, the ratio of layer thickness between the intermediate layer and p-type charge generation layer is in the range of ≥0.05 to ≤0.2, and ratio of layer thickness of the intermediate layer and n-type charge generation layer is in the range of ≥0.06 to ≤0.3.

According to one embodiment, wherein the hole transport compound of the intermediate layer has HOMO energy level calculated by using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, and the hole transport matrix compound of the p-type charge generation layer has a HOMO energy level calculated by using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase,

wherein the absolute value of the difference between the HOMO energy level of the hole transport compound of the intermediate layer and the HOMO energy level of the hole transport matrix compound of the p-type charge generation layer is ≤0.5 eV; preferably ≤0.4 eV, more preferably ≤0.3 eV, even more preferably ≤0.2 eV, even more preferably ≤0.1 eV, and

most preferably 0 eV.

Radialene of formula (I):

According to one embodiment of the present invention, the radialene of formula (I) has a LUMO when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase of ≤ -4.70 eV, preferably ≤ -4.80 eV, more preferably ≤ - 4.90 eV, still more preferably ≤ -5.00 eV, still more preferably ≤ -5.10 eV, still more preferably ≤ -5.15 eV, and most preferably ≤ -5.20 eV.

According to one embodiment of the present invention, the radialene of formula (I) has a LUMO when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range of ≥ -7.00 eV to ≤ -4.70 eV, preferably ≥ - 6.50 eV to ≤ -4.80 eV, more preferably ≥ -6.00 eV to ≤ -4.85 eV, still more preferably ≥ -5.80 eV to ≤ -4.90 eV, still more preferably ≥ -5.60 eV to ≤ -5.00 eV, still more preferably ≥ -5.50 eV to ≤ -5.10 eV, and still more preferably ≥ -5.45 eV to ≤ -5.20 eV.

According to one embodiment of the present invention, the radialene of formula (I) comprises at least one $CF_3$ group.

According to one embodiment of the present invention, the radialene of formula (I) comprises one to three $CF_3$ group.

According to one embodiment of the present invention, the radialene of formula (I) comprises less than nine cyano moieties.

According to one embodiment of the present invention, the radialene of formula (I) comprises less than eight cyano moieties.

According to one embodiment of the present invention, the radialene of formula (I) comprises at least one cyano moiety.

According to one embodiment of the present invention, the radialene of formula (I) comprises at least two cyano moieties.

According to one embodiment of the present invention, the radialene of formula (I) comprises at least three cyano moieties.

According to one embodiment of the present invention, the radialene of formula (I) comprises at least four cyano moieties.

According to one embodiment of the present invention, the radialene of formula (I) comprises from 3 to 8 cyano moieties.

According to one embodiment of the present invention, the radialene of formula (I) comprises from 3 to 7 cyano moieties.

According to one embodiment of the present invention, the radialene of formula (I) comprises from 4 to 7 cyano moieties.

According to one embodiment of the present invention, formula (I) comprises at least 10 fluorine atoms, at least 12 fluorine atoms, at least 13 fluorine atoms,14 at least fluorine atoms, at least 15 fluorine atoms, at least 16 fluorine atoms, at least 17 fluorine atoms, or at least 18 fluorine atoms.

According to one embodiment of the present invention, formula (I) comprises 10 to 20 fluorine atoms, or 10 to 18 fluorine atoms or 12 to 18 fluorine atoms.

According to one embodiment of the present invention, formula (I) comprises 4 to 7 cyano moieties and 12 to 18 fluorine atoms.

According to one embodiment of the present invention, in formula (I), at least two of $A^1$, $A^2$, and $A^3$ are selected the same.

According to one embodiment of the present invention, in formula (I), $A^2$ and $A^3$ are identical.

According to one embodiment of the present invention, in formula (I), $A^1$, $A^2$ and $A^3$ are identical

According to one embodiment of the present invention, in formula (I) $A^1$ is different from $A^2$ and/or $A^3$.

According to one embodiment of the present invention, in formula (I) $A^1$ is different from $A^2$ and/or $A^3$, and $A^2$ and $A^3$ are selected the same.

According one embodiment, in formula (I) $Ar^1$ is selected from is selected from substituted or unsubstituted $C_6$ to $C_{36}$ aryl, and substituted or unsubstituted $C_3$ to $C_{36}$ heteroaryl.

According to one embodiment, $Ar^1$, $Ar^2$, and $Ar^3$ are independently selected from substituted or unsubstituted $C_6$ to $C_{36}$ aryl, and substituted or unsubstituted $C_3$ to $C_{36}$ heteroaryl.

According one embodiment, in formula (I) $Ar^1$ is selected from is selected from substituted or unsubstituted $C_6$ to $C_{24}$ aryl, and substituted or unsubstituted $C_3$ to $C_{24}$ heteroaryl.

According to one embodiment, in formula (I) $Ar^1$, $Ar^2$, and $Ar^3$ are independently selected from substituted or

unsubstituted $C_6$ to $C_{24}$ aryl, and substituted or unsubstituted $C_3$ to $C_{24}$ heteroaryl.

According one embodiment, in formula (I) $Ar^1$ is selected from is selected from substituted or unsubstituted $C_6$ to $C_{18}$ aryl, and substituted or unsubstituted $C_3$ to $C_{18}$ heteroaryl.

According to one embodiment, in formula (I) $Ar^1$, $Ar^2$, and $Ar^3$ are independently selected from substituted or unsubstituted $C_6$ to $C_{189}$ aryl, and substituted or unsubstituted $C_3$ to $C_{18}$ heteroaryl.

According to one embodiment of the present invention, in formula (I) $Ar^1$ is independently selected from substituted or unsubstituted $C_6$ to $C_{12}$ aryl and substituted or unsubstituted $C_3$ to $C_{12}$ heteroaryl.

According to one embodiment of the present invention, in formula (I) $Ar^1$, $Ar^2$, and $Ar^3$ are independently selected from substituted or unsubstituted $C_6$ to $C_{12}$ aryl and substituted or unsubstituted $C_3$ to $C_{12}$ heteroaryl.

According to one embodiment of the present invention, in formula (I) $Ar^1$ is independently selected from substituted or unsubstituted $C_6$ aryl and substituted or unsubstituted $C_3$ to $C_5$ heteroaryl.

According to one embodiment of the present invention, in formula (I) $Ar^1$, $Ar^2$, and $Ar^3$ are independently selected from substituted or unsubstituted $C_6$ aryl and substituted or unsubstituted $C_3$ to $C_5$ heteroaryl.

According to one embodiment of the present invention, in formula (I) the substituents on $Ar^1$ is independently selected from the group consisting of an electron-withdrawing group, halogen, Cl, F, CN, $NO_2$, partially fluorinated alkyl, and perfluorinated alkyl.

According to one embodiment of the present invention, in formula (I) the substituents on $Ar^1$, $Ar^2$, and $Ar^3$ are independently selected from the group consisting of an electron-withdrawing group, halogen, Cl, F, CN, $NO_2$, partially fluorinated alkyl, and perfluorinated alkyl.

According to one embodiment of the present invention, in formula (I) the substituents on $Ar^1$ is independently selected from the group consisting of an electron-withdrawing group, halogen, Cl, F, CN, partially fluorinated alkyl, and perfluorinated alkyl.

According to one embodiment of the present invention, in formula (I) the substituents on $Ar^1$, $Ar^2$, and $Ar^3$ are independently selected from the group consisting of an electron-withdrawing group, halogen, Cl, F, CN, partially fluorinated alkyl, and perfluorinated alkyl.

According to one embodiment of the present invention, in formula (I) the substituents on $Ar^1$ is independently selected from the group consisting of Cl, F, CN, $NO_2$ and perfluorinated alkyl.

According to one embodiment of the present invention, in formula (I) the substituents on $Ar^1$, $Ar^2$, and $Ar^3$ are independently selected from the group consisting of Cl, F, CN, $NO_2$ and perfluorinated alkyl.

According to one embodiment of the present invention, in formula (I) the substituents on $Ar^1$ is independently selected from the group consisting of Cl, F, CN, and perfluorinated alkyl.

According to one embodiment of the present invention, in formula (I) the substituents on $Ar^1$, $Ar^2$, and $Ar^3$ are independently selected from the group consisting of Cl, F, CN, and perfluorinated alkyl.

According to one embodiment of the present invention, in formula (I) the substituents on $Ar^1$ is independently selected from the group consisting of F, CN, $NO_2$ and perfluorinated alkyl.

According to one embodiment of the present invention, in formula (I) the substituents on $Ar^1$, $Ar^2$, and $Ar^3$ are independently selected from the group consisting of F, CN, $NO_2$ and perfluorinated alkyl.

According to one embodiment of the present invention, in formula (I) the substituents on $Ar^1$ is independently selected from the group consisting of F, CN, and perfluorinated alkyl.

According to one embodiment of the present invention, in formula (I) the substituents on $Ar^1$, $Ar^2$, and $Ar^3$ are independently selected from the group consisting of F, CN, and perfluorinated alkyl.

According to one embodiment of the present invention, in formula (I) the substituents on $Ar^1$ is independently selected from the group consisting of F, CN, $NO_2$ and $CF_3$.

According to one embodiment of the present invention, in formula (I) the substituents on $Ar^1$, $Ar^2$, and $Ar^3$ are independently selected from the group consisting of F, CN, $NO_2$ and $CF_3$.

According to one embodiment of the present invention, in formula (I) the substituents on $Ar^1$ is independently selected from the group consisting of F, CN, and $CF_3$.

According to one embodiment of the present invention, in formula (I) the substituents on $Ar^1$, $Ar^2$, and $Ar^3$ are independently selected from the group consisting of F, CN, and $CF_3$.

According to one embodiment of the present invention, in formula (I) $Ar^1$ is independently each comprise more than one and less than five substituents, preferably more than two and less than four, for example 4.

According to one embodiment of the present invention, in formula (I) $Ar^1$, $Ar^2$, and $Ar^3$ independently each comprise more than one and less than five substituents, preferably more than two and less than four, for example 4.

According to one embodiment of the present invention, in formula (I) each R' is independently selected from electron-withdrawing group, partially fluorinated $C_1$ to $C_8$ alkyl, perfluorinated $C_1$ to $C_8$ alkyl, halogen, F and CN.

According to one embodiment of the present invention, in formula (I) each R' is independently selected from partially fluorinated $C_1$ to $C_8$ alkyl, perfluorinated $C_1$ to $C_8$ alkyl, halogen, F and CN.

According to one embodiment of the present invention, in formula (I) each R'is independently selected from $CF_3$,

F and CN.

According to one embodiment of the present invention, in formula (I) each R' is CN.

According to one embodiment of the present invention, in formula (I) $Ar^1$, $Ar^2$ and $Ar^3$ are independently selected from a group according to the following formula (III) and preferably each R' is selected from CN:

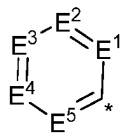

(III)

wherein

$E^1$ is selected from $CW^1$ or N;
$E^2$ is selected from $CW^2$ or N;
$E^3$ is selected from $CW^3$ or N;
$E^4$ is selected from $CW^4$ or N;
$E^5$ is selected from $CW^5$ or N;
$W^1$, $W^2$, $W^3$, $W^4$ and $W^5$ (if present) are independently selected from electron-withdrawing group, CN, halogen, Cl, F, $NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_6$ alkoxy, $OCF_3$, substituted or unsubstituted $C_6$ to $C_{30}$ aryl, substituted or unsubstituted $C_3$ to $C_{30}$ heteroaryl, D or H,
wherein the one or more substituents is independently selected from D, halogen, Cl, F, CN, $NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy,
wherein the asterisk "*" denotes the binding position.

According to one embodiment of the present invention, in formula (III) $W^1$, $W^2$, $W^3$, $W^4$ and $W^5$ (if present) are independently selected from electron-withdrawing group, CN, halogen, Cl, F, $NO_2$, partially fluorinated or perfluorinated $C_1$ to $C_8$ alkyl, partially fluorinated or perfluorinated $C_1$ to $C_6$ alkoxy, D or H, and wherein preferably each R' is selected from CN.

According to one embodiment of the present invention, in formula (I), $Ar^1$, $Ar^2$ and/or $Ar^3$ are independently selected from one of the following groups and preferably each R' is selected from CN:

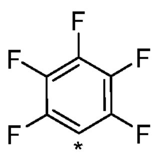
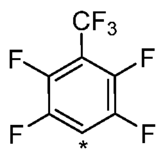
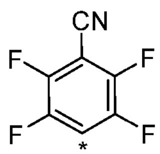
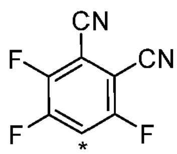
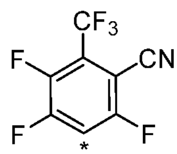
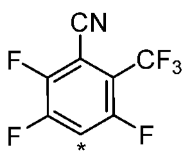
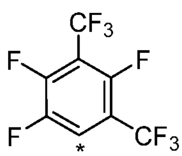
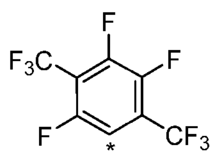
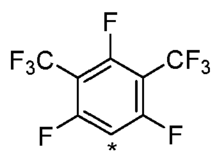
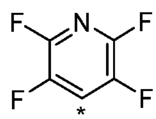
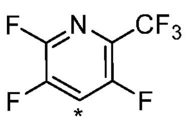
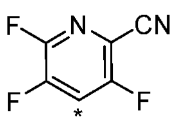
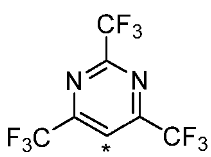
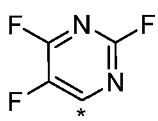
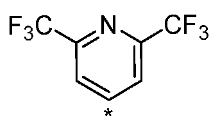
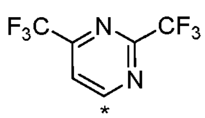
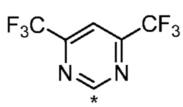
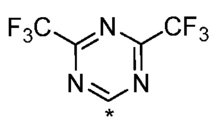
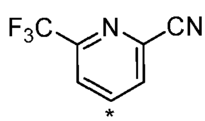
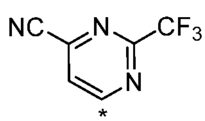

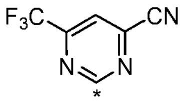 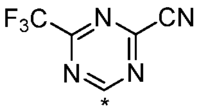 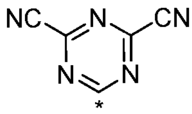 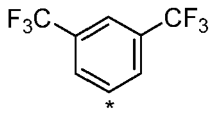 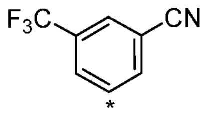

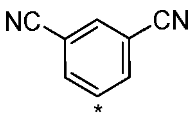 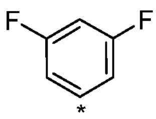 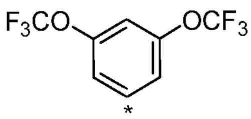 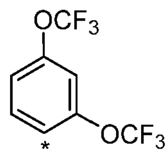 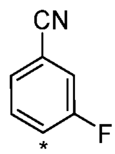

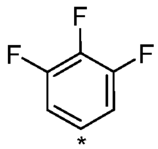 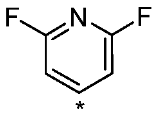 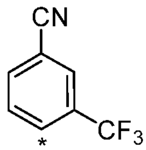 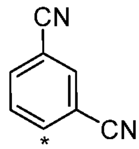 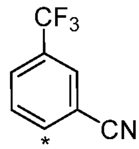

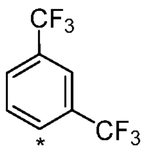 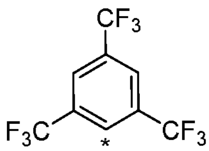 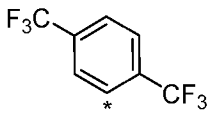 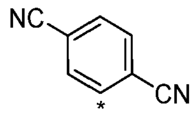 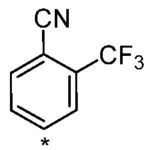

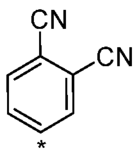 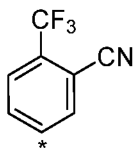 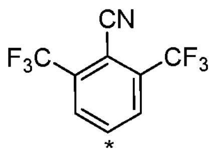 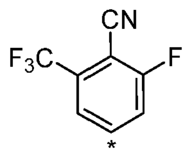 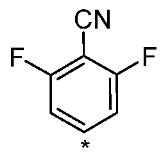

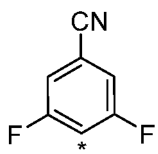 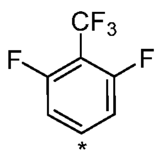 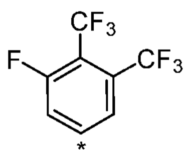 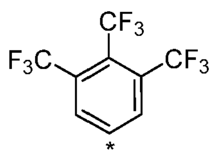 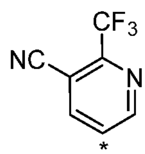

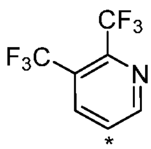 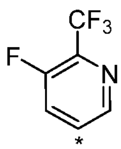 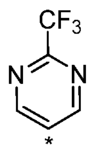 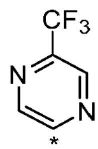 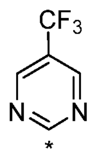

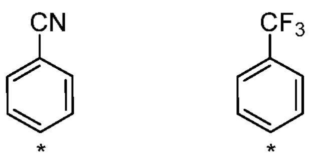 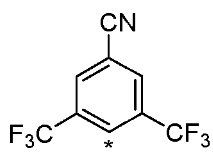 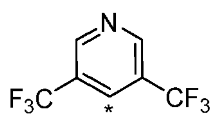 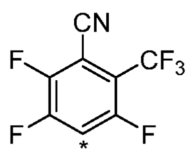

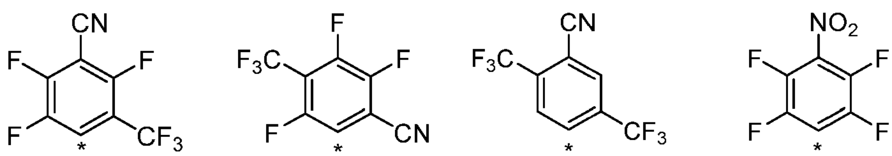

wherein the asterisk "*" denotes the binding position.

According to one embodiment of the present invention, in formula (I), $Ar^1$ is selected from one of the following groups and preferably each R' is selected from CN:

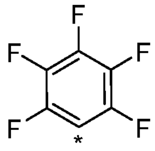 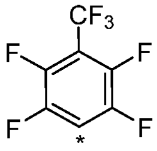 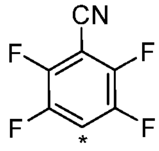 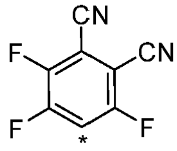 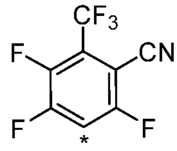

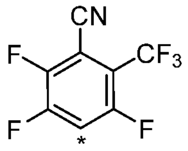 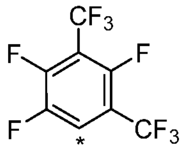 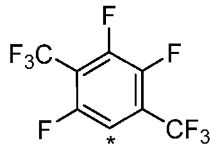 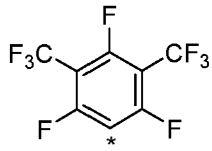 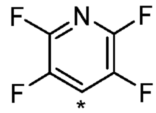

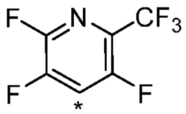 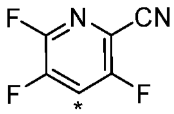 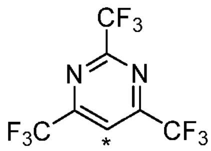 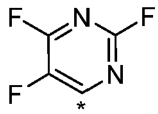 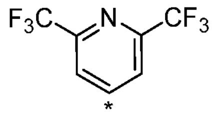

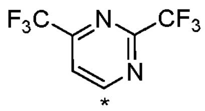 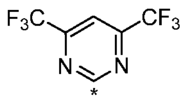 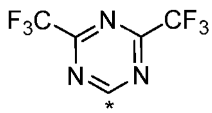 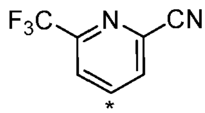 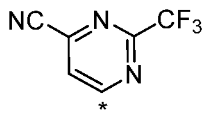

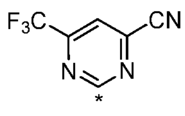 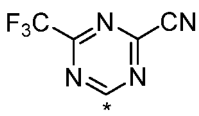 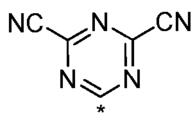 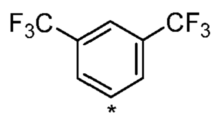 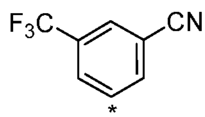

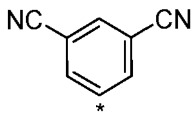 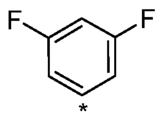 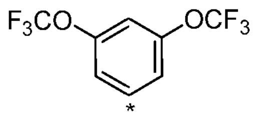 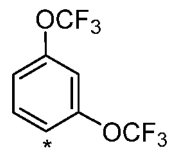 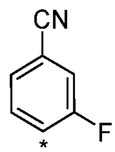

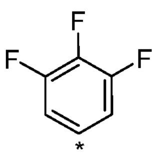 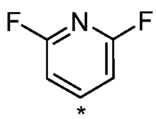 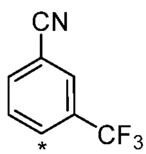 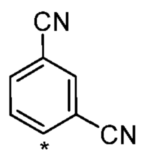 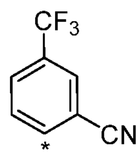

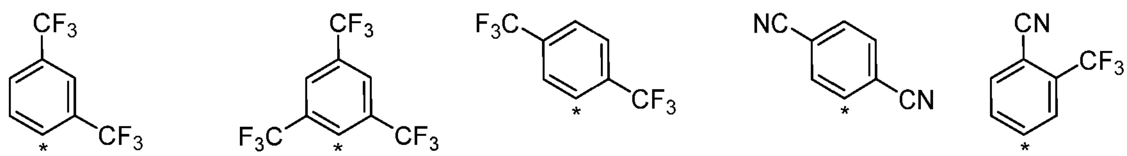

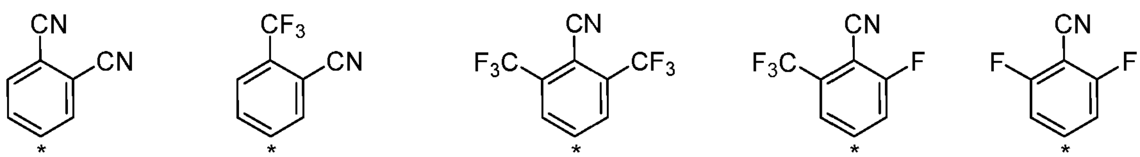

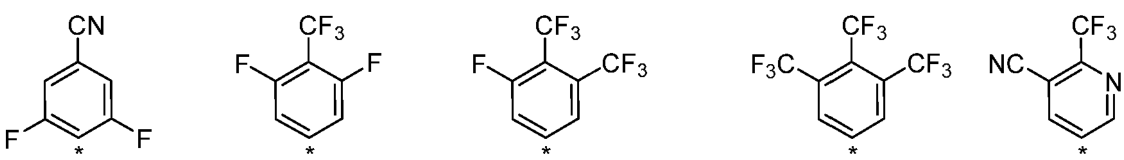

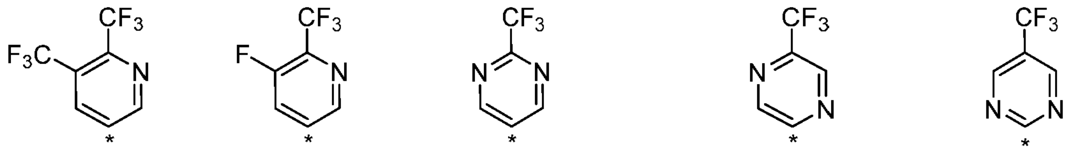

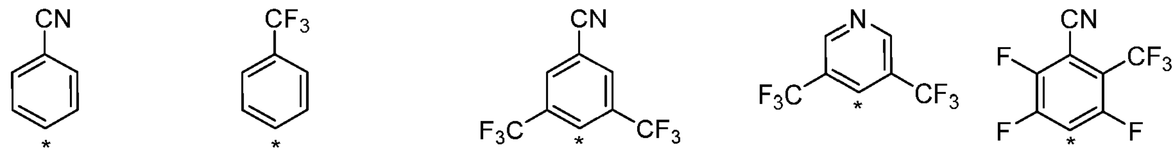

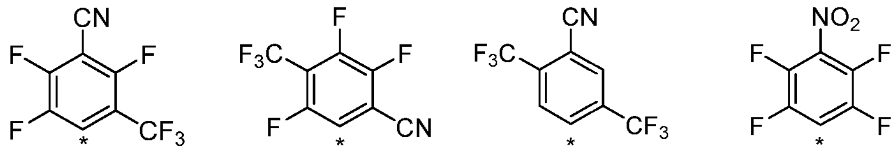

wherein the asterisk "*" denotes the binding position.

According to one embodiment of the present invention, in formula (I), $Ar^1$, $Ar^2$ and/or $Ar^3$ are independently selected from one of the following groups and preferably each R' is selected from CN:

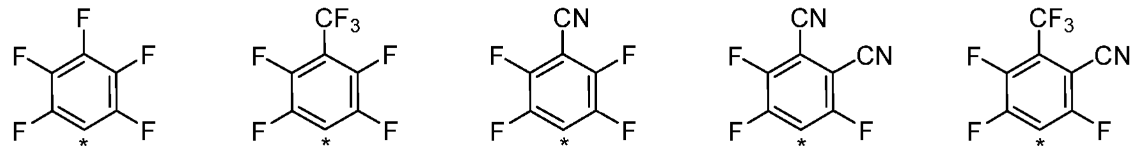

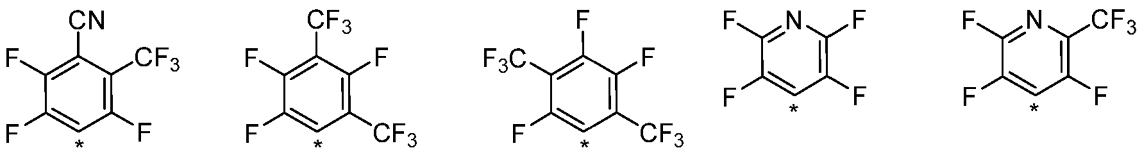

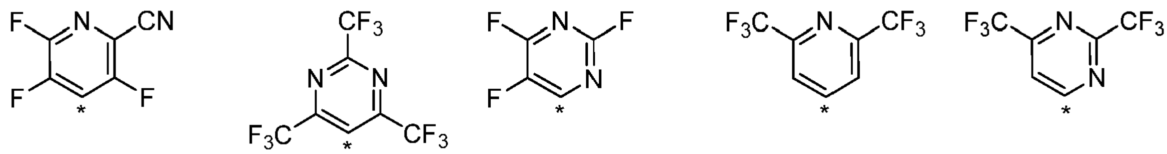

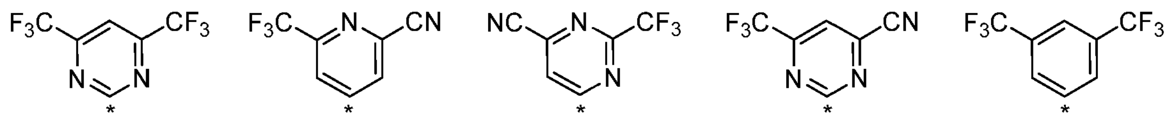

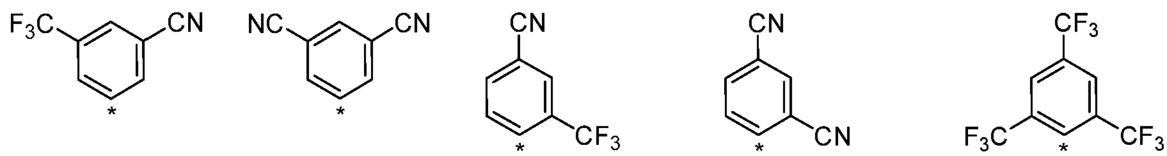

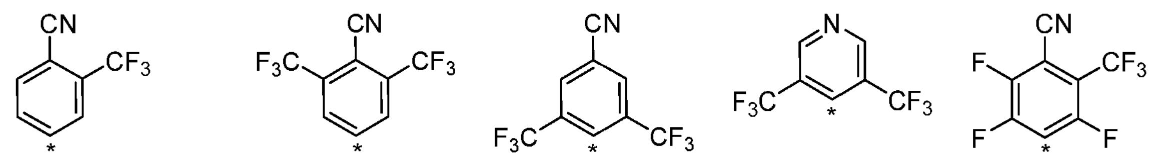

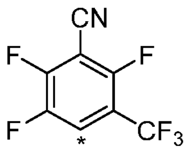 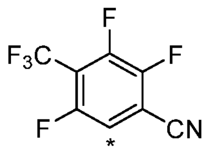 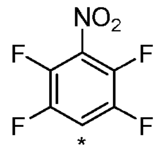 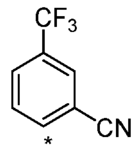

wherein the asterisk "*" denotes the binding position.

According to one embodiment of the present invention, in formula (I), $Ar^1$ is independently selected from one of the following groups and preferably each R' is selected from CN:

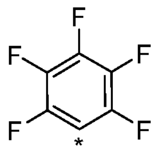 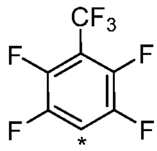 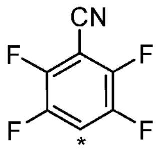 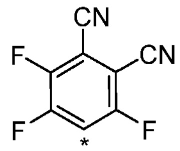 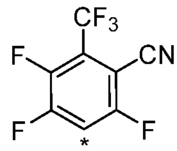

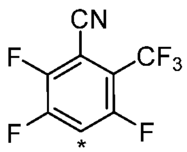 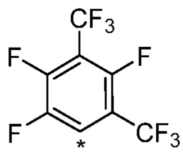 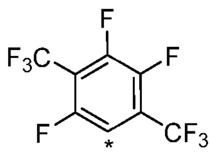 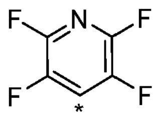 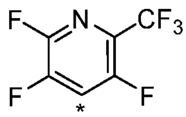

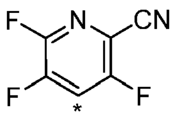 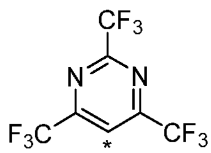 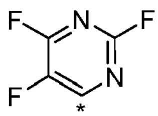 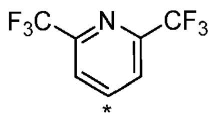 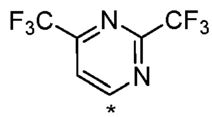

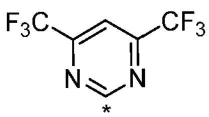 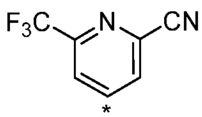 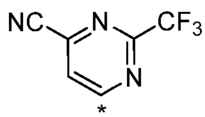 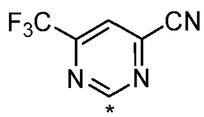 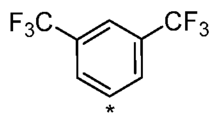

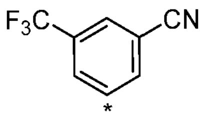 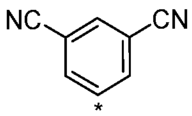 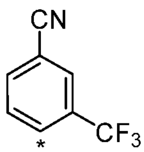 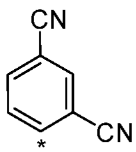 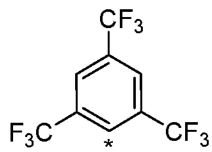

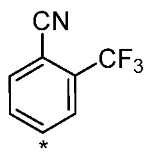 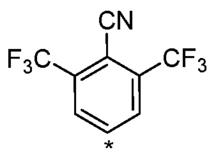 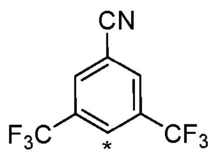 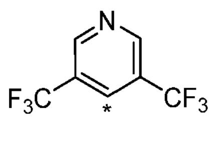 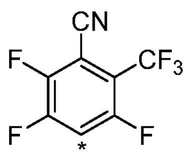

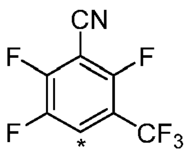 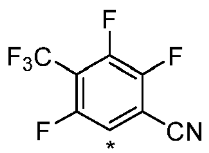 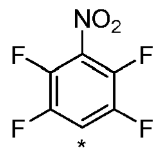 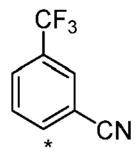

wherein the asterisk "*" denotes the binding position.

According to one embodiment of the present invention, in formula (I), $Ar^1$, $Ar^2$ and/or $Ar^3$ are independently selected from one of the following groups and preferably each R' is selected from CN:

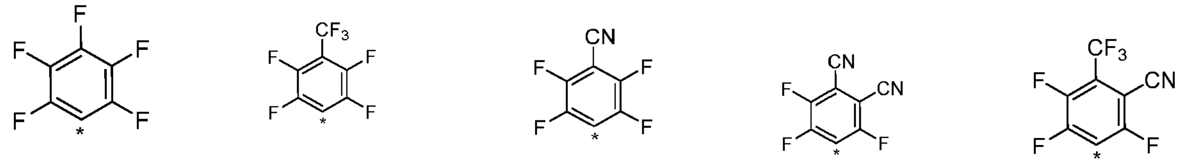

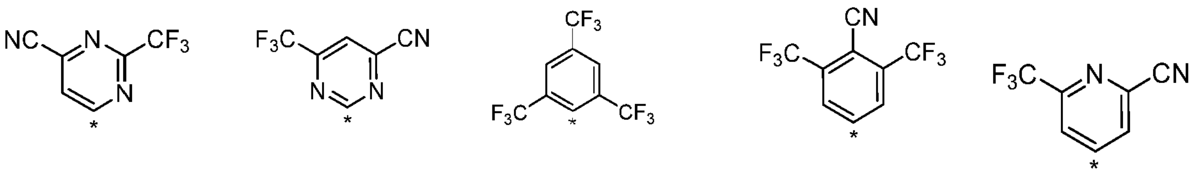

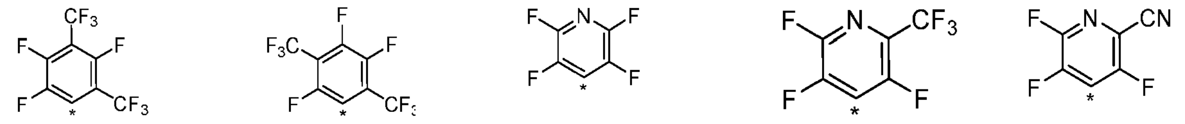

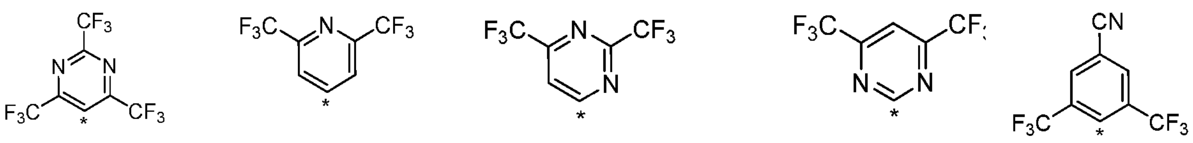

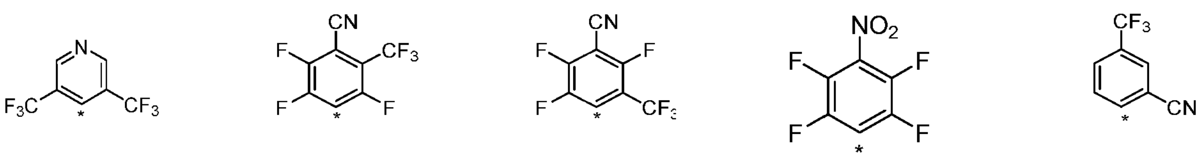

wherein the asterisk "*" denotes the binding position.

According to one embodiment of the present invention, in formula (I), $Ar^1$ is selected from one of the following groups and preferably each R' is selected from CN:

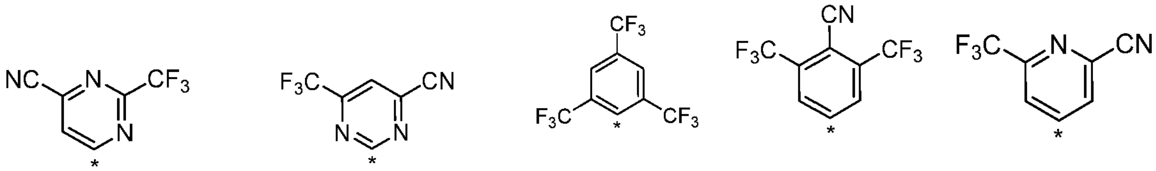

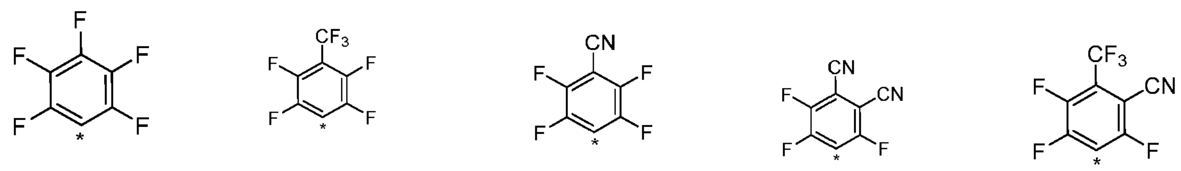

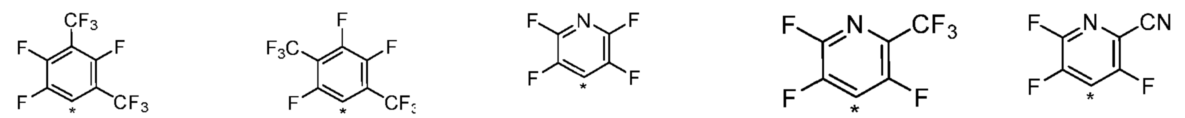

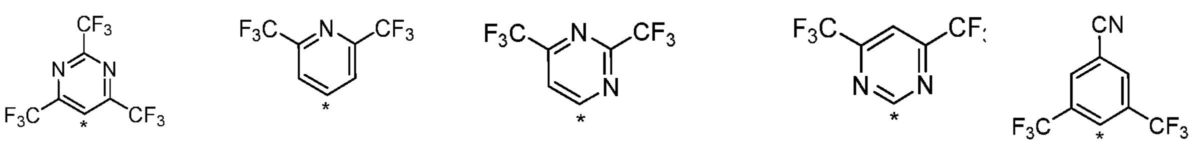

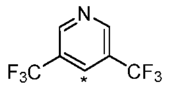 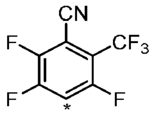 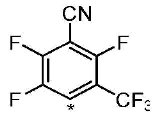 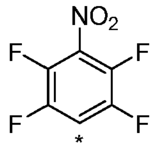 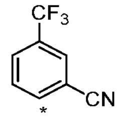

wherein the asterisk "*" denotes the binding position.

According to one embodiment, $Ar^1$ of formula (I) is selected from one of the following groups of B1 to B64, preferably R' of $A^1$ is CN, or $Ar^1$, $Ar^2$, and/or $Ar^3$ of formula (I) are independently selected from one of the following groups of B1 to B64 and preferably each R' of $A^1$, $A^2$, and $A^3$ is CN:

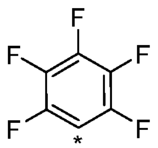 B1, 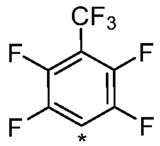 B2, 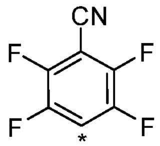 B3, 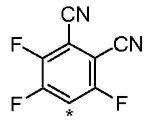 B4, 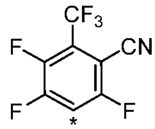 B5,

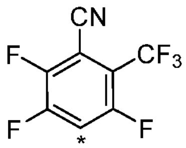 B6, 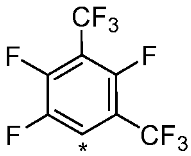 B7, 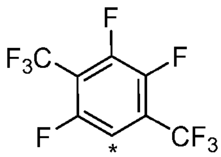 B8, 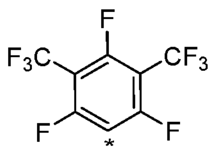 B9, 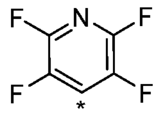 B10,

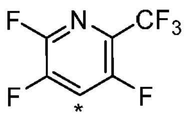 B11, 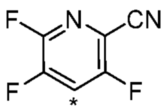 B12, 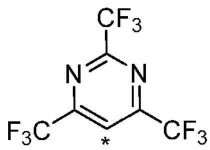 B13, 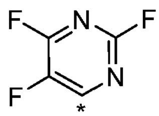 B14, 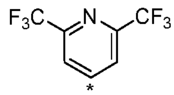 B15,

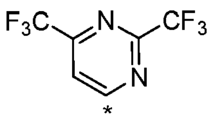 B16, 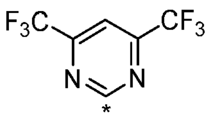 B17, 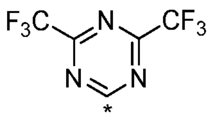 B18, 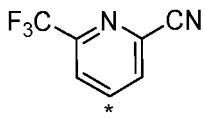 B19, 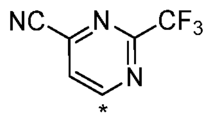 B20,

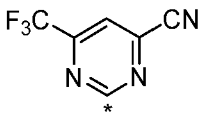 B21, 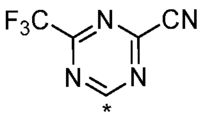 B22, 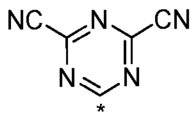 B23, 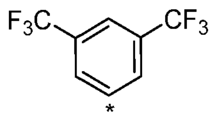 B24, 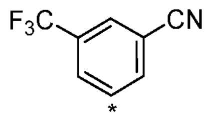 B25,

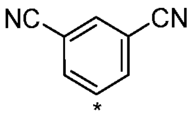 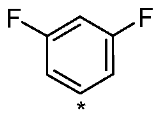 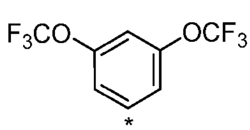 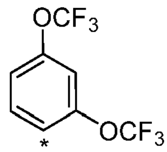 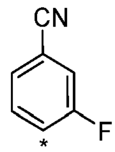

B26, B27, B28, B29, B30,

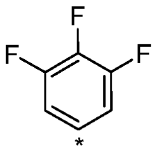 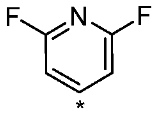 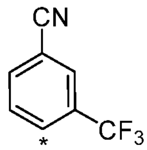 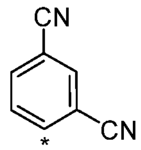 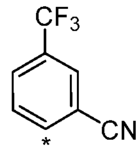

B31, B32, B33, B34, B35,

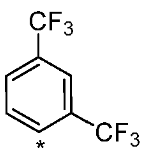 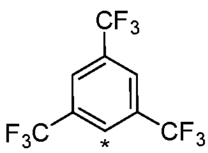 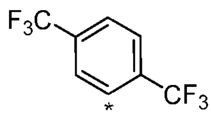 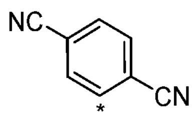 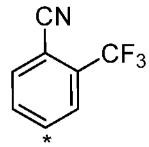

B36, B37, B38, B39, B40,

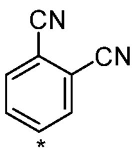 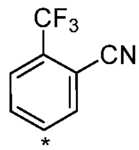 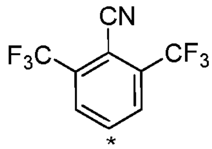 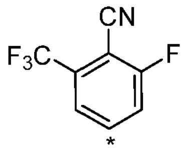 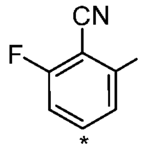

B41, B42, B43, B44, B45,

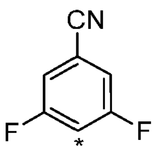 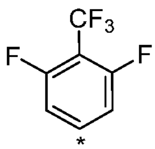 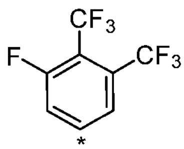 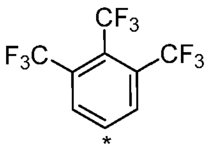 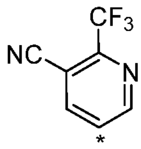

B46, B47, B48, B49, B50,

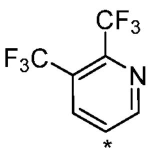 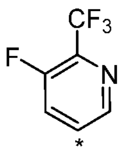 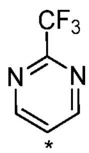 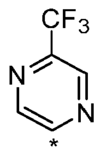 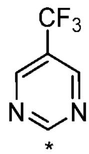

B51, B52, B53, B54, B55,

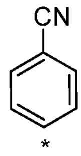 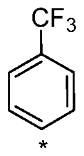 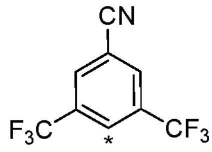 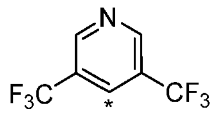 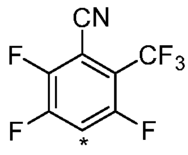

B56, B57, B58, B59, B60,

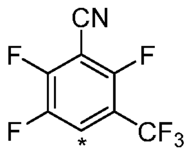 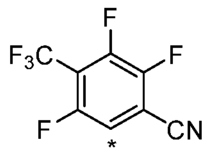 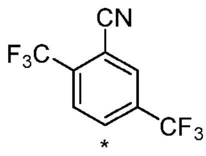 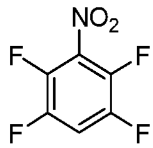

B61, B62, B63 B64

wherein the asterisk "*" denotes the binding position.

According to one embodiment, $Ar^1$ of formula (I) is selected from one of the following groups preferably R' of $A^1$ is CN, or $Ar^1$, $Ar^2$ and $Ar^3$ of formula (I) are independently selected from one of the following groups and preferably each R' of $A^1$, $A^2$, and $A^3$ is CN :

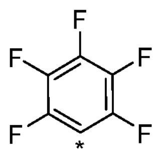 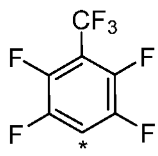 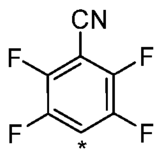 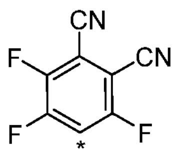 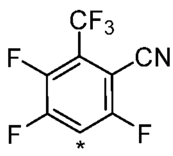

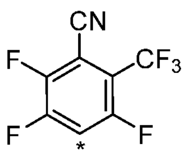 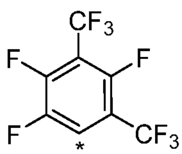 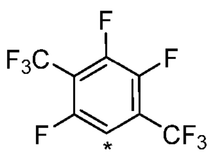 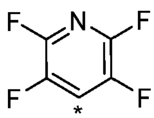 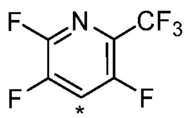

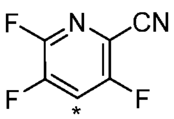 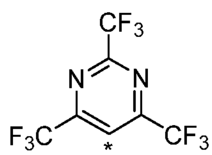 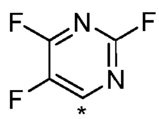 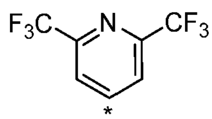 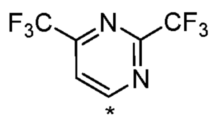

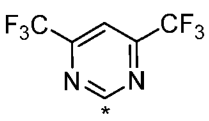 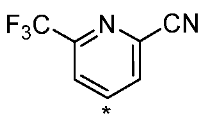 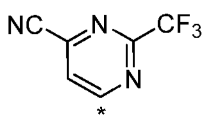 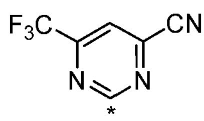 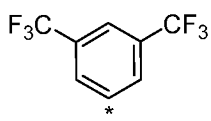

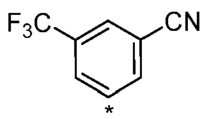 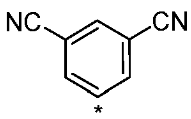 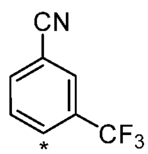 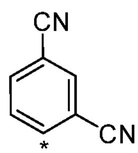 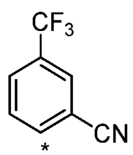

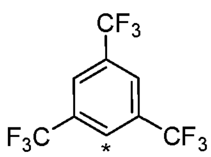 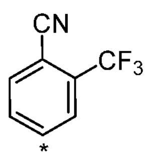 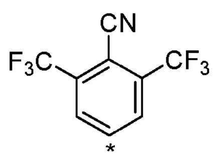 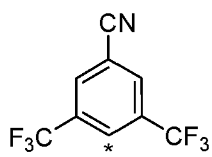 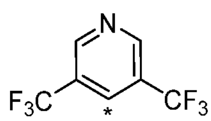

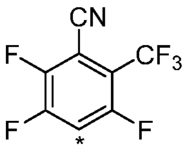 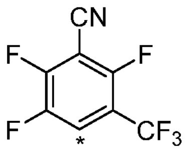 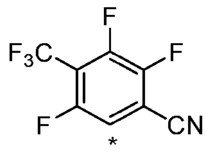 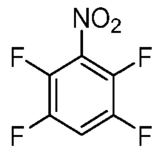

wherein the asterisk "*" denotes the binding position.

According to one embodiment, $Ar^1$ is selected from one of the following groups and preferably R' of $A^1$ is CN, or $Ar^1$, $Ar^2$ and $Ar^3$ of formula (I) are independently selected from one of the following groups and preferably each R' of $A^1$, $A^2$, and $A^3$ is CN:

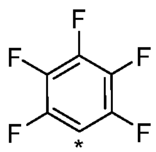 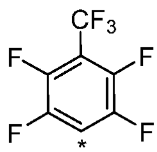 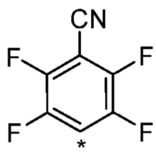 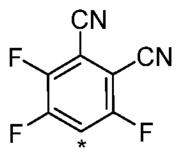 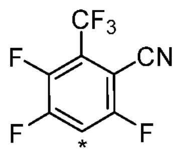

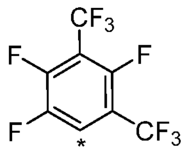 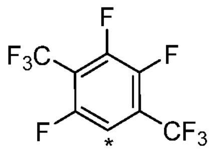 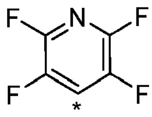 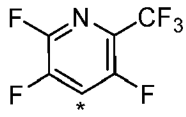 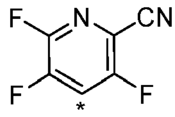

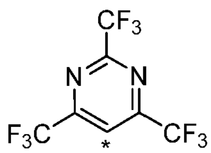 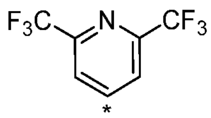 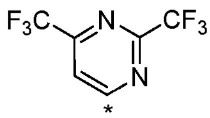 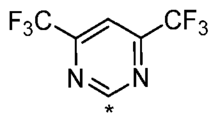 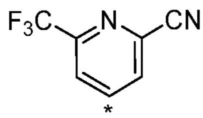

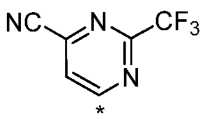 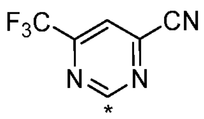 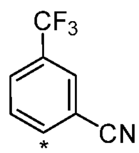 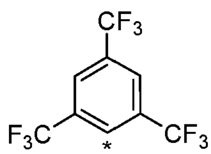 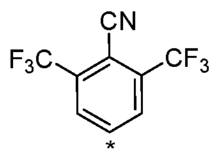

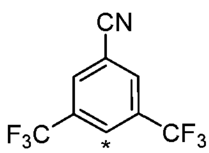 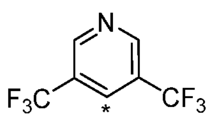 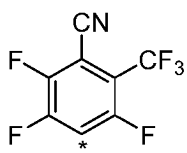 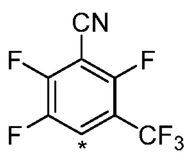 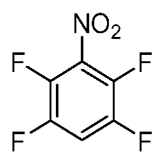

wherein the asterisk "*" denotes the binding position.

According to one embodiment of the present invention, the radialene of formula (I) is selected from one of the following compounds A1 to A16, wherein R' is selected from CN and $Ar^1$ of $A^1$, $Ar^2$ of $A^2$, and $Ar^3$ of $A^3$ are selected according to the following:

| Compound | $R^1$ of $A^1$ | $R^2$ of $A^2$ | $R^3$ of $A^3$ |
|---|---|---|---|
| A1 | 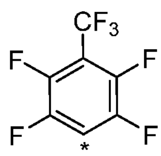 | 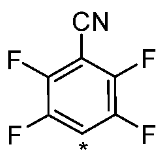 | 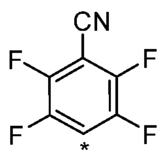 |

(continued)

| Compound | $R^1$ of $A^1$ | $R^2$ of $A^2$ | $R^3$ of $A^3$ |
|---|---|---|---|
| A2 | 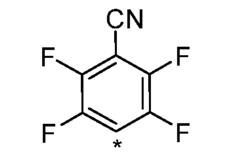 | 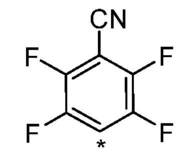 | 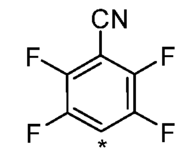 |
| A3 | 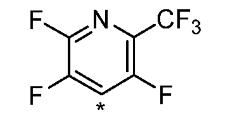 | 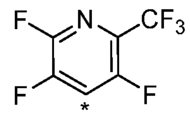 | 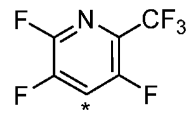 |
| A4 | 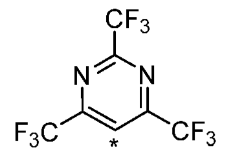 | 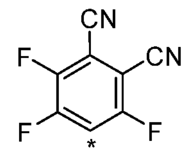 | 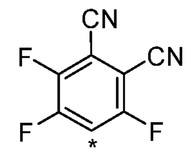 |
| A5 | 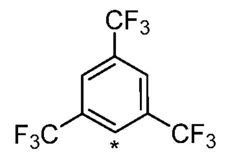 | 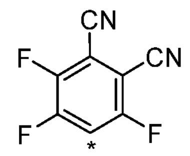 | 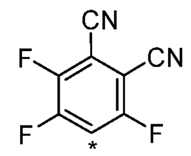 |
| A6 | 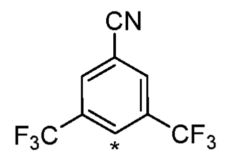 | 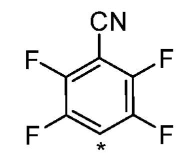 | 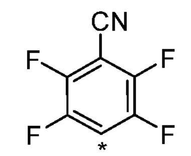 |
| A7 | 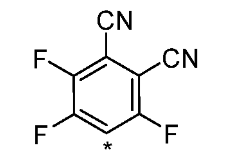 | 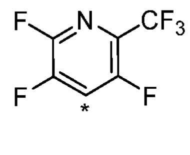 | 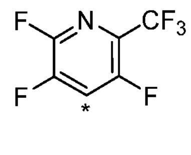 |
| A8 | 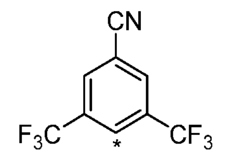 | 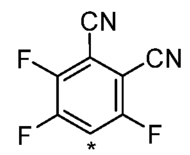 | 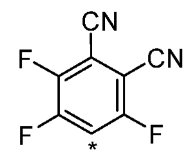 |
| A9 | 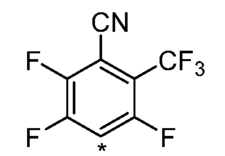 | 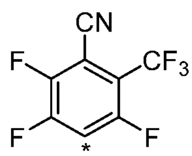 | 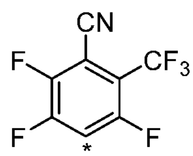 |
| A10 | 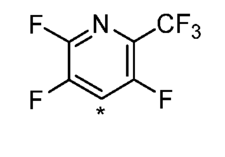 | 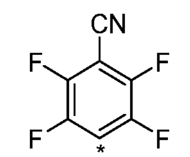 | 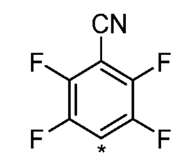 |
| A11 | 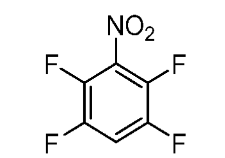 | 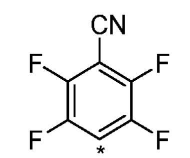 | 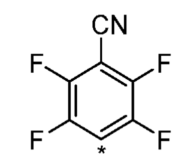 |

(continued)

| Compound | $R^1$ of $A^1$ | $R^2$ of $A^2$ | $R^3$ of $A^3$ |
|---|---|---|---|
| A12 | 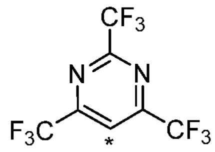 | 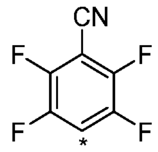 | 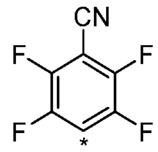 |
| A13 | 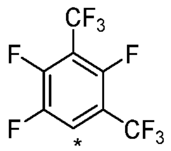 | 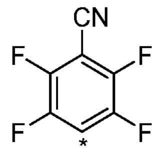 | 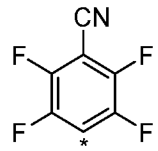 |
| A14 | 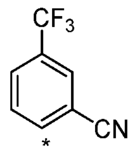 | 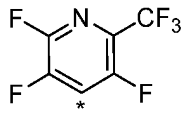 | 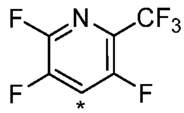 |
| A15 | 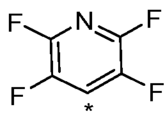 | 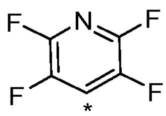 | 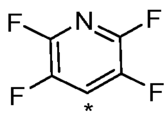 |
| A16 | 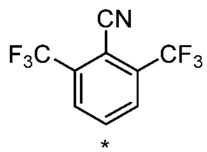 | 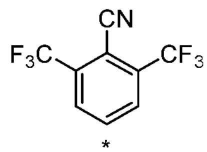 | 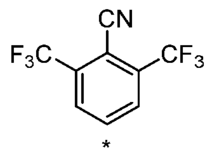 |

wherein the asterisk "*" denotes the binding position.

According to one embodiment of the present invention, the radialene of formula (I) is selected from one of the compounds A2, A3, A5, A6, A11, A15 and 16.

According to one embodiment of the present invention, the radialene of formula (I) is represented by one of the following formulae (IIIa) to (IIIh):

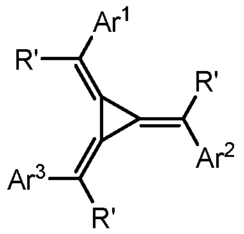

(IIIa)

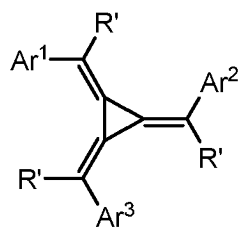

(IIIe)

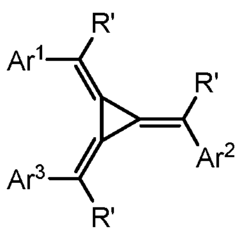

(IIIb)

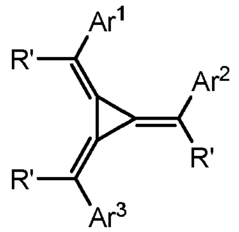

(IIIf)

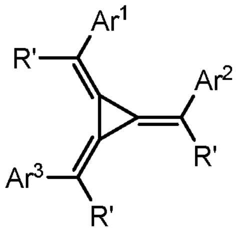

(IIIc)

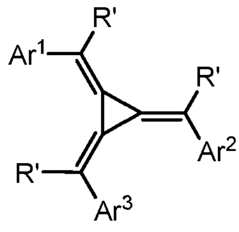

(IIIg)

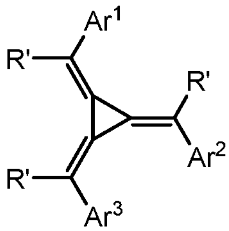

(IIId)

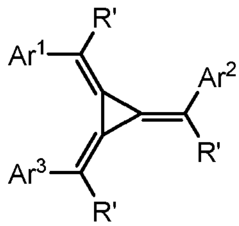

(IIIh)

wherein $Ar^1$, $Ar^2$, $Ar^3$, and R' are independently selected as above.

According to one embodiment of the present invention, the p-type generation layer comprises as radialene of formula (I) a mixture of at least two compounds selected from formulae (IIIa) to (IIIh) as defined above.

Hole transport compound

According to one embodiment of the invention, the hole transport compound has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.27 eV, the HOMO level of N4,N4,N4',N4'-tetrakis(4-methoxyphenyl)biphenyl-4,4'-diamine is -4.34 eV, and the HOMO level of N4,N4'-bis(9,9-dimethyl-9H-fluoren-2-yl)-N4,N4'-diphenyl-[1,1'-biphenyl]-4,4'-diamine is -4.64 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the hole transport compound has a HOMO energy level of ≤ -4.27 eV, preferably ≤-4.34 eV, more preferably ≤-4.40 eV, even more preferably ≤-4.45 eV, even more preferably ≤-4.50 eV, even more preferably ≤-4.55 eV, even more preferably ≤-4.60 eV, even more preferably ≤-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the hole transport compound has a HOMO energy level in the range of ≥-6.50 eV to ≤ -4.27 eV, preferably ≥-6.00 eV ≤-4.34 eV, more preferably ≥-5.50 eV to ≤-4.40 eV, even more preferably ≥-5.40 eV ≤-4.45 eV, even more preferably ≥-5.30 eV to ≤-4.50 eV, even more preferably ≥-5.20 eV to ≤-4.55 eV, even more preferably ≥-5.10 eV to ≤-4.60 eV, even more preferably ≥-5.00 eV to ≤-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to one embodiment, the hole transport compound has have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

The hole transport compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The intermediate layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to one embodiment, the hole transport compound(s) are selected of at least one compound selected from formula (IIa) and formula (IIb).

According to one embodiment, the hole transport is a compound of formula (IIa).

According to one embodiment, the compound according to formula (IIa) or (IIb) comprises at least one naphthyl group, carbazole group, dibenzofuran group, dibenzothiophene group and/or substituted fluorenyl group, wherein the substituents are independently selected from methyl, phenyl or fluorenyl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to another aspect of the present invention, in formulae (IIa) and/or (IIb) - wherever applicable -) T1, T2, T3, T4 and T5 may be independently selected from a single bond, phenylene, biphenylene or terphenylene.

According to one embodiment in formulae (IIa) and/or (IIb) - wherever applicable - $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond.

According to one embodiment in formulae (IIa) and/or (IIb) - wherever applicable - $T^1$, $T^2$, $T^3$, $T^4$ and $T^5$ may be independently selected from phenylene or biphenylene and one of $T^1$, $T^2$, $T^3$, $T^4$ and $T^5$ are a single bond.

According to one embodiment in formulae (IIa) and/or (IIb) - wherever applicable - $T^1$, $T^2$, $T^3$, $T^4$ and $T^5$ may be independently selected from phenylene or biphenylene and two of $T^1$, $T^2$, $T^3$, $T^4$ and $T^5$ are a single bond;

According to one embodiment in formulae (IIa) and/or (IIb) - wherever applicable - $T^1$, $T^2$ and $T^3$ may be independently selected from phenylene and one of $T^1$, $T^2$ and $T^3$ are a single bond.

According to one embodiment in formulae (IIa) and/or (IIb) - wherever applicable - $T^1$, $T^2$ and $T^3$ may be independently selected from phenylene and two of $T^1$, $T^2$ and $T^3$ are a single bond.

According to one embodiment in formula (IIb) $T^6$ may be phenylene, biphenylene, terphenylene.

According to one embodiment in formula (IIb) $T^6$ is phenylene.

According to one embodiment in formula (IIb) $T^6$ is biphenylene.

According to one embodiment in formula (IIb) $T^6$ is terphenylene.

According to an embodiment in formulae (IIa) and/or (IIb) - wherever applicable - $Ar'^1$, $Ar'^2$, $Ar'^3$, $Ar'^4$ and/or $Ar'^5$ are independently selected from D1 to D16:

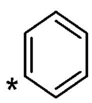 (D1), 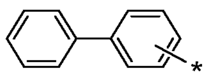 (D2), 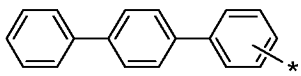 (D3), 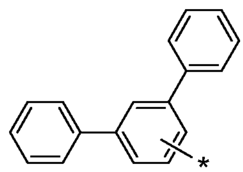 (D4),

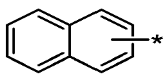 (D5), 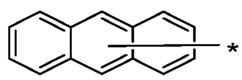 (D6), 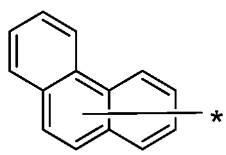 (D7), 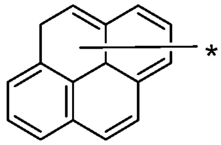 (D8),

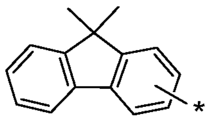 (D9), 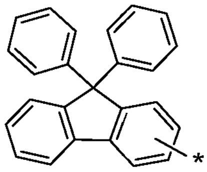 (D10), 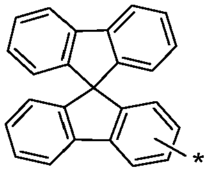 (D11),

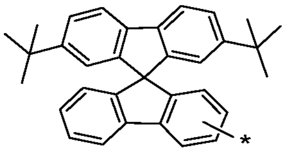 (D12), 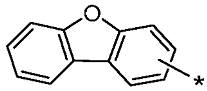 (D13), 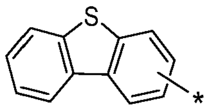 (D14),

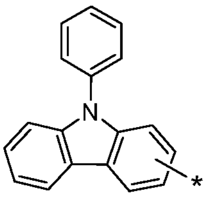 (D15), 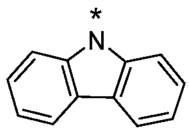 (D16),

wherein the asterix "*" denotes the binding position.

According to an embodiment in formulae (IIa) and/or (IIb) - wherever applicable - Ar'1, Ar'2, Ar'3, Ar'4 and/or Ar'5 are independently selected from D1 to D15; alternatively selected from D1 to D10 and D13 to D15.

According to an embodiment, in formulae (IIa) and/or (IIb) - wherever applicable - Ar'1, Ar'2, Ar'3, Ar'4 and/or Ar'5 may be independently selected from the group consisting of D1, D2, D5, D7, D9, D10, D13 to D16.

The rate onset temperature may be in a range particularly suited to mass production, when Ar'1, Ar'2, Ar'3, Ar'4 and Ar'5 are selected in this range.

According to one embodiment, the formula (IIa) and/ or formula (IIb) - wherever applicable are selected from compound (IIc)

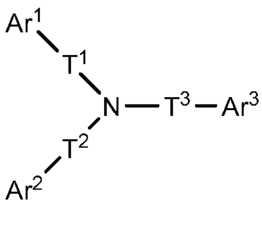 (IIc);

Whereby

$T^1$, $T^2$, $T^3$ are independently selected from a single bond, phenylene, biphenylene, terphenylene or naphthenylene, preferably a single bond or phenylene;

$Ar^1$, $Ar^2$, $Ar^3$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar^1$, $Ar^2$, $Ar^3$ are selected the same or different from the group comprising H, D, F, CN, $Si(R^2)_3$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5-to 6-member of an aromatic heterocycle, unsaturated 5- to 7-member ring of a non-heterocycle, and 6-member ring of an aromatic non-heterocycle,

wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl;

According to an embodiment of the electronic device, the hole transport compound(s) and/or formulae (IIa) and/or (IIb) - wherever applicable - are selected from F1 to F18:

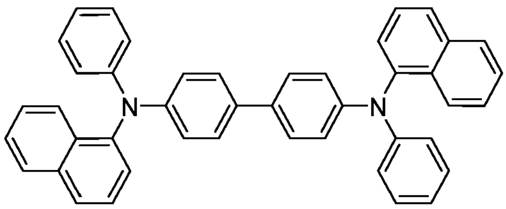
(F1),

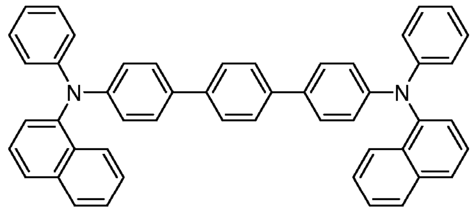
(F2),

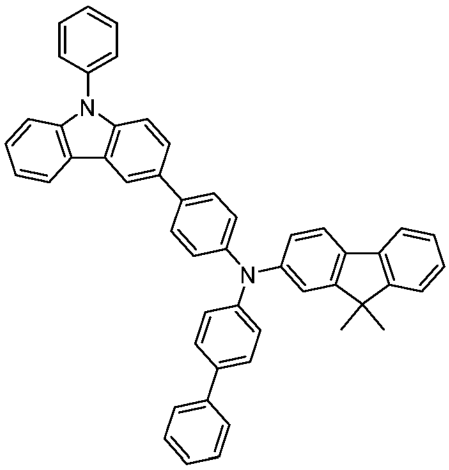
(F3),

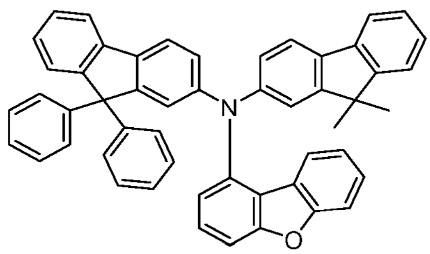
(F4),

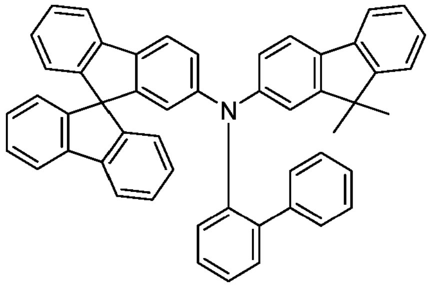
(F5),

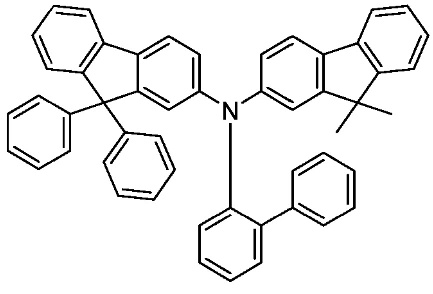
(F6),

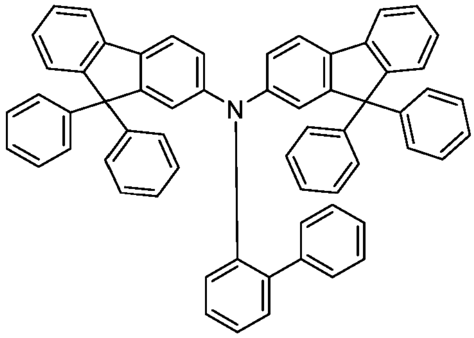
(F7),

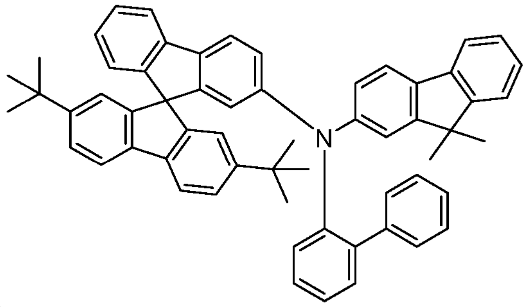
(F8),

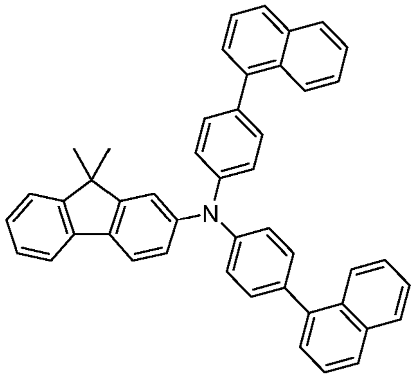
(F9),

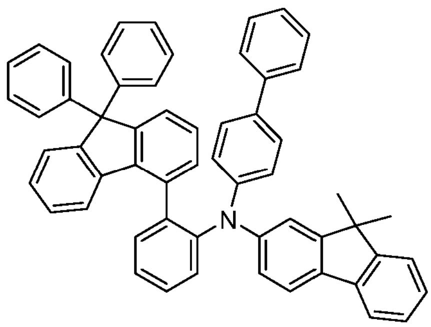
(F10),

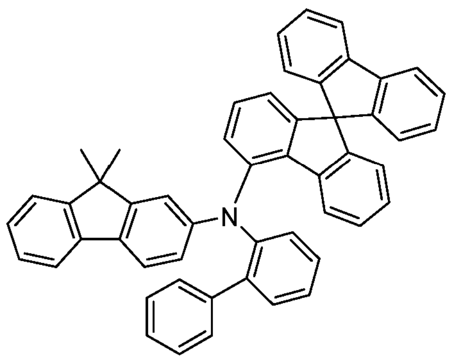
(F11),

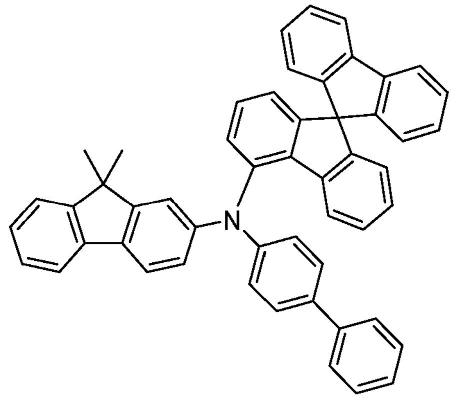
(F12),

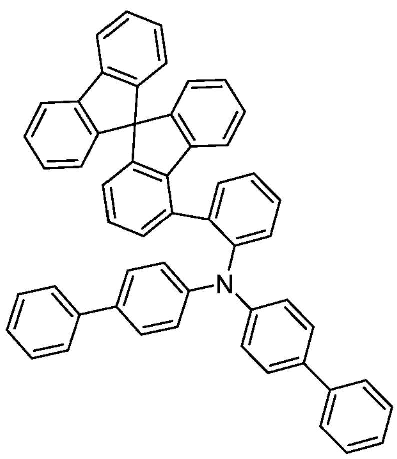
(F13),

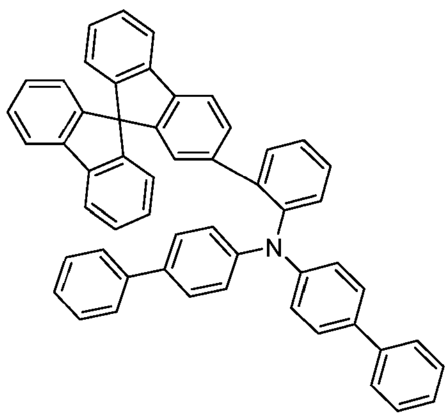
(F14),

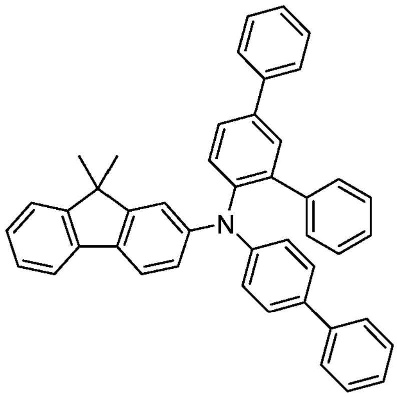 (F15),

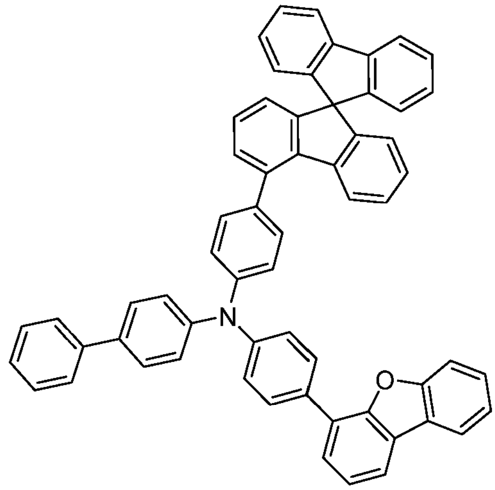 (F16),

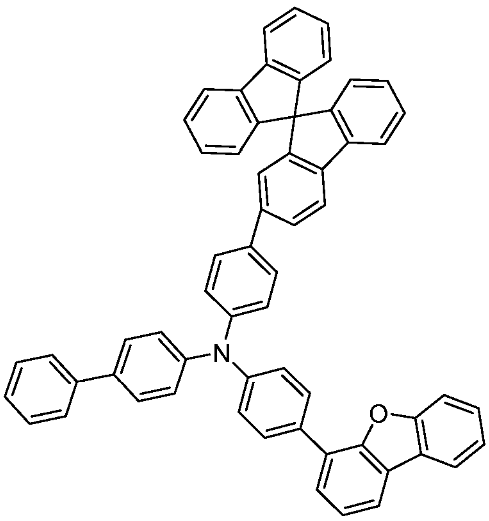 (F17)

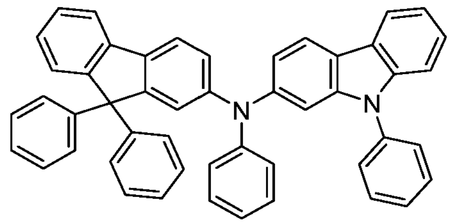 (F18).

According to an embodiment of the electronic device, formulae (IIa) and/or (IIb) - wherever applicable - are selected from F3 to F18.

## p-type charge generation layer (pCGL)

According to one embodiment, the p-type charge generation layer has a thickness of ≤20 nm; ≤ 15 nm, ≤10 nm.

According to one embodiment, the p-type charge generation layer has a thickness in the range of ≥1 nm to ≤20 nm, ≥2 nm to ≤15 nm, ≥3 nm to ≤15 nm, ≥5 nm to ≤15 nm.

According to one embodiment, wherein the hole transport matrix compound is present in the p-type charge generation layer in an amount of ≥0.1 wt.-%, preferably ≥1 wt.-%, more preferably ≥5 wt.-%, more preferably ≥10 wt.-%, more preferably ≥20 wt.-%, more preferably ≥30 wt.-%, more preferably ≥40 wt.-%, more preferably ≥50 wt.-%, more preferably ≥60 wt.-%, more preferably ≥70 wt.-%, more preferably ≥80 wt.-%, more preferably ≥90 wt.-%, and most preferably ≥95 wt.-% based on the total weight of the p-type charge generation layer.

According to one embodiment of the present invention, the radialene of formula (I) is present in the p-type charge generation layer in an amount of ≤99.9 wt% based on the total weight of the p-type charge generation layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt.-%,

The hole transport matrix compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The p-type charge generation layer may be free of HTM014, HTM081, HTM163, HTM222, EL-301, HTM226,

HTM355, HTM133, HTM334, HTM604 and EL-22T. The abbreviations denote the manufacturers' names, for example, of Merck or Lumtec.

Hole transport matrix compound

According to an embodiment, the hole transport matrix compound of the p-type charge generation layer comprises a material selected from an arylamine compound, diarylamine compound, triarylamine compound, a compound of formula (IIa) or a compound of formula (IIb), whereby all details and specification as described with the hole transport compound apply *mutatis mutandis.*

According to an embodiment of the present invention, the hole transport matrix compound of the p-type charge generation layer is selected from the compound of formula (IIa) or the compound of formula (IIb).

According to an embodiment of the present invention the hole transport matrix compound of the p-type charge generation layer is selected from the compound of formula (IIa).

According to an embodiment of the present invention the hole transport compound of the intermediate layer is selected from the compound of formula (IIa) or the compound of formula (IIb), and the hole transport matrix compound of the p-type charge generation layer is selected from the compound of formula (IIa) or the compound of formula (IIb).

According to an embodiment of the present invention the hole transport compound of the intermediate layer is selected from the compound of formula (IIa), and the hole transport matrix compound of the p-type charge generation layer is selected from compound of formula (IIa).

According to an embodiment of the present invention, the hole transport compound(s) and the hole transport matrix compound(s) are identical.

According to an embodiment of the present invention, the hole transport compound(s) and the hole transport matrix compound(s) are different.

According to one embodiment of the invention, the hole transport matrix compound has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.27 eV, the HOMO level of N4,N4,N4',N4'-tetrakis(4-methoxyphenyl)biphenyl-4,4'-diamine is -4.34 eV, and the HOMO level of N4,N4'-bis(9,9-dimethyl-9H-fluoren-2-yl)-N4,N4'-diphenyl-[1,1'-biphenyl]-4,4'-diamine is -4.64 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the hole transport matrix compound has a HOMO energy level of ≤ -4.27 eV, preferably ≤-4.34 eV, more preferably ≤-4.40 eV, even more preferably ≤-4.45 eV, even more preferably ≤-4.50 eV, even more preferably ≤-4.55 eV, even more preferably ≤-4.60 eV, even more preferably ≤-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the hole transport matrix compound has a HOMO energy level in the range of ≥-6.50 eV to ≤ -4.27 eV, preferably ≥-6.00 eV ≤-4.34 eV, more preferably ≥-5.50 eV to ≤-4.40 eV, even more preferably ≥-5.40 eV ≤-4.45 eV, even more preferably ≥-5.30 eV to ≤-4.50 eV, even more preferably ≥-5.20 eV to ≤-4.55 eV, even more preferably ≥-5.10 eV to ≤-4.60 eV, even more preferably ≥-5.00 eV to ≤-4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

**n-type charge generation layer (nCGL)**

According to one embodiment, the n-type charge generation layer has a thickness of ≤20 nm; ≤15 nm, ≤10 nm.

According to one embodiment, the n-type charge generation layer has a thickness in the range of ≥1 nm to ≤20 nm, ≥2 nm to ≤15 nm, ≥3 nm to ≤15 nm, ≥5 nm to ≤15 nm

According to one embodiment, the n-type charge generation layer is adjacent to the at least one electron transport layer.

According to one embodiment, the n-type charge generation layer is in direct contact to the at least one electron transport layer.

According to one embodiment, the matrix compound of the n-type charge generation layer is an electron

transport matrix material.

According to one embodiment, the matrix compound of the n-type charge generation layer is an organic electron transport matrix material.

According to one embodiment, the matrix compound of the n-type charge generation layer may have a molecular weight Mw of ≥ 400 and ≤ 2000 g/mol, preferably a molecular weight Mw of ≥ 410 and ≤ 1500 g/mol, further preferred a molecular weight Mw of ≥ 420 and ≤ 1000 g/mol, in addition preferred a molecular weight Mw of ≥ 430 and ≤ 900 g/mol, also preferred a molecular weight Mw of ≥ 440 and ≤ 800 g/mol.

According to one embodiment of the present invention, the matrix compound of the n-type charge generation layer has a LUMO energy level of ≤ -1.70 eV when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -1.74 eV, and more preferably ≤ -1.75 eV .

According to one embodiment of the present invention, the matrix compound of the n-type charge generation layer has LUMO energy level in the range from ≥ -3.5 eV to ≤ -1e V when calculated with the program package TURBOMOLE V6.5 by applying the hybrid functional B3LYP with a Gaussian 6-31G* basis set in the gas phase, preferably in the range from ≥ -2.5 eV to ≤ -1.5 eV, more preferably in the range from ≥ -2.25 eV to ≤ -1.7 eV, and more preferably ≥ - 2.1 eV to ≤ -1.74 eV, and most preferably ≥ -2.0 eV to ≤ -1.75 eV.

According to one embodiment, the matrix compound of the n-type charge generation layer and/ or the comprises at least one $C_2$ to $C_{24}$ N-heteroaryl or P=X moiety, with X being O, P, Se, with P=O especially preferred.

According to one embodiment, the at least one $C_2$ to $C_{24}$ N-heteroaryl may be selected from a compound comprising at least one azine moiety, preferably at least two azine moieties, also preferred three azine moiety.

According to one embodiment, the matrix compound of the n-type charge generation layer comprises at least one moiety selected from the list consisting of pyridine, pyrimidine, triazine, imidazole, benzimidazole, benzooxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to one embodiment, the matrix compound of the n-type charge generation layer comprises at least one phenanthroline moiety, preferably two phenanthroline moieties, one or more pyridine moieties, one or more pyrimidine moieties, one or more triazine moieties, one or more imidazo[1,5-*a*]pyridine moieties, or one or more phosphine oxide moieties.

According to one embodiment, the matrix compound of the n-type charge generation layer comprises at least one phenanthroline moiety, preferably two phenanthroline moieties, one or more pyridine moieties, one or more pyrimidine moieties, or one or more phosphine oxide moieties.

According to one embodiment, the matrix compound of the n-type charge generation layer comprises at least one phenanthroline moiety, preferably two phenanthroline moieties, a pyridine moiety, a pyrimidine moieties, or a phosphine oxide moiety.

According to one embodiment, the matrix compound of the n-type charge generation layer compound comprises at least one phenanthroline moiety, preferably two phenanthroline moieties, one or more pyridine moieties, one or more pyrimidine moieties, one or more triazine moieties.

According to one embodiment, the matrix compound of the n-type charge generation layer is selected from the moiety comprising 2,2'-(1,3-Phenylene)bis[9-phenyl-1,10-phenanthroline], (3-(10-(3-(2,6-diphenylpyrimidin-4-yl)phenyl)anthracen-9-yl)phenyl)dimethylphosphine oxide, 3-(3-(9,10-diphenylanthracen-2-yl)phenyl)-1-(pyridin-2-yl)imidazo [1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethyl phosphine oxide.

According to one embodiment, the matrix compound of the n-type charge generation layer comprises at least one phenanthroline moiety, preferably two phenanthroline moieties.

According to one embodiment, the matrix compound of the n-type charge generation layer comprises at least one $C_2$ to $C_{24}$ N-heteroaryl or P=X group, with X being O, P, Se, with P=O especially preferred.

According to one embodiment, the at least one $C_2$ to $C_{24}$ N-heteroaryl may be selected from a compound comprising at least one azine group, preferably at least two azine groups, also preferred three azine groups.

According to one embodiment, the matrix compound of the n-type charge generation layer of the n-type charge generation layer comprises at least one group selected from the list consisting of pyridine, pyrimidine, triazine, imidazole, benzimidazole, benzooxazole, quinone, benzoquinone, imidazo[1,5-*a*]pyridine, quinoxaline, benzoquinoxaline, acridine, phenanthroline, benzoacridine, dibenzoacridine phosphine oxide, terpyridine.

According to one embodiment, the matrix compound of the n-type charge generation layer of the n-type charge generation layer comprises at least one phenanthroline group, preferably two phenanthroline groups, one or more pyridine groups, one or more pyrimidine groups, one or more triazine groups, one or more imidazo[1,5-*a*]pyridine groups, or one or more phosphine oxide groups.

According to one embodiment, the matrix compound of the n-type charge generation layer comprises at least one

phenanthroline group, preferably two phenanthroline groups, one or more pyridine groups, one or more pyrimidine groups, or one or more phosphine oxide groups.

According to one embodiment, the matrix compound of the n-type charge generation layer comprises at least one phenanthroline group, preferably two phenanthroline groups, a pyridine group, a pyrimidine groups, or a phosphine oxide group.

According to one embodiment, the matrix compound of the n-type charge generation layer of the n-type charge generation layer comprises at least one phenanthroline group, preferably two phenanthroline groups, one or more pyridine groups, one or more pyrimidine groups, one or more triazine groups.

According to one embodiment, the matrix compound of the n-type charge generation layer is selected from the group comprising 2,2'-(1,3-Phenylene)bis[9-phenyl-1,10-phenanthroline], (3-(10-(3-(2,6-diphenylpyrimidin-4-yl)phenyl) anthracen-9-yl)phenyl)dimethylphosphine oxide, 3-(3-(9,10-diphenylanthracen-2-yl)phenyl)-1-(pyridin-2-yl)imidazo [1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethyl phosphine oxide.

According to one embodiment, the matrix compound of the n-type charge generation layer comprises at least one phenanthroline group, preferably two phenanthroline groups.

According to one embodiment, the matrix compound of the n-type charge generation layer is presented by a compound of formula (IV)

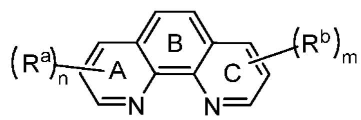

(IV)

wherein

n is an integer selected from 0, 1, 2, 3, 4;
m is an integer selected form 0, 1, 2, 3, 4;
wherein at one of n or m is ≥1;
wherein each $R^a$ or each $R^b$ can be bound independently to ring A, ring B or ring C;
wherein each $R^a$ (if present) is independently selected from H, D, substituted or unsubstituted aryl, substituted or unsubstituted heteroaryl, substituted or unsubstituted alkyl, electron withdrawing group, CN;
wherein each $R^b$ (if present) is independently selected from H, D, substituted or unsubstituted aryl, substituted or unsubstituted heteroaryl, substituted or unsubstituted alkyl, electron withdrawing group, CN.
wherein the one or more substituents are selected from D, substituted or unsubstituted aryl, substituted or unsubstituted heteroaryl, substituted or unsubstituted alkyl, partially fluorinated alkyl, perfluorinated alkyl, partially perdeuterated alkyl, perdeuterated alkyl, substituted or unsubstituted alkoxy, partially fluorinated alkoxy, perfluorinated alkoxy, partially deuterated alkoxy, perdeuterated alkoxy, electron withdrawing group, CN, $-PX(R^d)_2$, CORc, $COOR^c$, $CONH_2$, $NO_2$, F
wherein the one or more substituents are selected from D, substituted or unsubstituted aryl, substituted or unsubstituted heteroaryl, substituted or unsubstituted alkyl, partially fluorinated alkyl, perfluorinated alkyl, partially perdeuterated alkyl, perdeuterated alkyl, substituted or unsubstituted alkoxy, partially fluorinated alkoxy, perfluorinated alkoxy, partially deuterated alkoxy, perdeuterated alkoxy, electron withdrawing group, CN, $-PX(R^d)_2$, $COR^c$, $COOR^c$, $CONH_2$, $NO_2$, F,
wherein the one or more substituents are selected from D, aryl, heteroaryl, alkyl, partially fluorinated $C_1$ to Cs alkyl, perfluorinated $C_1$ to $C_8$ alkyl, partially perdeuterated $C_1$ to $C_8$ alkyl, perdeuterated $C_1$ to $C_8$ alkyl, partially fluorinated $C_1$ to $C_8$ alkoxy, perfluorinated $C_1$ to $C_8$ alkoxy, partially perdeuterated $C_1$ to $C_8$ alkoxy, perdeuterated $C_1$ to $C_8$ alkoxy, CN, $-PX(R^d)_2$, $COR^c$, $COOR^c$, $CONH_2$, $NO_2$, F;
wherein $R^c$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and
$R^d$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

- two $R^d$ can be linked together to form a ring

X is selected from S or O.

According to one embodiment, the matrix compound of the n-type charge generation layer the is presented by a compound of formula (IV)

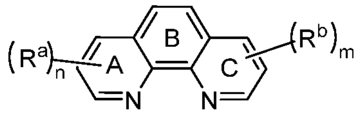

(IV)

wherein

n is an integer selected from 0, 1, 2, 3, 4;
m is an integer selected form 0, 1, 2, 3, 4;
wherein at one of n or m is ≥1;
wherein each $R^a$ or each $R^b$ can be bound independently to ring A, ring B or ring C;
wherein each $R^a$ (if present) is independently selected from H, D, substituted or unsubstituted $C_6$ to $C_{30}$ aryl, substituted or unsubstituted $C_3$ to $C_{30}$ heteroaryl, substituted or unsubstituted $C_1$ to $C_8$ alkyl, electron withdrawing group, CN;
wherein each $R^b$ (if present) is independently selected from H, D, substituted or unsubstituted $C_6$ to $C_{30}$ aryl, substituted or unsubstituted $C_3$ to $C_{30}$ heteroaryl, substituted or unsubstituted $C_1$ to $C_8$ alkyl, electron withdrawing group, CN.
wherein the one or more substituents are selected from D, substituted or unsubstituted $C_6$ to $C_{30}$ aryl, substituted or unsubstituted $C_3$ to $C_{30}$ heteroaryl, substituted or unsubstituted $C_1$ to $C_8$ alkyl, partially fluorinated $C_1$ to $C_8$ alkyl, perfluorinated $C_1$ to $C_8$ alkyl, partially perdeuterated $C_1$ to $C_8$ alkyl, perdeuterated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, partially deuterated $C_1$ to $C_8$ alkoxy, perdeuterated $C_1$ to $C_8$ alkoxy, electron withdrawing group, CN, $-PX(R^d)_2$, $COR^c$, $COOR^c$, $CONH_2$, $NO_2$, F
wherein the one or more substituents are selected from D, substituted or unsubstituted $C_6$ to $C_{30}$ aryl, substituted or unsubstituted $C_3$ to $C_{30}$ heteroaryl, substituted or unsubstituted $C_1$ to $C_8$ alkyl, partially fluorinated $C_1$ to $C_8$ alkyl, perfluorinated $C_1$ to $C_8$ alkyl, partially perdeuterated $C_1$ to $C_8$ alkyl, perdeuterated $C_1$ to $C_8$ alkyl, substituted or unsubstituted $C_1$ to $C_8$ alkoxy, partially fluorinated $C_1$ to $C_8$ alkoxy, perfluorinated alkoxy $C_1$ to $C_8$, partially deuterated $C_1$ to $C_8$ alkoxy, perdeuterated $C_1$ to $C_8$ alkoxy, electron withdrawing group, CN, $-PX(R^d)_2$, $COR^c$, $COOR^c$, $CONH_2$, $NO_2$, F,
wherein the one or more substituents are selected from D, $C_6$ to $C_{30}$ aryl, $C_3$ to $C_{30}$ heteroaryl, alkyl, partially fluorinated $C_1$ to $C_8$ alkyl, perfluorinated $C_1$ to $C_8$alkyl, partially perdeuterated $C_1$ to $C_8$ alkyl, perdeuterated $C_1$ to $C_8$ alkyl, partially fluorinated $C_1$ to $C_8$ alkoxy, perfluorinated $C_1$ to $C_8$ alkoxy, partially perdeuterated $C_1$ to $C_8$ alkoxy, perdeuterated $C_1$ to $C_8$ alkoxy, CN, $-PX(R^d)_2$, $COR^c$, $COOR^c$, $CONH_2$, $NO_2$, F;
wherein $R^c$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and
$R^d$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

- two $R^d$ can be linked together to form a ring

X is selected from S or O.

According to one embodiment, the matrix compound of the n-type charge generation layer is presented by a compound of formula (IV)

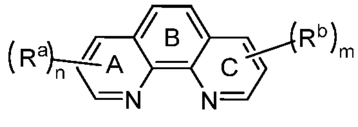

(IV)

wherein

n is an integer selected from 0, 1, 2, 3, 4;

m is an integer selected form 0, 1, 2, 3, 4;
wherein at one of n or m is ≥1;
wherein each $R^a$ or each $R^b$ can be bound independently to ring A, ring B or ring C;
wherein each $R^a$ (if present) is independently selected from H, D, substituted or unsubstituted $C_6$ to $C_{24}$ aryl, substituted or unsubstituted $C_3$ to $C_{24}$ heteroaryl, substituted or unsubstituted $C_1$ to $C_6$ alkyl, electron withdrawing group, CN;
wherein each $R^b$ (if present) is independently selected from H, D, substituted or unsubstituted $C_6$ to $C_{24}$ aryl, substituted or unsubstituted $C_3$ to $C_{24}$ heteroaryl, substituted or unsubstituted $C_1$ to C6 alkyl, electron withdrawing group, CN.
wherein the one or more substituents are selected from D, substituted or unsubstituted $C_6$ to $C_{24}$ aryl, substituted or unsubstituted $C_3$ to $C_{24}$ heteroaryl, substituted or unsubstituted $C_1$ to $C_6$ alkyl, partially fluorinated $C_1$ to $C_6$ alkyl, perfluorinated $C_1$ to $C_6$ alkyl, partially perdeuterated $C_1$ to $C_6$ alkyl, perdeuterated $C_1$ to $C_6$ alkyl, substituted or unsubstituted $C_1$ to $C_6$ alkoxy, partially fluorinated $C_1$ to $C_6$ alkoxy, perfluorinated $C_1$ to $C_6$ alkoxy, partially deuterated $C_1$ to $C_6$ alkoxy, perdeuterated $C_1$ to $C_6$ alkoxy, electron withdrawing group, CN, $-PX(R^d)_2$, $COR^c$, $COOR^c$, $CONH_2$, $NO_2$, F
wherein the one or more substituents are selected from D, substituted or unsubstituted $C_6$ to $C_{24}$ aryl, substituted or unsubstituted $C_3$ to $C_{24}$ heteroaryl, substituted or unsubstituted $C_1$ to $C_6$ alkyl, partially fluorinated $C_1$ to $C_6$ alkyl, perfluorinated $C_1$ to $C_6$ alkyl, partially perdeuterated $C_1$ to $C_6$ alkyl, perdeuterated $C_1$ to $C_6$ alkyl, substituted or unsubstituted $C_1$ to $C_6$ alkoxy, partially fluorinated $C_1$ to $C_6$ alkoxy, perfluorinated alkoxy $C_1$ to $C_6$, partially deuterated $C_1$ to $C_6$ alkoxy, perdeuterated $C_1$ to $C_6$ alkoxy, electron withdrawing group, CN, $-PX(R^d)_2$, $COR^c$, $COOR^c$, $CONH_2$, $NO_2$, F,
wherein the one or more substituents are selected from D, $C_6$ to $C_{24}$ aryl, $C_3$ to $C_{24}$ heteroaryl, $C_1$ to $C_6$ alkyl, partially fluorinated $C_1$ to $C_6$ alkyl, perfluorinated $C_1$ to $C_6$ alkyl, partially perdeuterated $C_1$ to $C_6$ alkyl, perdeuterated $C_1$ to $C_6$ alkyl, partially fluorinated $C_1$ to $C_6$ alkoxy, perfluorinated $C_1$ to $C_6$ alkoxy, partially perdeuterated $C_1$ to $C_6$ alkoxy, perdeuterated $C_1$ to $C_6$ alkoxy, CN, $-PX(R^d)_2$, $COR^c$, $COOR^c$, $CONH_2$, $NO_2$, F;
wherein $R^c$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and
$R^d$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

- two $R^d$ can be linked together to form a ring

X is selected from S or O.

According to one embodiment, the matrix compound of the n-type charge generation layer is presented by a compound of formula (IV)

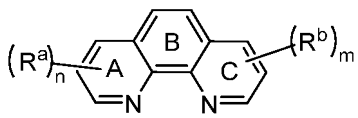
(IV)

wherein

n is an integer selected from 0, 1, 2, 3, 4;
m is an integer selected form 0, 1, 2, 3, 4;
wherein at one of n or m is ≥1;
wherein each $R^a$ or each $R^b$ can be bound independently to ring A, ring B or ring C;
wherein each $R^a$ (if present) is independently selected from H, D, substituted or unsubstituted $C_6$ to $C_{18}$ aryl, substituted or unsubstituted $C_3$ to $C_{18}$ heteroaryl, substituted or unsubstituted $C_1$ to $C_4$ alkyl, electron withdrawing group, CN;
wherein each $R^b$ (if present) is independently selected from H, D, substituted or unsubstituted $C_6$ to $C_{18}$ aryl, substituted or unsubstituted $C_3$ to $C_{18}$ heteroaryl, substituted or unsubstituted $C_1$ to $C_4$ alkyl, electron withdrawing group, CN.
wherein the one or more substituents are selected from D, substituted or unsubstituted $C_6$ to $C_{18}$ aryl, substituted or unsubstituted $C_3$ to $C_{18}$ heteroaryl, substituted or unsubstituted $C_1$ to $C_4$ alkyl, partially fluorinated $C_1$ to $C_4$ alkyl,

perfluorinated $C_1$ to $C_4$ alkyl, partially perdeuterated $C_1$ to $C_4$ alkyl, perdeuterated $C_1$ to $C_4$ alkyl, substituted or unsubstituted $C_1$ to $C_4$ alkoxy, partially fluorinated $C_1$ to $C_4$ alkoxy, perfluorinated $C_1$ to $C_4$ alkoxy, partially deuterated $C_1$ to $C_4$ alkoxy, perdeuterated $C_1$ to $C_4$ alkoxy, electron withdrawing group, CN, $-PX(R^d)_2$, $COR^c$, $COOR^c$, $CONH_2$, $NO_2$, F

wherein the one or more substituents are selected from D, substituted or unsubstituted $C_6$ to $C_{18}$ aryl, substituted or unsubstituted $C_3$ to $C_{18}$ heteroaryl, substituted or unsubstituted $C_1$ to $C_4$ alkyl, partially fluorinated $C_1$ to $C_4$ alkyl, perfluorinated $C_1$ to $C_4$ alkyl, partially perdeuterated $C_1$ to $C_4$ alkyl, perdeuterated $C_1$ to $C_4$ alkyl, substituted or unsubstituted $C_1$ to $C_4$ alkoxy, partially fluorinated $C_1$ to $C_4$ alkoxy, perfluorinated alkoxy $C_1$ to $C_4$, partially deuterated $C_1$ to $C_4$ alkoxy, perdeuterated $C_1$ to $C_4$ alkoxy, electron withdrawing group, CN, $-PX(R^d)_2$, $COR^c$, $COOR^c$, $CONH_2$, $NO_2$, F,

wherein the one or more substituents are selected from D, $C_6$ to $C_{18}$ aryl, $C_3$ to $C_{18}$ heteroaryl, $C_1$ to $C_4$ alkyl, partially fluorinated $C_1$ to $C_4$ alkyl, perfluorinated $C_1$ to $C_4$ alkyl, partially perdeuterated $C_1$ to $C_4$ alkyl, perdeuterated $C_1$ to $C_4$ alkyl, partially fluorinated $C_1$ to $C_4$ alkoxy, perfluorinated $C_1$ to $C_4$ alkoxy, partially perdeuterated $C_1$ to $C_4$ alkoxy, perdeuterated $C_1$ to $C_6$ alkoxy, CN, $-PX(R^d)_2$, $COR^c$, $COOR^c$, $CONH_2$, $NO_2$, F;

wherein $R^c$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

$R^d$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

- two $R^d$ can be linked together to form a ring

X is selected from S or O.

According to one embodiment, the compound of formula (IV) is selected from compound of formula (IVa)

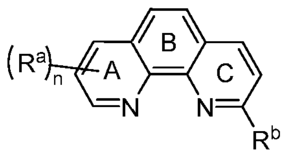
(IVa)

wherein the ring A, ring B, ring C can be independently be partially or fully deuterated.

According to one embodiment, the compound of formula (IV) is selected from compound of formula (IVb)

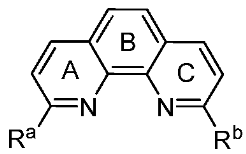
(IVb)

wherein the ring A, ring B, ring C can be independently be partially or fully deuterated.

According to one embodiment, the compound of formula (IV) is selected from compound of formula (IVc)

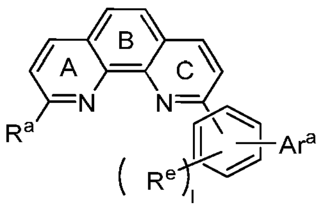
(IVc)

wherein the ring A, ring B, ring C can be independently be partially or fully deuterated,
wherein l is an integer selected from 0, 1, 2, 3, 4;
wherein each $R^e$ is independently selected from D;
wherein $R^a$ (if present) is independently selected from H, D, substituted or unsubstituted $C_6$ to $C_{18}$ aryl, substituted or

unsubstituted $C_3$ to $C_{18}$ heteroaryl, substituted or unsubstituted $C_1$ to $C_4$ alkyl, electron withdrawing group, CN; wherein $Ar^a$ is selected from substituted or unsubstituted $C_6$ to $C_{18}$ aryl, substituted or unsubstituted $C_3$ to $C_{18}$ heteroaryl,

wherein the one or more substituents of $R^a$ or $Ar^a$ are independently selected from D, substituted or unsubstituted $C_6$ to $C_{18}$ aryl, substituted or unsubstituted $C_3$ to $C_{18}$ heteroaryl, substituted or unsubstituted $C_1$ to $C_4$ alkyl, partially fluorinated $C_1$ to $C_4$ alkyl, perfluorinated $C_1$ to $C_4$ alkyl, partially perdeuterated $C_1$ to $C_4$ alkyl, perdeuterated $C_1$ to $C_4$ alkyl, substituted or unsubstituted $C_1$ to $C_4$ alkoxy, partially fluorinated $C_1$ to $C_4$ alkoxy, perfluorinated alkoxy $C_1$ to $C_4$, partially deuterated $C_1$ to $C_4$ alkoxy, perdeuterated $C_1$ to $C_4$ alkoxy, electron withdrawing group, CN, $-PX(R^d)_2$, $COR^c$, $COOR^c$, $CONH_2$, $NO_2$, F,

wherein the one or more substituents are independently selected from D, $C_6$ to $C_{18}$ aryl, $C_3$ to $C_{18}$ heteroaryl, $C_1$ to $C_4$ alkyl, partially fluorinated $C_1$ to $C_4$ alkyl, perfluorinated $C_1$ to $C_4$ alkyl, partially perdeuterated $C_1$ to $C_4$ alkyl, perdeuterated $C_1$ to $C_4$ alkyl, partially fluorinated $C_1$ to $C_4$ alkoxy, perfluorinated $C_1$ to $C_4$ alkoxy, partially perdeuterated $C_1$ to $C_4$ alkoxy, perdeuterated $C_1$ to $C_6$ alkoxy, CN, $-PX(R^d)_2$, $COR^c$, $COOR^c$, $CONH_2$, $NO_2$, F;

wherein $R^c$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

$R^d$ is independently selected from $C_6$ to $C_{12}$ aryl, $C_3$ to $C_{12}$ heteroaryl, $C_1$ to $C_{16}$ alkyl, $C_1$ to $C_{16}$ alkoxy, partially or perfluorinated $C_1$ to $C_{16}$ alkyl, partially or perfluorinated $C_1$ to $C_{16}$ alkoxy, partially or perdeuterated $C_1$ to $C_{16}$ alkyl, partially or perdeuterated $C_1$ to $C_{16}$ alkoxy and

- two $R^d$ can be linked together to form a ring

X is selected from S or O.

According to one embodiment, m is selected from 1, and wherein ring A, ring B or ring C can be deuterated.

According to one embodiment, n is selected from 1, and m is selected from 1, and wherein ring A, ring B or ring C can be deuterated.

According to an embodiment of the present invention, the n-type charge generation comprises a metal dopant.

According to one embodiment of the present invention, the metal dopant is selected from a metal with an electronegativity of ≤ 1.4 eV by Pauling scale or a metal alloy comprising a metal with an electronegativity of ≤ 1.4 eV by Pauling scale.

According to one embodiment of the present invention, the metal dopant is selected from a metal with an electronegativity of ≤ 1.35 eV by Pauling scale or a metal alloy comprising a metal with an electronegativity of ≤ 1.35 eV by Pauling scale.

According to one embodiment of the present invention, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment of the present invention, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment of the present invention, the metal dopant is a metal selected from the group consisting of Li, Mg and Yb or a metal alloy comprising a metal selected from the group consisting of Li, Mg and Yb.

According to one embodiment of the present invention, the metal dopant is a metal selected from the group consisting of Li and Yb or a metal alloy comprising a metal selected from the group consisting of Li, and Yb.

According to one embodiment of the present invention, the metal dopant is Yb or a metal alloy comprising a metal selected from the group consisting of Li and Yb.

According to one embodiment of the present invention, the metal dopant is Yb.

According to one embodiment of the present invention, the metal dopant is present in the n-type charge generation layer in an amount of ≤99.9 wt% based on the total weight of the layer, preferably ≤99 wt%, more preferably ≤95 wt%, more preferably ≤90 wt%, more preferably ≤80 wt%, more preferably ≤70 wt%, more preferably ≤60 wt%, more preferably ≤50 wt%, more preferably ≤40 wt%, more preferably ≤30 wt%, more preferably ≤20 wt%, more preferably ≤ 10 wt.-%, more preferably ≤ 5 wt.-%, more preferably ≤ 3.0 wt.-%, more preferably ≤ 2.75 wt.-%, more preferably ≤ 2.5 wt.-%, more preferably ≤ 2.25 wt.-%, and most preferably ≤ 2.0 wt.-%.

According to one embodiment of the present invention, the electron transport material is present in the n-type charge generation layer in an amount of ≥0.1 wt% based on the total weight of the layer, preferably ≥1 wt%, more preferably ≥5 wt%, more preferably ≥10 wt%, more preferably ≥20 wt%, more preferably ≥30 wt%, more preferably ≥40 wt%, more preferably ≥50 wt%, more preferably ≥60 wt%, more preferably ≥70 wt%, more preferably ≥80 wt%, more preferably ≥ wt%, more preferably ≥95 wt%, more preferably ≥97.0 wt%, more preferably ≥97.25 wt%, more preferably ≥97.5 wt%, more

preferably ≥97.75 wt% and most preferably ≥98.0 wt%.

According to one embodiment of the present invention, an organic electroluminescent device is provided, comprising an anode layer, a cathode layer, a first emission layer, a second emission layer and at least one intermediate connecting region, wherein the at least one intermediate connecting region is arranged between the first and the second emission layer,

wherein the intermediate connecting region comprises an n-type charge generation layer, an intermediate layer, and a p-type charge generation layer,
wherein the n-type charge generation layer is arranged closer to the anode layer than the p-type charge generation layer;
wherein the p-type charge generation layer is arranged closer to the cathode layer than the n-type charge generation layer; and
wherein the intermediate layer is arranged between the n-type charge generation layer and the p-type charge generation layer
whereby
wherein the p-type charge generation layer comprises a hole transport matrix compound and a radialene of formula (I),

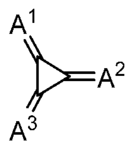

(I),

wherein in formula (I)

- $A^1$ is independently selected from a group of formula (Ia)

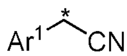

(Ia')

wherein the asterisk "*" denotes the binding position,
wherein $Ar^1$ is independently selected from substituted or unsubstituted aryl and substituted or unsubstituted heteroaryl
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Ib)

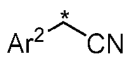

(Ib')

wherein the asterisk "*" denotes the binding position,
wherein $Ar^2$ is independently selected from substituted or unsubstituted aryl and substituted or unsubstituted heteroaryl
wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are

independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Ic)

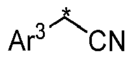
(Ic')

wherein the asterisk "*" denotes the binding position,
wherein $Ar^3$ is independently selected from substituted or unsubstituted aryl and substituted or unsubstituted heteroaryl
wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- and wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN;

wherein the intermediate layer comprises at least one hole transport compound selected from an amine compound, diarylamine compound, triarylamine compound, a compound of formula (IIa) or a compound of formula (IIb):

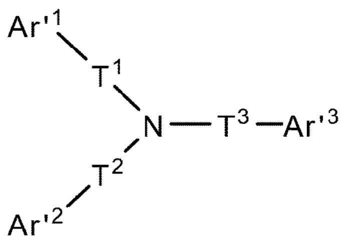
(IIa),
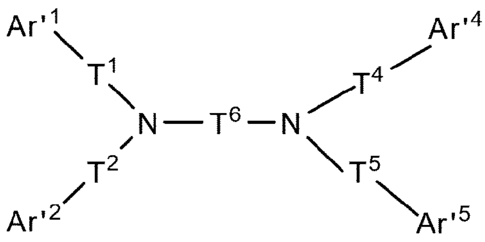
(IIb),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
Ar'[1], Ar'[2], Ar'[3], Ar'[4] and Ar'[5] are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein

the substituents of Ar'1, Ar'2, Ar'3, Ar'4 and Ar'5 are selected the same or different from the group comprising H, D, F, C(=O)R'2, CN, Si(R'2)3, P(=O)(R'2)2, OR'2, S(=O)R'2, S(=O)2R'2, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein R'2 may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Methods:

The present invention furthermore relates to a method for preparation of an organic light emitting device, preferably an organic electroluminescent device as described above, comprising the steps of

- forming a n-type charge generation layer by depositing a matrix compound and depositing a metal dopant;
- forming an intermediate layer by depositing a hole transport compound consisting essentially of at least one compound selected from arylamine, diarylamine, triarylamine formula (IIa) and formula (IIb);
- forming a p-type charge generation layer by depositing a hole transport matrix compound consisting essentially of at least one compound selected from arylamine, diarylamine, triarylamine, formula (IIa), and formula (IIb) and depositing a radialene of formula (I);

All details and specifications apply *mutatis mutandis.*

According to one embodiment of the present invention, a method for preparation of an organic electroluminescent device as described above, comprises the following steps:

- forming a n-type charge generation layer by depositing a matrix compound and depositing a metal dopant;
- forming an intermediate layer directly on the n-type charge generation layer by depositing a hole transport compound consisting essentially of at least one compound selected from arylamine, diarylamine, triarylamine, formula (IIa) and formula (IIb);
- forming a p-type charge generation layer by depositing a hole transport matrix compound consisting essentially of at least one compound according to formula (IIa) or formula (IIb) and depositing a radialene of formula (I);

wherein the hole transport compound and the hole transport matrix compound is selected the same or different.

According to one embodiment of the present invention, a method for preparation of an organic electroluminescent device as described above, comprises the following steps:

- forming a n-type charge generation layer by depositing a matrix compound and depositing a metal dopant;
- forming an intermediate layer by depositing a hole transport compound consisting essentially of at least one compound selected from arylamine, diarylamine, triarylamine, formula (IIa) and formula (IIb);
- forming a p-type charge generation layer directly on the intermediate layer by depositing a hole transport matrix compound consisting essentially of at least one compound selected from arylamine, diarylamine, triarylamine, formula (IIa) and formula (IIb) and depositing a radialene of formula (I);

wherein the hole transport compound and the hole transport matrix compound is selected the same or different.

According to one embodiment of the present invention, a method for preparation of an organic electroluminescent device as described above, comprises the following steps:

- forming a n-type charge generation layer by depositing a matrix compound and depositing a metal dopant;
- forming an intermediate layer directly on the n-type charge generation layer by depositing a hole transport compound consisting essentially of at least one compound selected from arylamine, diarylamine, triarylamine, formula (IIa) and formula (IIb);
- forming a p-type charge generation layer directly on the intermediate layer by depositing a hole transport matrix

compound consisting essentially of at least one compound selected from arylamine, diarylamine, triarylamine, formula (IIa) and formula (IIb) and depositing a radialene of formula (I);

wherein the hole transport compound and the hole transport matrix compound is selected the same or different.

According to one embodiment of the present invention, a method for preparation of an organic electroluminescent device as described above, comprises the following steps:

- providing a deposition source to deposit a radialene of formula (I) according to the invention, and
- providing a deposition source to deposit a hole transport compound selected from arylamine, diarylamine, triarylamine, formula (IIa) and (IIb) and a hole transport matrix compound consisting essentially of at least one compound selected from arylamine, diarylamine, triarylamine, formula (IIa) and formula (IIb);
  or providing a deposition source to deposit the hole transport compound consisting essentially of at least one compound selected from arylamine, diarylamine, triarylamine, formula (IIa) or formula (IIb), and a providing deposition source to deposit the radialene of formula (I),
- providing a deposition source to deposit the matrix compound;
- providing a deposition source to deposit the metal dopant;
- forming a n-type charge generation layer by depositing the matrix compound released from the deposition source and metal dopant released from the deposition source;
- forming an intermediate layer by depositing the hole transport compound consisting essentially of at least one compound selected from arylamine, diarylamine, triarylamine, formula (IIa) and formula (IIb) released from the deposition source,
- forming a p-type charge generation layer by depositing the hole transport matrix compound consisting essentially of at least one compound selected from arylamine, diarylamine, triarylamine, formula (IIa) and formula (IIb) released from the deposition source and the radialene of formula (I) released from the deposition source;

wherein the hole transport compound and the hole transport matrix compound is selected the same or different.

According to one embodiment of the present invention, a method for preparation of an organic electroluminescent device as described above, comprises the following steps:

- providing a deposition source to deposit a radialene of formula (I) according to the invention, and
- providing a deposition source to deposit a hole transport compound consisting essentially of at least one compound selected from arylamine, diarylamine, triarylamine, formula (IIa) and formula (IIb) and a hole transport matrix compound according to formula (IIa) or (IIb);
  or providing a deposition source to deposit the hole transport compound consisting essentially of at least one compound selected from arylamine, diarylamine, triarylamine, formula (IIa) and formula (IIb), and a providing deposition source to deposit the radialene of formula (I),
- providing a deposition source to deposit the matrix compound;
- providing a deposition source to deposit the metal dopant;
- forming a n-type charge generation layer by depositing the matrix compound released from the deposition source and metal dopant released from the deposition source;
- forming an intermediate layer directly on the n-type charge generation layer by depositing the hole transport compound consisting essentially of at least one compound selected from arylamine, diarylamine, triarylamine, formula (IIa) and formula (IIb) released from the deposition source,
- forming a p-type charge generation layer by depositing the hole transport matrix compound consisting essentially of at least one compound selected from arylamine, diarylamine, triarylamine, formula (IIa) and formula (IIb) released from the deposition source and the radialene of formula (I) released from the deposition source;

wherein the hole transport compound and the hole transport matrix compound is selected the same or different.

According to one embodiment of the present invention, a method for preparation of an organic electroluminescent device as described above, comprises the following steps:

- providing a deposition source to deposit a radialene of formula (I) according to the invention, and
- providing a deposition source to deposit a hole transport compound consisting essentially of at least one compound selected from arylamine, diarylamine, triarylamine, formula (IIa) and formula (IIb) and a hole transport matrix compound consisting essentially of at least one compound selected from arylamine, diarylamine, triarylamine, formula (IIa) and formula (IIb);
  or providing a deposition source to deposit the hole transport compound consisting essentially of at least one compound selected from arylamine, diarylamine, triarylamine, formula (IIa) and (IIb), and a providing deposition

source to deposit the radialene of formula (I),
- providing a deposition source to deposit the matrix compound;
- providing a deposition source to deposit the metal dopant;
- forming a n-type charge generation layer by depositing the matrix compound released from the deposition source and metal dopant released from the deposition source;
- forming an intermediate layer by depositing the hole transport compound consisting essentially of at least one compound according to formula (IIa) or formula (IIb) released from the deposition source,
- forming a p-type charge generation layer directly on the intermediate layer by depositing the hole transport matrix compound consisting essentially of at least one compound selected from arylamine, diarylamine, triarylamine, formula (IIa) and formula (IIb) released from the deposition source and the radialene of formula (I) released from the deposition source;

wherein the hole transport compound and the hole transport matrix compound is selected the same or different.

According to one embodiment of the present invention, a method for preparation of an organic electroluminescent device as described above, comprises the following steps:

- providing a deposition source to deposit a radialene of formula (I) according to the invention, and
- providing a deposition source to deposit a hole transport compound consisting essentially of at least one compound selected from arylamine, diarylamine, triarylamine, formula (IIa) or (IIb) and a hole transport matrix compound consisting essentially of at least one compound arylamine, diarylamine, triarylamine, formula (IIa) and formula (IIb));
  or providing a deposition source to deposit the hole transport compound consisting essentially of at least one compound selected from arylamine, diarylamine, triarylamine, formula (IIa) or formula (IIb), and a providing deposition source to deposit the radialene of formula (I),
- providing a deposition source to deposit the matrix compound;
- providing a deposition source to deposit the metal dopant;
- forming a n-type charge generation layer by depositing the matrix compound released from the deposition source and metal dopant released from the deposition source;
- forming an intermediate layer directly on the n-type charge generation layer by depositing the hole transport compound consisting essentially of at least one compound selected fromarylamine, diarylamine, triarylamine, formula (IIa) and formula (IIb) released from the deposition source,
- forming a p-type charge generation layer directly on the intermediate layer by depositing the hole transport matrix compound consisting essentially of at least one compound selected from arylamine, diarylamine, triarylamine, formula (IIa) and formula (IIb) released from the deposition source and the radialene of formula (I) released from the deposition source;

wherein the hole transport compound and the hole transport matrix compound is selected the same or different.

According to one embodiment of the present invention, a method for preparation of an organic electroluminescent device as described above, comprises the following steps:

- providing a first deposition source to deposit a radialene of formula (I) according to the invention, and
- providing a second deposition source to deposit a hole transport compound consisting essentially of at least one compound according to formula (IIa) and formula (IIb) and a hole transport matrix compound according to formula (IIa) or (IIb);
  or providing a second deposition source to deposit the hole transport compound consisting essentially of at least one compound selected from arylamine, diarylamine, triarylamine, formula (IIa) and formula (IIb), and a providing second prime deposition source to deposit the radialene of formula (I),
- providing a third deposition source to deposit the matrix compound;
- providing a fourth deposition source to deposit the metal dopant;
- forming a n-type charge generation layer by depositing the matrix compound released from the third deposition source and metal dopant released from fourth the deposition source;
- forming an intermediate layer by depositing the hole transport compound consisting essentially of at least one compound selected from arylamine, diarylamine, triarylamine, formula (IIa) and formula (IIb) released from the first deposition source,
- forming a p-type charge generation layer by depositing the hole transport matrix compound consisting essentially of at least one compound selected from arylamine, diarylamine, triarylamine, formula (IIa) and formula (IIb) released from the second or second prime deposition source and the radialene of formula (I) released from the first deposition source;

wherein the hole transport compound and the hole transport matrix compound is selected the same or different.

According to one embodiment of the present invention, a method for preparation of an organic electroluminescent device as described above, comprises the following steps:

- providing a first deposition source to deposit a radialene of formula (I) according to the invention, and
- providing a second deposition source to deposit a hole transport compound consisting essentially of at least one compound selected from arylamine, diarylamine, triarylamine, formula (IIa) and formula (IIb) and a hole transport matrix compound consisting essentially of at least one compound selected from arylamine, diarylamine, triarylamine, formula (IIa) and formula (IIb);
  or providing a second deposition source to deposit the hole transport compound consisting essentially of at least one compound selected from arylamine, diarylamine, triarylamine, formula (IIa) and formula (IIb), and a providing second prime deposition source to deposit the radialene of formula (I),
- providing a third deposition source to deposit the matrix compound;
- providing a fourth deposition source to deposit the metal dopant;
- forming a n-type charge generation layer by depositing the matrix compound released from the third deposition source and metal dopant released from fourth the deposition source;
- forming an intermediate layer directly on the n-type charge generation layer by depositing the hole transport compound selected from arylamine, diarylamine, triarylamine, formula (IIa) and (IIb) released from the first deposition source,
- forming a p-type charge generation layer by depositing the hole transport matrix compound consisting essentially of at least one compound selected from arylamine, diarylamine, triarylamine, formula (IIa) and formula (IIb) released from the second or second prime deposition source and the radialene of formula (I) released from the first deposition source;

wherein the hole transport compound and the hole transport matrix compound is selected the same or different.

According to one embodiment of the present invention, a method for preparation of an organic electroluminescent device as described above, comprises the following steps:

- providing a first deposition source to deposit a radialene of formula (I) according to the invention, and
- providing a second deposition source to deposit a hole transport compound consisting essentially of at least one compound selected from arylamine, diarylamine, triarylamine, formula (IIa) and formula (IIb) and a hole transport matrix compound consisting essentially of at least one compound selected from arylamine, diarylamine, triarylamine, formula (IIa) and formula (IIb);
  or providing a second deposition source to deposit the hole transport compound consisting essentially of at least one compound selected from arylamine, diarylamine, triarylamine, formula (IIa) and formula (IIb), and a providing second prime deposition source to deposit the radialene of formula (I),
- providing a third deposition source to deposit the matrix compound;
- providing a fourth deposition source to deposit the metal dopant;
- forming a n-type charge generation layer by depositing the matrix compound released from the third deposition source and metal dopant released from fourth the deposition source;
- forming an intermediate layer by depositing the hole transport compound consisting essentially of at least one compound selected from arylamine, diarylamine, triarylamine, formula (IIa) and formula (IIb) released from the first deposition source,
- forming a p-type charge generation layer directly on the intermediate layer by depositing the hole transport matrix compound consisting essentially of at least one compound selected from arylamine, diarylamine, triarylamine, formula (IIa) and formula (IIb) released from the second or second prime deposition source and the radialene of formula (I) released from the first deposition source;

wherein the hole transport compound and the hole transport matrix compound is selected the same or different.

According to one embodiment of the present invention, a method for preparation of an organic electroluminescent device as described above, comprises the following steps:

- providing a first deposition source to deposit a radialene of formula (I) according to the invention, and
- providing a second deposition source to deposit a hole transport compound consisting essentially of at least one compound selected from arylamine, diarylamine, triarylamine, formula (IIa) and formula (IIb) and a hole transport matrix compound consisting essentially of at least one compound selected from arylamine, diarylamine, triarylamine, formula (IIa) and formula (IIb);
  or providing a second deposition source to deposit the hole transport compound consisting essentially of at least one

compound selected from arylamine, diarylamine, triarylamine, formula (IIa) and formula (IIb), and a providing second prime deposition source to deposit the radialene of formula (I),
- providing a third deposition source to deposit the matrix compound;
- providing a fourth deposition source to deposit the metal dopant;
- forming a n-type charge generation layer by depositing the matrix compound released from the third deposition source and metal dopant released from fourth the deposition source;
- forming an intermediate layer directly on the n-type charge generation layer by depositing the hole transport compound consisting essentially of at least one compound selected from arylamine, diarylamine, triarylamine, formula (IIa) and formula (IIb) released from the first deposition source,
- forming a p-type charge generation layer directly on the intermediate layer by depositing the hole transport matrix compound consisting essentially of at least one compound selected from arylamine, diarylamine, triarylamine, formula (IIa) and formula (IIb) released from the second or second prime deposition source and the radialene of formula (I) released from the first deposition source;

wherein the hole transport compound and the hole transport matrix compound is selected the same or different. According to an embodiment of the present invention the hole transport matrix compound of the p-type charge generation layer is selected from the compound of formula (IIa) or the compound of formula (IIb).
According to an embodiment of the present invention the hole transport matrix compound of the p-type charge generation layer is selected from the compound of formula (IIa).
According to an embodiment of the present invention the hole transport compound of the intermediate layer is selected from the compound of formula (IIa) or the compound of formula (IIb).
According to an embodiment of the present invention the hole transport compound of the intermediate layer is selected from the compound of formula (IIa).
According to an embodiment of the present invention the hole transport compound of the intermediate layer is selected from the compound of formula (IIa) or the compound of formula (IIb), and the hole transport matrix compound of the p-type charge generation layer is selected from the compound of formula (IIa) or the compound of formula (IIb).
According to an embodiment of the present invention the hole transport compound of the intermediate layer is selected from the compound of formula (IIa), and the hole transport matrix compound of the p-type charge generation layer is selected from compound of formula (IIa).
According to one embodiment, the method may further include forming on the anode electrode, at least one layer selected from the group consisting of forming a hole transport layer or forming a hole blocking layer, an emission layer and a n-type charge generation layer between the anode electrode and the cathode layer.
The methods for deposition that can be suitable comprise:

- deposition via vacuum thermal evaporation;
- deposition via solution processing, preferably the processing is selected from spin-coating, printing, casting; and/or
- slot-die coating.

Preferably the method for deposition is a vacuum thermal evaporation.

Setup of the organic electroluminescent device

According to one embodiment of the invention the organic electroluminescent device is an organic light emitting diode.
According to a preferred embodiment of the invention, the organic electroluminescent device is an organic light emitting diode, wherein light is emitted through the cathode layer.
The present invention furthermore relates to a display device comprising an organic electroluminescent device according to the present invention.
According to a preferred embodiment of the invention, the display device comprising an organic electroluminescent device according to the present invention, wherein the cathode layer is transparent.

Further embodiments

According to one embodiment of the present invention, the organic electroluminescent device comprises a hole injection layer.
According to one embodiment of the present invention, the organic electroluminescent device comprises a hole injection layer, and wherein the hole injection layer is in direct contact to the anode layer.
According to one embodiment of the present invention, the organic electroluminescent device comprises a hole

injection layer, wherein the hole injection layer is in direct contact to the anode layer, and wherein the hole injection layer comprises an organic p-dopant.

According to one embodiment of the present invention, the organic electroluminescent device comprises a hole injection layer, wherein the hole injection layer is in direct contact to the anode layer, and wherein the hole injection layer comprises an organic p-dopant and a hole transport compound.

According to one embodiment of the present invention, the organic electroluminescent device comprises an electron injection layer.

According to one embodiment of the present invention, the organic electroluminescent device comprises an electron injection layer, and wherein the electron injection layer is in direct contact to the cathode layer.

According to one embodiment of the present invention, the organic electroluminescent device comprises an electron transport layer.

According to one embodiment of the present invention, wherein the organic electroluminescent device comprises a hole transport layer.

According to one embodiment of the present invention, wherein the organic electroluminescent device comprises an electron transport layer and a hole transport layer.

According to one embodiment of the present invention, wherein the organic electroluminescent device comprises an electron transport layer and a hole transport layer wherein the hole transport layer is arranged closer to the anode than the at least one electron transport layer.

According to one embodiment of the present invention, the organic electroluminescent device comprises at least one electron transport layer and at least one hole transport layer, wherein the first emission layer is arranged between the at least one hole transport layer and the at least one electron transport layer, wherein preferably, the at least one hole transport layer is arranged closer to the anode than the at least one electron transport layer.

According to one embodiment of the present invention, the organic electroluminescent device comprises an electron blocking layer and a hole blocking layer, wherein the electron blocking layer is preferably arranged between the hole transport layer and the first emission layer and the hole blocking layer is arranged between the electron transport layer and the first emission layer.

According to one embodiment of the present invention, the electroluminescent device further comprises at least one electron transport layer.

According to one embodiment of the present invention, the at least one electron transport layer is comprised in one of the first or second light-emitting unit.

According to one embodiment of the present invention, the organic electroluminescent device comprises a first electron transport layer, and a second electron transport layer.

According to one embodiment of the present invention, the electron transport layer is free of metal dopant, particularly free of metal dopant in the oxidation state (0).

According to one embodiment of the present invention, the n-type charge generation layer is adjacent to the first electron transport layer.

According to one embodiment of the present invention, the n-type charge generation layer is adjacent to the first electron transport layer and adjacent to the intermediate layer.

According to one embodiment of the present invention, the n-type charge generation layer is in direct contact to the first electron transport layer.

According to one embodiment of the present invention, the n-type charge generation layer is in direct contact to the first electron transport layer and adjacent to the intermediate layer.

According to one embodiment of the present invention, the n-type charge generation layer is in direct contact to the first electron transport layer and in direct contact to the intermediate layer.

According to one embodiment of the present invention, the n-type charge generation layer of each of the at least one charge generation layer is in direct contact to the at least one electron transport layer and adjacent to the p-type charge generation layer of said at least one charge generation layer.

According to one embodiment of the present invention, the organic electroluminescent device comprises a first hole transport layer, and second hole transport layer.

According to one embodiment of the present invention, the p-type charge generation layer is adjacent to the at least one hole transport layer.

According to one embodiment of the present invention, the p-type charge generation layer is in direct contact to the hole transport layer.

According to one embodiment of the present invention, the p-type charge generation layer is adjacent to the intermediate layer and adjacent to the at least one hole transport layer.

According to one embodiment of the present invention, the p-type charge generation layer is in direct contact to the intermediate layer and in direct contact to the at least one hole transport layer.

According to one embodiment of the present invention, the p-type charge generation layer of each of the at least

one intermediate connecting region is adjacent to the at least one hole transport layer.

According to one embodiment of the present invention, the p-type charge generation layer of each of the at least one intermediate connecting region is in direct contact to the at least one hole transport layer.

According to one embodiment of the present invention, the p-type charge generation layer of each of the at least one intermediate connecting region is adjacent to the n-type charge generation layer of said at least one intermediate connecting region and adjacent to the at least one hole transport layer.

According to one embodiment of the present invention, the p-type charge generation layer of each of the at least one intermediate connecting region is in direct contact to the n-type charge generation layer of said at least one intermediate interconnecting region and in direct contact to the at least one hole transport layer.

According to one embodiment of the present invention, the organic electroluminescent device further comprises a third light-emitting unit, and wherein the third light-emitting unit comprises a third emission layer

According to one embodiment of the present invention, the organic electroluminescent device further comprises a third light-emitting unit and a fourth light-emitting unit, wherein the third light-emitting unit comprises a third emission layer, and wherein the fourth light-emitting unit comprises a fourth emission layer.

According to one embodiment of the present invention, the organic electroluminescent device comprises at least two intermediate connecting regions and further comprises a third light-emitting unit, and wherein the third light-emitting unit comprises a third emission layer.

According to one embodiment of the present invention, the organic electroluminescent device comprises at least three intermediate connecting regions and further comprises a third light-emitting unit and a fourth light-emitting unit, wherein the third light-emitting unit comprises a third emission layer, and wherein the fourth light-emitting unit comprises a fourth emission layer.

According to one embodiment of the present invention, there is provided an organic electroluminescent device comprising: a substrate, an anode layer, a first hole injection layer, a first hole transport layer, a first optional electron blocking layer, a first emission layer, a first optional hole blocking layer, a first electron transport layer, an intermediate connecting region comprising an n-type charge generation layer, an intermediate layer, and a p-type charge generation layer, a second hole transport layer, a second optional electron blocking layer, a second emission layer, a second optional hole blocking layer, a second electron transport layer, and an electron injection layer and a cathode layer.

According to one embodiment of the present invention, there is provided an organic electroluminescent device comprising: a substrate, an anode layer, a first hole injection layer, a first hole transport layer, a first electron blocking layer, a first emission layer, a first optional hole blocking layer, a first electron transport layer, an intermediate connecting region comprising an n-type charge generation layer, an intermediate layer, and a p-type charge generation layer, a second hole transport layer, a second electron blocking layer, a second emission layer, a second optional hole blocking layer, a second electron transport layer, and an electron injection layer and a cathode layer.

According to one embodiment of the present invention, there is provided an organic electroluminescent device comprising: a substrate, an anode layer, a first hole injection layer, a first hole transport layer, a first electron blocking layer, a first emission layer, a first electron transport layer, an intermediate connecting region comprising an n-type charge generation layer, an intermediate layer, and a p-type charge generation layer, a second hole transport layer, a second electron blocking layer, a second emission layer, a hole blocking layer, a second electron transport layer, and an electron injection layer and a cathode layer.

According to one embodiment of the present invention, there is provided an organic electroluminescent device comprising: a substrate, an anode layer, a hole injection layer, a first hole transport layer, a first optional electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second optional electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third optional electron blocking layer, a third emission layer, a third optional hole blocking layer, a third electron transport layer and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a third optional hole blocking layer, a third electron transport layer and an electron injection layer and a cathode layer.

According to one embodiment of the present invention, there is provided an organic electroluminescent device

comprising: a substrate, an anode layer, a hole injection layer, a first hole transport layer, a first electron blocking layer, a first emission layer, electron transport layer, a first intermediate connecting region comprising first n-type charge generation layer, a first intermediate layer, and a first p-type charge generation layer, a second hole transport layer, a second electron blocking layer, a second emission layer, a first optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a second optional hole blocking layer, a third electron transport layer and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, an optional hole blocking layer, a third electron transport layer and an electron injection layer and a cathode layer.

According to one embodiment of the present invention, there is provided an organic electroluminescent device comprising: a substrate, an anode layer, a hole injection layer, a first hole transport layer, a first optional electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second optional electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third optional electron blocking layer, a third emission layer, a third optional hole blocking layer, a third electron transport layer, a third intermediate connecting region comprising a third n-type charge generation layer, a third intermediate layer, and a third p-type charge generation layer, a fourth hole transport layer, a fourth optional electron blocking layer, a fourth emission layer, a fourth optional hole blocking layer, a fourth electron transport layer, and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, a first optional hole blocking layer, a first electron transport layer, a first intermediate connecting region comprising first n-type charge generation layer, a first intermediate layer, and a first p-type charge generation layer, a second hole transport layer, a second electron blocking layer, a second emission layer, a second optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a third optional hole blocking layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, a fourth optional hole blocking layer, a fourth electron transport layer, and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a first optional hole blocking layer, a second electron transport layer, a second intermediate connecting region comprising a second n-type charge generation layer, a second intermediate layer, and a second p-type charge generation layer, a third hole transport layer, a third electron blocking layer, a third emission layer, a second optional hole blocking layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, a third optional hole blocking layer, a fourth electron transport layer, and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, a first optional hole blocking layer, a third electron transport layer, a third intermediate connecting region comprising a third n-type charge

generation layer, a third intermediate layer, and a third p-type charge generation layer, a fourth hole transport layer, a fourth electron blocking layer, a fourth emission layer, a second optional hole blocking layer, a fourth electron transport layer, and an electron injection layer and a cathode layer.

According to one embodiment of the present invention, there is provided an organic electroluminescent device comprising: a substrate, an anode layer, a hole injection layer, a first hole transport layer, a first electron blocking layer, a first emission layer, a first electron transport layer, a first intermediate connecting region comprising first n-type charge generation layer, a first intermediate layer, and a first p-type charge generation layer, a second hole transport layer, a second electron blocking layer, a second emission layer, a second electron transport layer, a second intermediate connecting region comprising a second n-type charge generation layer, a second intermediate layer, and a second p-type charge generation layer, a third hole transport layer, a third electron blocking layer, a third emission layer, a third electron transport layer, a third intermediate connecting region comprising a third n-type charge generation layer, a third intermediate layer, and a third p-type charge generation layer, a fourth hole transport layer, a fourth electron blocking layer, a fourth emission layer, an optional hole blocking layer, a fourth electron transport layer, and an electron injection layer and a cathode layer.

Substantially covalent matrix compound

According to one embodiment of the present invention, the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the present invention, the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

Compound of formula (VII) or a compound of formula (VIII)

According to another aspect of the present invention, the substantially covalent matrix compound may comprises at least one arylamine compound, diarylamine compound, triarylamine compound, a compound of formula (VII) or a compound of formula (VIII):

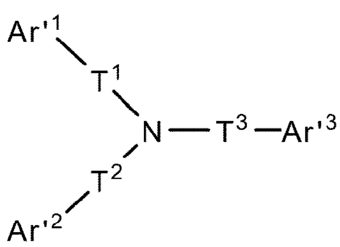 (VII), 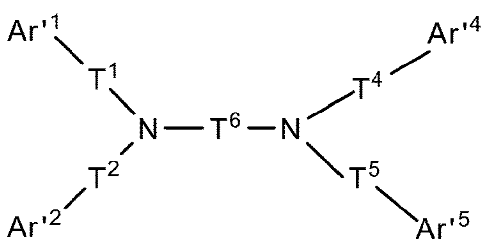 (VIII),

wherein:

- $T^1$, $T^2$, $T^3$, $T^4$ and $T^5$ are independently selected from a single bond, phenylene, biphenylene, terphenylene or naphthenylene, preferably a single bond or phenylene;
- $T^6$ is phenylene, biphenylene, terphenylene or naphthenylene;
- Ar'$^1$, Ar'$^2$, Ar'$^3$, Ar'$^4$ and Ar'$^5$ are independently selected from substituted or unsubstituted $C_6$ to $C_{20}$ aryl, or substituted

or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar'^1$, $Ar'^2$, $Ar'^3$, $Ar'^4$ and $Ar'^5$ are selected the same or different from the group comprising H, D, F, $C(=O)R'^2$, CN, $Si(R'^2)_3$, $P(=O)(R'^2)_2$, $OR'^2$, $S(=O)R'^2$, $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R'^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment wherein $Ar'^1$, $Ar'^2$, $Ar'^3$, $Ar'^4$ and $Ar'^5$ may be independently selected from D1 to D16:

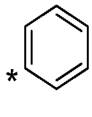 (D1), 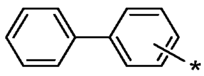 (D2), 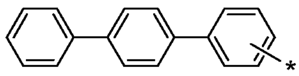 (D3), 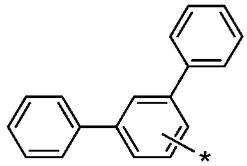 (D4),

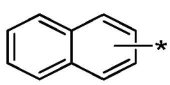 (D5), 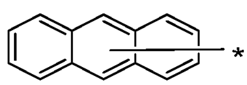 (D6), 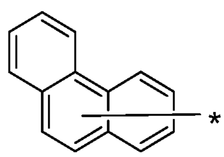 (D7), 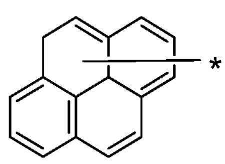 (D8),

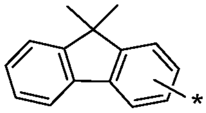 (D9), 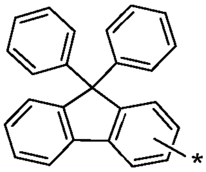 (D10), 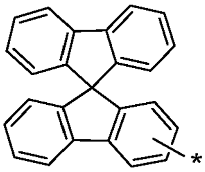 (D11),

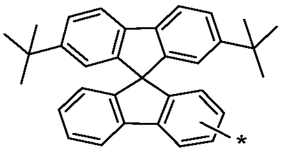 (D12), 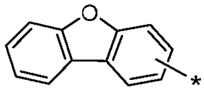 (D13), 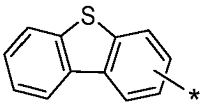 (D14),

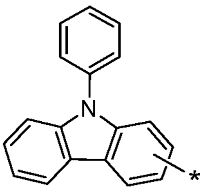 (D15), 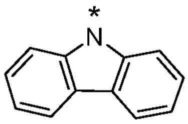 (D16),

wherein the asterix "*" denotes the binding position.

According to an embodiment, wherein Ar'1, Ar'2, Ar'3, Ar'4 and Ar'5 may be independently selected from D1 to D15; alternatively selected from D1 to D10 and D13 to D15.

According to an embodiment, wherein Ar'1, Ar'2, Ar'3, Ar'4 and Ar'5 may be independently selected from the group consisting of D1, D2, D5, D7, D9, D10, D13 to D16.

The rate onset temperature may be in a range particularly suited to mass production, when Ar'1, Ar'2, Ar'3, Ar'4 and Ar'5 are selected in this range.

The "matrix compound of formula (VII) or formula (VIII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (VII) or formula (VIII) are selected from F1 to F18:

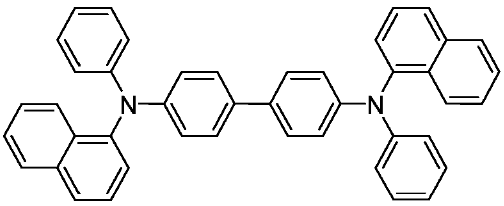 (F1), 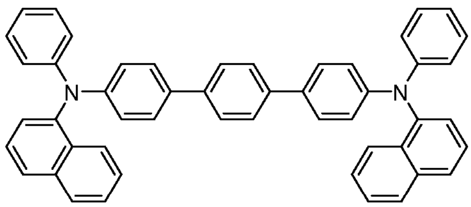 (F2),

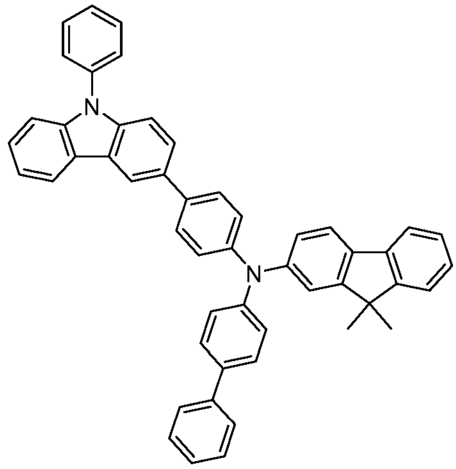

(F3),

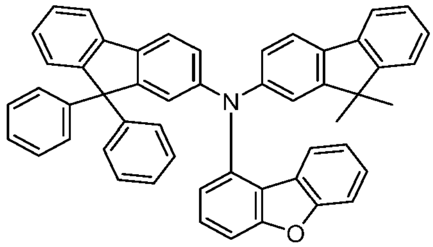

(F4),

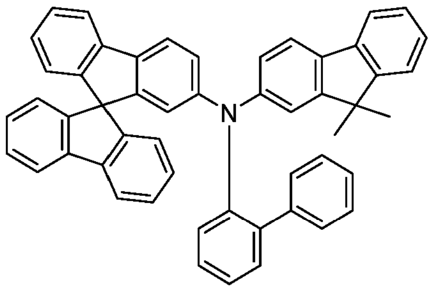

(F5),

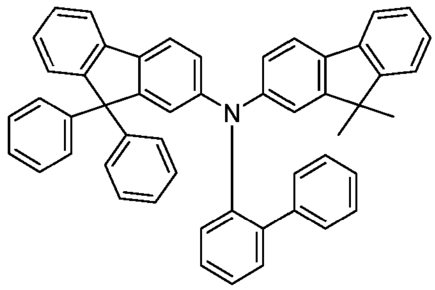

(F6),

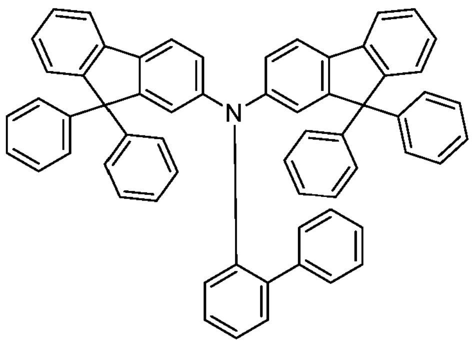

(F7),

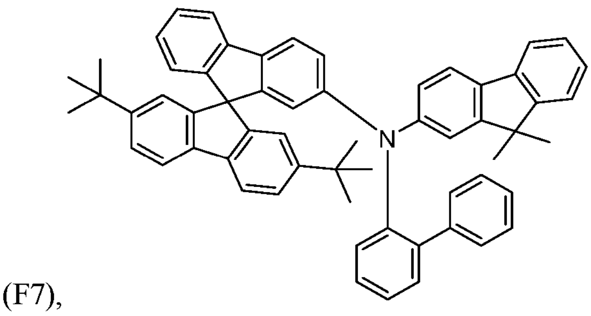

(F8),

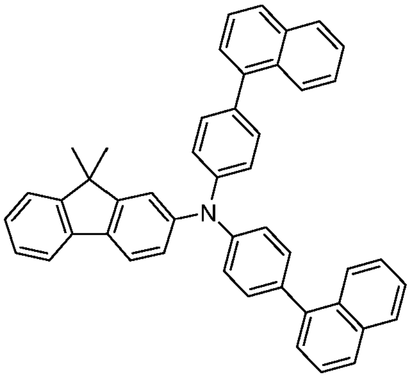

(F9),

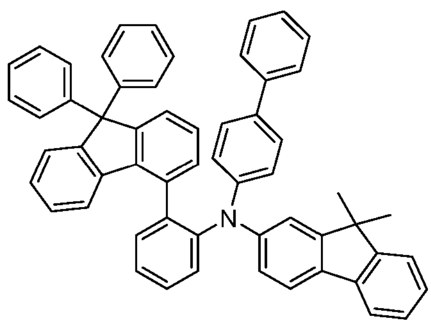

(F10),

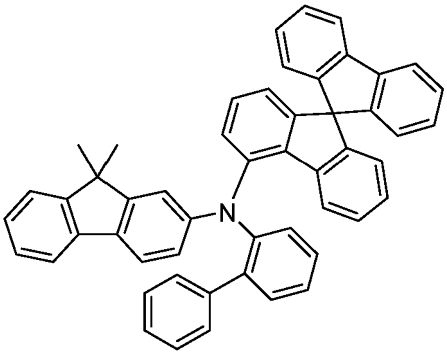
(F11),

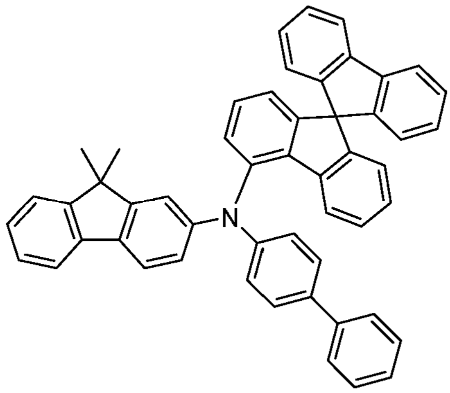
(F12),

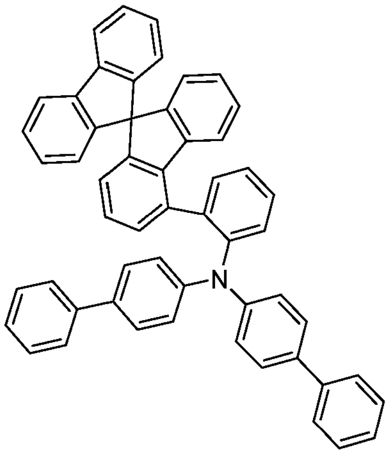
(F13),

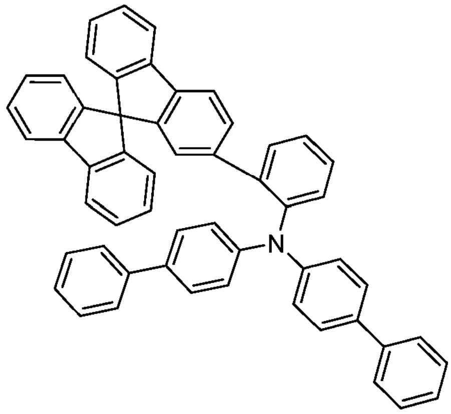
(F14),

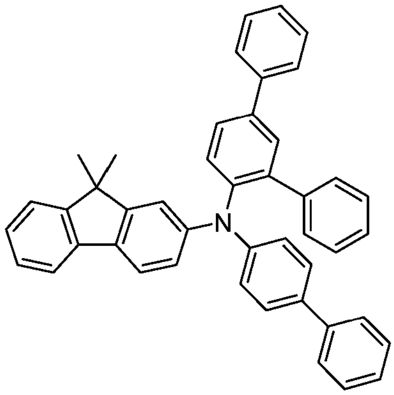
(F15),

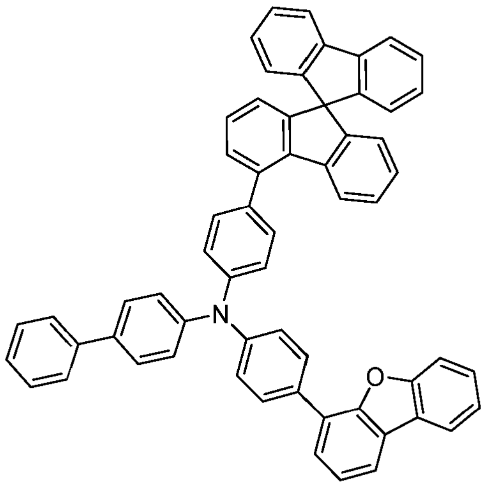
(F16),

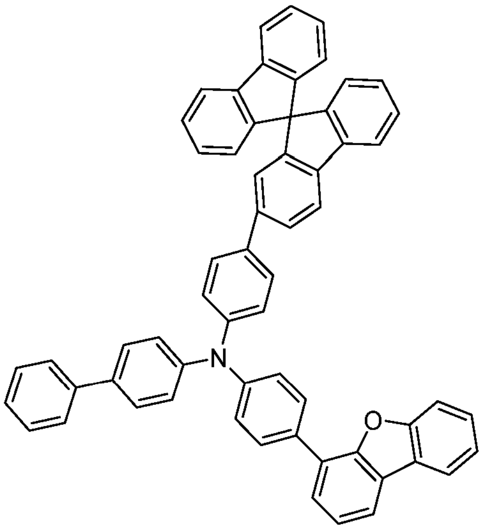
(F17)
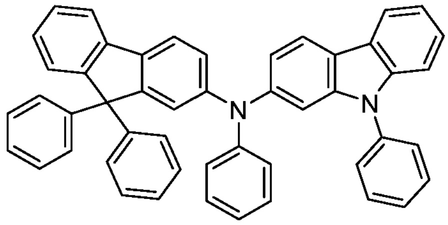
(F18).

According to one embodiment of the invention the organic electroluminescent device is an organic light emitting diode.

According to a preferred embodiment of the invention, the organic electroluminescent device is an organic light emitting diode, wherein light is emitted through the cathode layer.

The present invention furthermore relates to a display device comprising an organic electroluminescent device according to the present invention.

According to a preferred embodiment of the invention, the display device comprising an organic electroluminescent device according to the present invention, wherein the cathode layer is transparent.

p-type charge generation layer (other than the p-type charge generation layer of the intermediate region)

The p-type charge generation layer may be formed on the anode layer or cathode layer by vacuum deposition, spin coating, printing, casting, slot-die coating, Langmuir-Blodgett (LB) deposition, or the like. When the a p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for example, from about 2 nm to about 15 nm, alternatively about 2 nm to about 12 nm.

Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

According to a preferred embodiment of the present invention, the hole injection layer may comprise a substantially covalent matrix compound.

The thickness of the HIL may be in the range from about 1 nm to about 100 nm, and for example, from about 1 nm to about 25 nm. When the thickness of the HIL is within this range, the HIL may have excellent hole injecting characteristics,

without a substantial penalty in driving voltage.

Preferably, the HIL is in direct contact to the anode layer.

The hole injection layer can comprise an organic p-dopant.

The organic p-dopant can be a radialene of formula (I).

The hole injection layer can comprise a hole transport compound.

The hole injection layer can comprise an organic p-dopant and a hole transport compound.

## Further layers

In accordance with the invention, the organic electroluminescent device may comprise, besides the layers already mentioned above, further layers. Exemplary embodiments of respective layers are described in the following:

### *Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### *Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

### *Hole transport layer*

The organic electroluminescent device according to the present invention may further comprise at least one hole transport layer (HTL). According to one embodiment of the present invention, the at least one hole transport layer is comprised in one of the first or second light-emitting unit, wherein preferably at least one hole transport layer is comprised in each light-emitting unit.

A hole transport layer (HTL) may be formed on the HIL or CGL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL or CGL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to a preferred embodiment of the present invention, the hole injection layer and the hole transport layer may comprise an identical substantially covalent matrix compound as described above.

According to one embodiment of the present invention, the hole transport layer may comprise a compound of formula (VII) or (VIII) as described above.

According to a preferred embodiment of the present invention, the hole injection layer and the hole transport layer may comprise an identical compound of formula (VII) or (VIII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical compound of formula (VII) or (VIII) as

described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

According to an embodiment of the present invention, the organic electroluminescent device may further comprise a photoactive layer, wherein the photoactive layer is arranged between the anode layer and the cathode layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

The photoactive layer may be a light-emitting layer or a light-absorbing layer, in particular a light-emitting layer.

*Emission layer (EML)*

According to an embodiment of the present invention, the organic electroluminescent device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100

parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electroluminescent device according to the present invention may further comprise at least one electron transport layer (ETL). According to one embodiment of the present invention, the at least one electron transport layer is comprised in one of the first or second light-emitting unit, wherein preferably at least one electron transport layer is comprised in each light-emitting unit.

According to another embodiment of the present invention, the electron transport layer may further comprise an azine compound, preferably a pyridine, pyrimidine or triazine compound, and most preferably a triazine compound or a pyrimidine compound.

According to another embodiment of the present invention, the electron transport layer may further comprise 2-([1,1'-biphenyl]-4-yl)-4-(9,9-diphenyl-9H-fluoren-4-yl)-6-phenyl-1,3,5-triazine, 2-(3-(2,6-dimethylpyridin-3-yl)-5-(phenanthren-9-yl)phenyl)-4,6-diphenyl-1,3,5-triazine, 3'-(4-phenyl-6-(spiro[fluorene-9,9'-xanthen]-2'-yl)-1,3,5-triazin-2-yl)-[1,1'-biphenyl]-4-carbonitrile, and 4'-(4-(4-(4,6-diphenyl-1,3,5-triazin-2-yl)phenyl)naphthalen-1-yl)-[1,1'-biphenyl]-4-carbonitrile.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the ETL is within this range, the ETL may have satisfactory electron-injecting properties, without a substantial penalty in driving voltage.

According to another embodiment of the present invention, the organic electroluminescent device may further comprise a hole blocking layer and an electron transport layer, wherein the hole blocking layer and the electron transport layer comprise an azine compound. Preferably, the azine compound is a pyridine, pyrimidine or triazine compound, and most preferably a triazine compound.

*Electron injection layer (EIL)*

An optional EIL, which may facilitates injection of electrons from the cathode, may be formed on the ETL preferably closest to the cathode, and more preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example,

the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

In a preferred embodiment, the cathode layer comprises a metal or metal alloy and is transparent.

It is to be understood that the cathode layer is not part of an electron injection layer or the electron transport layer.

## Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device according to an exemplary embodiment of the present invention.

FIG. 2 is a schematic sectional view of an organic electroluminescent device according to an exemplary embodiment of the present invention.

FIG. 3 is a schematic sectional view of an organic electroluminescent device according to an exemplary embodiment of the present invention.

FIG. 4 is a schematic sectional view of a stacked organic electroluminescent device according to another exemplary embodiment of the present invention.

FIG. 5 is a schematic sectional view of a stacked organic electroluminescent device according to another exemplary embodiment of the present invention.

FIG. 6 is a schematic sectional view of a stacked organic electroluminescent device according to another exemplary embodiment of the present invention.

FIG. 7 is a schematic sectional view of a stacked organic electroluminescent device according to another exemplary embodiment of the present invention.

FIG. 8 is a schematic sectional view of a stacked organic electroluminescent device according to another exemplary embodiment of the present invention.

FIG. 9 is a schematic sectional view of a stacked organic electroluminescent device according to another exemplary embodiment of the present invention.

FIG. 10 is a schematic sectional view of a stacked organic electroluminescent device according to another exemplary embodiment of the present invention.

FIG. 11 is a schematic sectional view of a stacked organic electroluminescent device according to another exemplary embodiment of the present invention.

FIG. 12 is a schematic sectional view of a stacked organic electroluminescent device according to another exemplary embodiment of the present invention.

FIG. 13 is a schematic sectional view of a stacked organic electroluminescent device according to another exemplary embodiment of the present invention.

FIG. 14 is a schematic sectional view of an anode layer 120 on a substrate 110.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an organic electroluminescent device 100, according to one exemplary embodiment of the present invention.

Referring to Fig. 1 the organic electroluminescent device 100 includes an anode layer 120, a first light-emitting unit 140, a first intermediate connecting region (ICR1) 150 comprising a first n-type charge generation layer (n-CGL1) 151, a first intermediate layer (IL1) 153, and a first p-type charge generation layer (p-CGL1) 152, wherein the n-type charge generation layer (n-CGL1) comprises a matrix compound and metal dopant, wherein the first intermediate layer (IL1) 153 comprises a hole transport compound, and wherein the first p-type charge generation layer (p-CGL1) 152 comprises the radialene of formula (I) and a hole transport matrix compound. The organic electroluminescent device 100 further comprises a second light-emitting unit 240, and a cathode layer (CAT) 190.

Fig. 2 is a schematic sectional view of an organic electroluminescent device 100, according to one exemplary embodiment of the present invention.

Referring to Fig. 2 the organic electroluminescent device 100 includes an anode layer 120, a hole injection layer (HIL) 130, a first light-emitting unit 140, a first intermediate connecting region (ICR1) 150 comprising a first n-type charge generation layer (n-CGL1) 151, a first intermediate layer (IL1) 153, and a first p-type charge generation layer (p-CGL1) 152, wherein the n-type charge generation layer (n-CGL1) comprises a matrix compound and metal dopant, wherein the first intermediate layer (IL1) 153 comprises a hole transport compound, and wherein the first p-type charge generation layer (p-CGL1) 152 comprises the radialene of formula (I) and a hole transport matrix compound. The organic electroluminescent device 100 further comprises a second light-emitting unit 240, an electron injection layer (EIL) 180, and a cathode layer (CAT) 190.

Fig. 3 is a schematic sectional view of an organic electroluminescent device 100, according to one exemplary embodiment of the present invention.

Referring to Fig. 3 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first intermediate connecting region (ICR1) 150 comprising a first n-type charge generation layer (n-CGL1) 151, a first intermediate layer (IL1) 153, and a first p-type charge generation layer (p-GCL1) 152, wherein the n-type charge generation layer (n-CGL1) comprises a matrix compound and metal dopant, wherein the first intermediate layer (IL1) 153 comprises a hole transport compound, and wherein the first p-type charge generation layer (p-CGL1) 152 comprises the radialene of formula (I) and a hole transport matrix compound. The organic electronic device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245. The organic electroluminescent device 100 further comprising and electron injection layer (EIL) 180, a cathode layer (CAT) 190.

Fig. 4 is a schematic sectional view of a stacked organic electroluminescent device 100, according to another exemplary embodiment of the present invention. Fig. 4 differs from Fig. 3 in that the organic electroluminescent device 100 of Fig. 3 further comprises a second intermediate connecting region (ICR2) 250 disposed on the second light-emitting unit 240, comprising a second n-type charge generation layer (n-CGL2) 251, a second intermediate layer (IL2) 253 and a second p-type charge generation layer (p-GCL2) 252, wherein the second n-type charge generation layer (n-CGL2) 251 may optionally also comprises a matrix compound and metal dopant, wherein the second intermediate layer (IL2) 253 may optionally also comprise a hole transport compound, and wherein the second p-type charge generation layer (p-CGL2) 252 may optionally also comprise the radialene of formula (I) and an hole transport matrix compound,. Wherein the organic electroluminescent device 100 of Fig. 4 further differs from Fig. 3 in that it further comprises a third light-emitting unit 340 disposed on the second intermediate connecting region (ICR2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

Fig. 5 is a schematic sectional view of a stacked organic electroluminescent device 100, according to another exemplary embodiment of the present invention. Fig. 5 differs from Fig. 4 in that the organic electroluminescent device 100 of Fig. 4 further comprises a third intermediate connecting region (ICR3) 350 disposed on the third light-emitting unit 340, comprising a third n-type charge generation layer (n-CGL3) 351, a third intermediate layer (IL3) 353, and a third p-type charge generation layer (p-GCL3) 352, wherein the third n-type charge generation layer (n-CGL3) 351 may optionally also comprise a matrix compound and a metal dopant, wherein the third intermediate layer (IL3) 353 may optionally also comprise a hole transport compound, and wherein the third p-type charge generation layer (p-CGL3) 352 may optionally also comprise the radialene of formula (I) and a hole transport matrix compound. Wherein the organic electroluminescent device 100 of Fig. 5 further differs from Fig. 3 in that it further comprises a fourth light-emitting unit 440 disposed on the third intermediate connecting region (ICR3) 350, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

Fig. 6 is a schematic sectional view of an organic electroluminescent device 100, according to one exemplary embodiment of the present invention.

Referring to Fig. 6 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising an n-type charge generation layer 161, and a p-type charge generation layer 162. The organic electroluminescent device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a first intermediate connecting region (ICR1) disposed on the second light-emitting unit 240, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprises a third light-emitting unit 340 disposed on the first intermediate connecting region (ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprising and electron injection layer (EIL) 180, a cathode layer (CAT) 190.

Fig. 7 is a schematic sectional view of an organic electroluminescent device 100, according to one exemplary embodiment of the present invention.

Referring to Fig. 7 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising a first intermediate connecting region (ICR1), disposed on the first light-emitting unit 140, comprising a first n-type charge generation layer (n-CGL1) 151 of the first intermediate connecting region, a first intermediate layer (IL1) 153, and a first p-type charge generation layer (p-GCL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises a hole transport compound, and wherein the first p-type charge generation layer (p-CGL1) 152 of the first intermediate connecting region comprises the radialene of formula (I) and a hole transport matrix compound.

The organic electroluminescent device 100 further comprising, a second light-emitting unit 240 disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161 disposed on the second light-emitting unit 240. A p-type charge generation layer 162 disposed on the n-type charge generation layer 161

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprising and electron injection layer (EIL) 180, a cathode layer (CAT) 190.

Fig. 8 is a schematic sectional view of an organic electroluminescent device 100, according to one exemplary embodiment of the present invention.

Referring to Fig. 8 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145. The organic electroluminescent device 100 further comprising an n-type charge generation layer 161, and a p-type charge generation layer 162. The organic electroluminescent device 100 further comprising, a second light-emitting unit 240, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a first intermediate connecting region (ICR1) 150

disposed on the second light-emitting unit 240, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprises a third light-emitting unit 340 disposed on the first intermediate connecting region (ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a second intermediate connecting region (ICR2) 250 disposed on the third light-emitting unit 340, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises a matrix compound and metal dopant, wherein the second intermediate layer (IL2) 253 may optionally also comprises hole transport compound, and wherein the second p-type charge generation layer (p-CGL2) 252 of the second intermediate connecting region may optionally also comprises the radialene of the formula (I) and a hole transport matrix compound.

The organic electroluminescent device 100 further comprises a fourth light-emitting unit 440 disposed on the second intermediate connecting region (ICR2) 250, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 9 is a schematic sectional view of an organic electroluminescent device 100, according to one exemplary embodiment of the present invention.

Referring to Fig. 9 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161, and a p-type charge generation layer 162.

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a second intermediate connecting region (ICR2) 250 disposed on the third light-emitting unit 340, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises a matrix compound and metal dopant, wherein the second intermediate layer (IL2) 253 may optionally also comprises hole transport compound, and wherein the second p-type charge generation layer (p-CGL3) 252 of the second intermediate connecting region may optionally also comprises the radialene of the formula (I) and a hole transport matrix compound.

The organic electroluminescent device 100 further comprises a fourth light-emitting unit 440 disposed on the second intermediate connecting region (ICR2) 250, comprising a fourth hole transport layer (HTL4) 441, a fourth electron blocking layer (EBL4) 442, a fourth emission layer (EML4) 443, a fourth hole blocking layer (HBL4) 444, and a fourth

electron transport layer (ETL4) 445.

The organic electroluminescent device 100 further comprising and electron injection layer (EIL) 180, a cathode layer (CAT) 190.

Fig. 10 is a schematic sectional view of an organic electroluminescent device 100, according to one exemplary embodiment of the present invention.

Referring to Fig. 10 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a second intermediate connecting region (ICR2) 250 disposed on the second light-emitting unit 240, comprising a n-type second charge generation layer (n-CGL2) 251 of the second intermediate connecting region, a second intermediate layer (IL2) 253 and a second p-type charge generation layer (p-CGL2) 252 of the second intermediate connecting region, wherein the second n-type charge generation layer (n-CGL2) 251 of the second intermediate connecting region may optionally also comprises a matrix compound and metal dopant, wherein the second intermediate layer (IL2) 253 may optionally also comprises hole transport compound, and wherein the second p-type charge generation layer (p-CGL3) 252 of the second intermediate connecting region may optionally also comprises the radialene of the formula (I) and a hole transport matrix compound.

The organic electroluminescent device 100 further comprises a third light-emitting unit 340 disposed on the second intermediate connecting region (ICR2) 250, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 161, and a p-type charge generation layer 162.

The organic electroluminescent device 100 further comprises a fourth light-emitting unit 440 disposed on p-type charge generation layer 162, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 11 is a schematic sectional view of an organic electroluminescent device 100, according to one exemplary embodiment of the present invention.

Referring to Fig. 11 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising an n-type charge generation layer 161, and a p-type charge generation layer 162.

The organic electroluminescent device 100 further comprising, a second light-emitting unit 240, disposed on the p-type charge generation layer 162, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further an n-type charge generation layer 261, and a p-type charge generation layer 262.

The organic electroluminescent device 100 further comprises a third light-emitting unit 340 disposed on the p-type charge generation layer 262, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises a first intermediate connecting region (ICR1) 150 disposed on the third light-emitting unit 340, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprises a fourth light-emitting unit 440 disposed on the first intermediate connecting region (ICR1) 150, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 12 is a schematic sectional view of an organic electroluminescent device 100, according to one exemplary embodiment of the present invention.

Referring to Fig. 12 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising a first intermediate connecting region (ICR1) 150 disposed on the first light-emitting unit 140, comprising a n-type first charge generation layer (n-CGL1) 151 of the first intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprising, a second light-emitting unit 240, disposed on the first intermediate connecting region (ICR1) 150, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises an n-type charge generation layer 161, and a p-type charge generation layer 162.

The organic electroluminescent device 100 further comprises a third light-emitting unit 340 disposed on the p-type charge generation layer 162, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 261, and a p-type charge generation layer 262.

The organic electroluminescent device 100 further comprises a fourth light-emitting unit 440 disposed on the p-type charge generation layer 262, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

Fig. 13 is a schematic sectional view of an organic electroluminescent device 100, according to one exemplary embodiment of the present invention.

Referring to Fig. 13 the organic electroluminescent device 100 includes a substrate 110, an anode layer 120, a hole injection layer (HIL) 130 comprising the radialene of formula (I), and a first light-emitting unit 140, comprising a first hole transport layer (HTL1) 141, a first electron blocking layer (EBL1) 142, a first emission layer (EML1) 143, a first hole blocking layer (HBL1) 144, and a first electron transport layer (ETL1) 145.

The organic electroluminescent device 100 further comprising an n-type charge generation layer 161, and a p-type charge generation layer 162.

The organic electroluminescent device 100 further comprising, a second light-emitting unit 240, disposed on the p-type charge generation layer 162, comprising a second hole transport layer (HTL2) 241, a second electron blocking layer (EBL2) 242, a second emission layer (EML2) 243, a second hole blocking layer (HBL2) 244, and a second electron transport layer (ETL2) 245.

The organic electroluminescent device 100 further comprises a first intermediate connecting region (ICR1) 150 disposed on the second light-emitting unit 240, comprising a n-type first charge generation layer (n-CGL1) 151 of the first

intermediate connecting region, a first intermediate layer (IL1) 153 and a first p-type charge generation layer (p-CGL1) 152 of the first intermediate connecting region, wherein the first n-type charge generation layer (n-CGL1) 151 of the first intermediate connecting region comprises a matrix compound and metal dopant, wherein the first intermediate layer (IL1) 153 comprises hole transport compound, and wherein the first p-type charge generation layer (p-CGL1) 152 of the first intermediate connecting region comprises the radialene of the formula (I) and a hole transport matrix compound.

The organic electroluminescent device 100 further comprises a third light-emitting unit 340 disposed on the intermediate connecting region(ICR1) 150, comprising a third hole transport layer (HTL3) 341, a third electron blocking layer (EBL3) 342, a third emission layer (EML3) 343, a third hole blocking layer (HBL3) 344, and a third electron transport layer (ETL3) 345.

The organic electroluminescent device 100 further comprises an n-type charge generation layer 261, and a p-type charge generation layer 262.

The organic electroluminescent device 100 further comprises a fourth light-emitting unit 440 disposed on p-type charge generation layer 262, comprising a fourth hole transport layer (HTL4) 441, a fourth electron blocking layer (EBL4) 442, a fourth emission layer (EML4) 443, a fourth hole blocking layer (HBL4) 444, and a fourth electron transport layer (ETL4) 445.

The organic electroluminescent device 100 further comprising and electron injection layer (EIL) 180, a cathode layer (CAT) 190.

FIG. 14 is a schematic sectional view of an anode layer 120 on a substrate 110. The anode layer 120 that comprises a first anode sub-layer 121, a second anode sub-layer 122 and a third anode sub-layer 123.

Hereinafter, one or more exemplary embodiments of the present invention will be described in detail with, reference to the following examples. However, these examples are not intended to limit the purpose and scope of the one or more exemplary embodiments of the present invention.

**Detailed description**

The invention is furthermore illustrated by the following examples which are illustrative only and non-binding.

Compounds of formula (I) may be prepared as described in EP2180029A1 and WO2016097017A1.

Compounds of formula (II) may be prepared by methods known in the art.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Selected Radialenes with respective LUMO level

| Compound | $Ar^1$ of $A^1$ | $Ar^2$ of $A^2$ | $Ar^3$ of $A^3$ | LUMO [eV] |
|---|---|---|---|---|
| A1 | 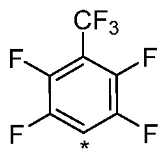 | 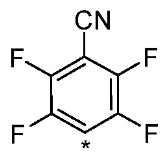 | 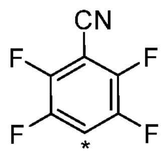 | -5.10 |
| A2 | 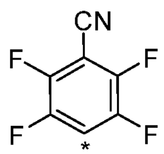 | 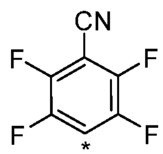 | 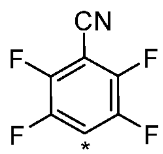 | -5.19 |
| A3 | 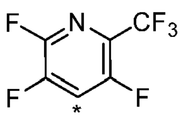 | 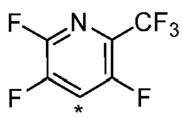 | 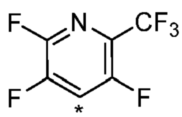 | -5.29 |

(continued)

| Compound | $Ar^1$ of $A^1$ | $Ar^2$ of $A^2$ | $Ar^3$ of $A^3$ | LUMO [eV] |
|---|---|---|---|---|
| A4 | 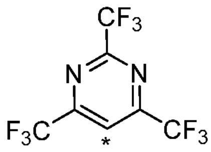 | 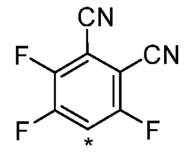 | 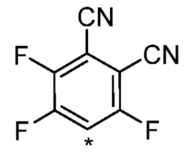 | -5.44 |
| A5 | 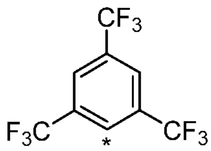 | 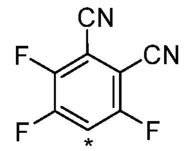 | 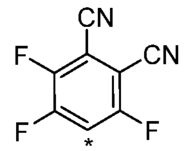 | -5.22 |
| A6 | 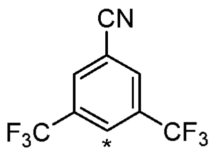 | 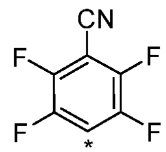 | 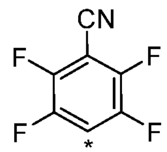 | -5.07 |
| A7 | 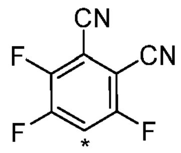 | 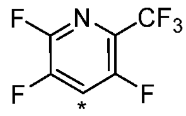 | 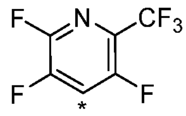 | -5.33 |
| A8 | 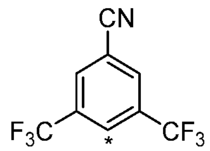 | 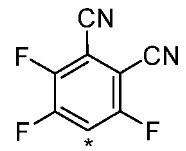 | 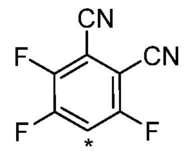 | -5.32 |
| A9 | 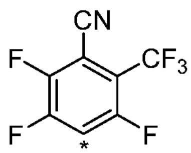 | 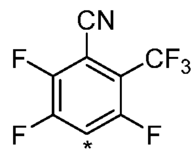 | 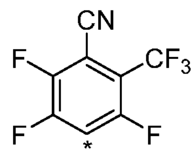 | -5.32 |
| A10 | 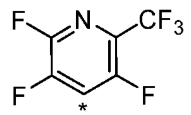 | 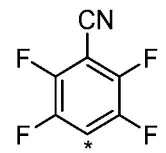 | 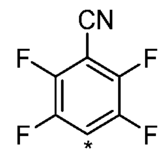 | -5.23 |
| A11 | 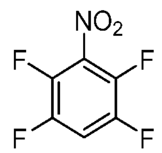 | 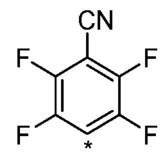 | 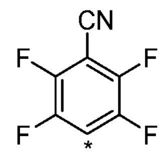 | -5.21 |
| A12 | 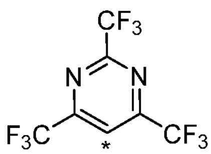 | 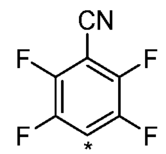 | 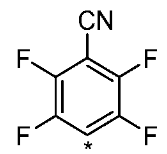 | -5.19 |
| A13 | 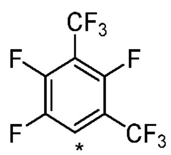 | 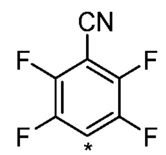 | 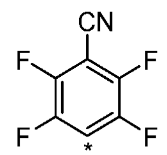 | -5.10 |

(continued)

| Compound | $Ar^1$ of $A^1$ | $Ar^2$ of $A^2$ | $Ar^3$ of $A^3$ | LUMO [eV] |
|---|---|---|---|---|
| A14 | 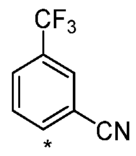 | 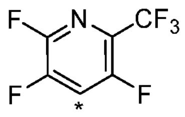 | 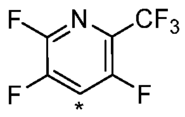 | -5.12 |
| A15 | 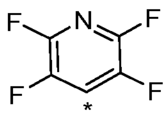 | 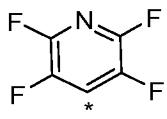 | 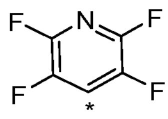 | -5.09 |
| A16 | 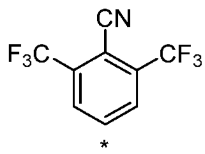 | 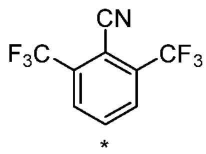 | 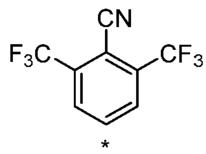 | -5.36 |

wherein the asterisk "*" denotes the binding position.

Selected Compounds of formula (II) with respective LUMO level.

| Compound | Structure | HOMO energy level [eV] |
|---|---|---|
| F1 | 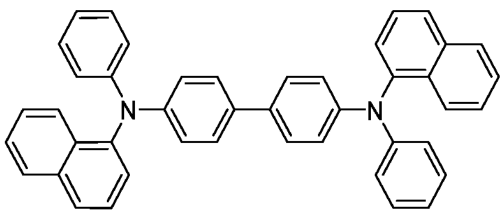 | -4.72 |
| F2 | 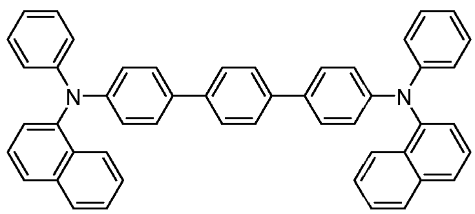 | -4.81 |
| F3 | 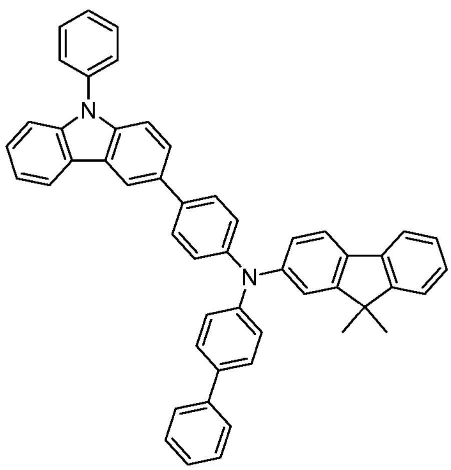 | -4.69 |

(continued)

| Compound | Structure | HOMO energy level [eV] |
|---|---|---|
| F4 | 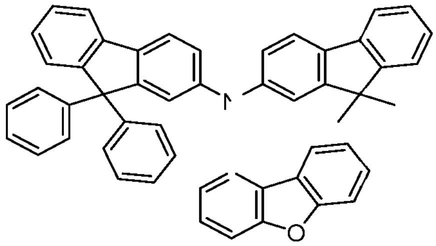 | -4.85 |
| F5 | 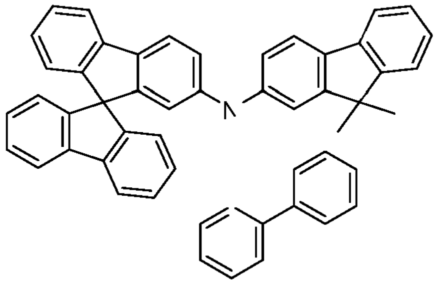 | -4.73 |
| F6 | 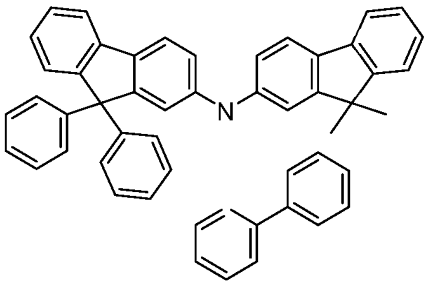 | -4.75 |
| F7 | 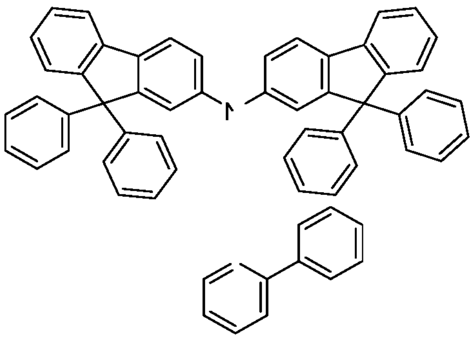 | -4.77 |
| F8 | 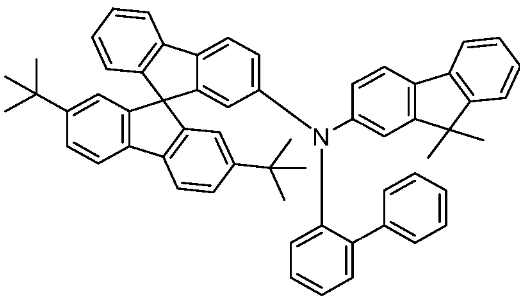 | -4.71 |

(continued)

| Compound | Structure | HOMO energy level [eV] |
|---|---|---|
| F9 | 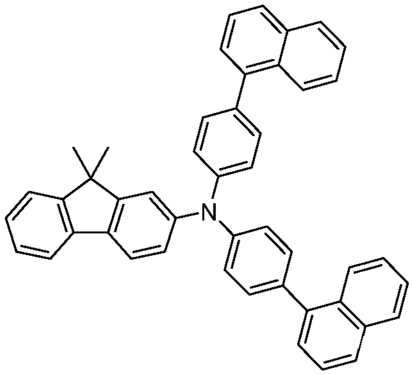 | -4.84 |
| F10 | 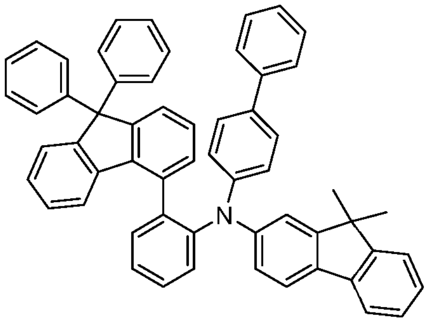 | -4.84 |
| F11 | 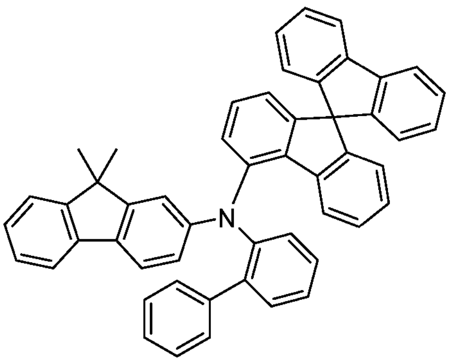 | -4.93 |
| F12 | 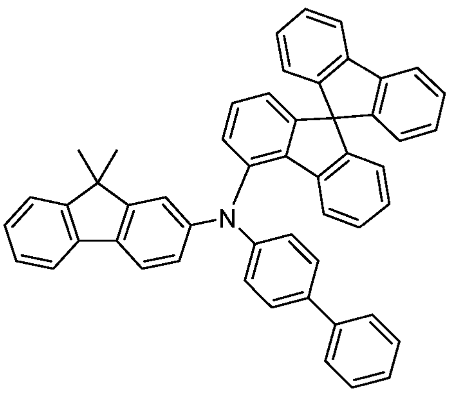 | -4.87 |

(continued)

| Compound | Structure | HOMO energy level [eV] |
|---|---|---|
| F13 | 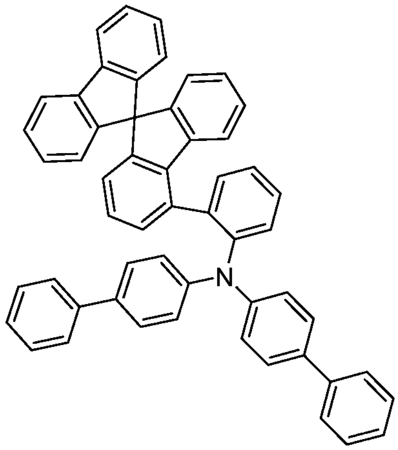 | -4.84 |
| F14 | 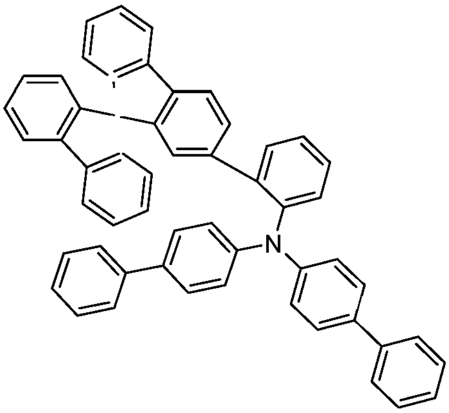 | -4.84 |
| F15 | 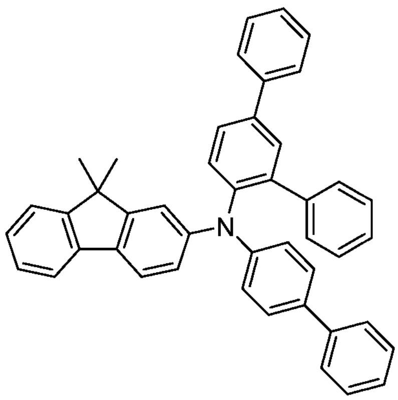 | -4.80 |

(continued)

| Compound | Structure | HOMO energy level [eV] |
|---|---|---|
| F16 | 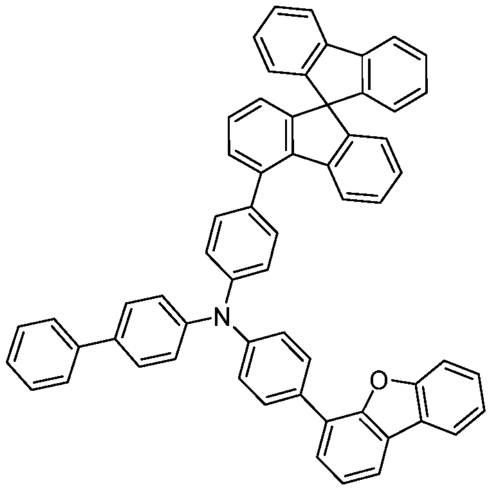 | -4.90 |
| F17 | 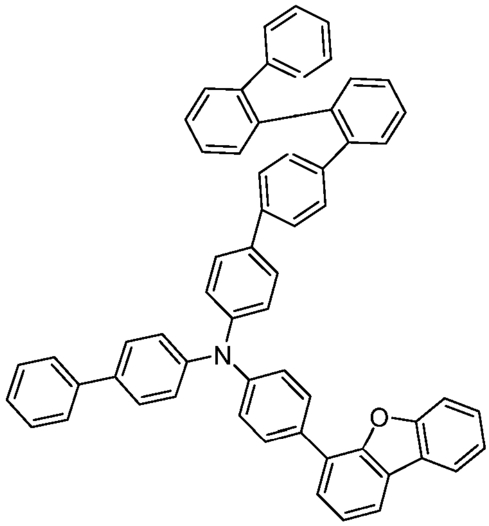 | -4.82 |
| F18 | 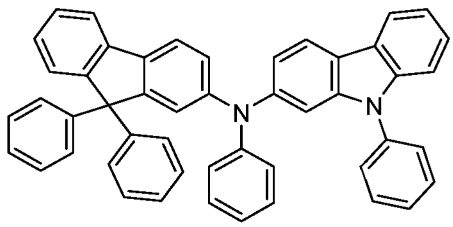 | -4.73 |

General procedure for fabrication of OLEDs

For the Examples, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment, to prepare the anode layer. The plasma treatment was performed in nitrogen atmosphere or in an atmosphere comprising 98 vol.-% nitrogen and 2 vol.-% oxygen.

Then, a hole injection layer (HIL) having a thickness of 10 nm is formed on the anode layer by co-depositing 99 wt.-% of compound F16 (N-([1,1'-biphenyl]-4-yl)-9,9-dimethyl-N-(4-(9-phenyl-9H-carbazol-3-yl)phenyl)-9H-fluoren-2-amine) and 1 wt.-% of 4,4',4"-((1E,1'E,1"E)-cyclopropane-1,2,3-triylidenetris(cyanomethanylylidene))tris(2,3,5,6-tetrafluorobenzonitrile).

Then, a first hole transport layer (HTL1) having a thickness of 29 nm is formed on the HIL by depositing compound

F16 (N-([1,1'-biphenyl]-4-yl)-9,9-dimethyl-N-(4-(9-phenyl-9H-carbazol-3-yl)phenyl)-9H-fluoren-2-amine).

Then, a first electron blocking layer (EBL1) having a thickness of 5 nm is formed on the HTL1 by depositing compound N,N-di([1,1'-biphenyl]-4-yl)-3'-(9H-carbazol-9-yl)-[1,1'-biphenyl]-4-amine .

Then, a first emission layer (EML1) having a thickness of 19 nm is formed on the EBL1 by co-depositing 99 vol.-% Dibenzofuran, 7-(phenyl-2 ,3 ,4 ,5 6 -d )-1-[10-(phenyl-2 ,3 ,4 ,5 6 -d )-9-anthracenyl] [2457172-82-4]as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis [4-(1,1-dimethylethyl)phenyl] [2482607-57-6] as blue dopant.

Then, a first electron transport layer (ETL1) having a thickness of 20 nm is formed on the first emission layer by co-depositing compound 2,2'-(1,3-Phenylene)bis[9-phenyl-1,10-phenanthroline] and LiQ in a ratio of 50:50 wt.-%.

Then, the n-CGL having a thickness of 15 nm is formed on the ETL by co-depositing 90 wt.% of compound 2,2'-(1,3-Phenylene)bis[9-phenyl-1,10-phenanthroline] and 10 wt.-% Yb.

In the inventive examples, as a next step, the intermediate layer having a thickness as described in the description of the corresponding examples is formed on the n-CGL by depositing a compound as described later on.

Then, in the inventive examples, a p-CGL having a thickness of 10 nm is formed on the intermediate layer by co-depositing a matrix compound and a radialene of formula (I). The composition of the p-CGL can be seen in the description of the corresponding examples.

Then, a second hole transport layer (HTL2) having a thickness of 43 nm is formed on the p-CGL by depositing a compound identical to the matrix compound of the p-CGL.

Then, a second electron blocking layer (EBL2) having a thickness of 5 nm is formed on the HTL2 by depositing compound N,N-di([1,1'-biphenyl]-4-yl)-3'-(9H-carbazol-9-yl)-[1,1'-biphenyl]-4-amine .

Then, a second emission layer (EML2) having a thickness of 19 nm is formed on the EBL2 by co-depositing 99 vol.-% Dibenzofuran, 7-(phenyl-2 ,3 4 ,5 6 -d )-1-[10-(phenyl-2 ,3 4,5 ,6 -d )-9-anthracenyl] [2457172-82-4] as EML host and 1 vol.-% 5H ,9H - [1]Benzothieno[2',3':5,6][1,4]azaborino[2,3,4-kl ]phenazaborine, 2,7,11-tris(1,1-dimethylethyl)-5,9-bis[4-(1,1-dimethylethyl) as blue dopant.

Then, a first hole blocking layer (HBL1) having a thickness of 5 nm is formed on the EML2 by depositing compound 4-([1,1'-biphenyl]-4-yl)-6-(3'-(9,9-dimethyl-9H-fluoren-4-yl)-[1,1'-biphenyl]-4-yl)-2-phenylpyrimidine

Then, a second electron transport layer (ETL2) having a thickness of 31 nm is formed on the HBL by co-depositing compound 6,6'-(naphthalene-1,2-diylbis(4,1-phenylene))bis(2,4-diphenyl-1,3,5-triazine) and LiQ in a ratio of 50:50 wt.-%.

Then, an electron injection layer (EIL) having a thickness of 2 nm is formed on the ETL2 by depositing Yb.

Then, the cathode layer having a thickness of 13 nm is formed on the EIL by co-depositing Ag:Mg (90:10 vol.-%) at a rate of 0.01 to 1 Å/s at $10^{-7}$ mbar.

Then, a capping layer having a thickness of 75 nm is formed on the cathode layer by depositing compound F16 (N-([1,1'-biphenyl]-4-yl)-9,9-dimethyl-N-(4-(9-phenyl-9H-carbazol-3-yl)phenyl)-9H-fluoren-2-amine).

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/$m^2$ using an Instrument Systems CAS-140CT array spectrometer (calibrated by Deutsche Akkreditierungsstelle (DAkkS)) for each of the voltage values. The cd/A efficiency at 15 mA/$cm^2$ is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 mA/$cm^2$.

Lifetime LT of the device is measured at ambient conditions (20°C) or at 85°C and 30 mA/$cm^2$, using a Keithley 2400 source meter, and recorded in hours.

The brightness of the device is measured using a calibrated photo diode. The lifetime LT is defined as the time till the brightness of the device is reduced to 97 % of its initial value.

The increase in operating voltage $\Delta$U is used as a measure of the operational voltage stability of the device.

This increase is also determined during the LT measurement and by subtracting the operating voltage after 1 hour after the start of operation of the device from the operating voltage after 100 hours.

$$\Delta U=[U100\ h)-\ U(1h)]$$

The smaller the value of ΔU the better is the operating voltage stability.

## Technical Effect of the invention

**Table 1: Performance and lifetime data of comparative and inventive OLED devices**

| Entry | p-CGL matrix | Intermediate layer | Voltage [V] | Voltage rise 85°C (1-100h) [V] | Ceff/CIEy [(cd/A] At 15 mA/cm2 | LT97, 85°C [h] |
|---|---|---|---|---|---|---|
| C-1a | F18 | --- | 6.72 | 0.471 | 311.14 | 20 |
| C-1b | CNHAT | CNHAT | 7.40 | 0.840 | 304.61 | --- |
| C-1c | F18 | CuPc | 6.74 | 0.443 | 297.63 | 19 |
| C-1d | F18 | CNHAT | 6.70 | 0.455 | 316.02 | 22 |
| I-1a | F18 | F18 | 6.74 | 0.283 | 314.52 | 20 |
| I-1b | F18 | F3 | 6.78 | 0.303 | 311.25 | 19 |
| I-1c | F18 | F4 | 6.81 | 0.323 | 309.40 | 20 |
| (C means comparative example, I means inventive example) | | | | | | |

If present, the thickness of the intermediate layer was always 1 nm. In case of example C-1b, the thickness of the intermediate layer and the p-type charge generation layer is together 10 nm. All examples used compound N-1 as the n-CGL matrix material and Yb as the n-CGL metal dopant. All examples except C-1b (which has no p-CGL-dopant) a mixture of 91 wt% of the respective p-CGL matrix material (as listed in the table) and 9wt% of compound A2 as p-CGL dopant was used.

Compound N-1 has the following structure

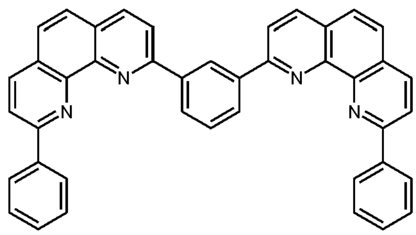

CNHAT has the following structure:

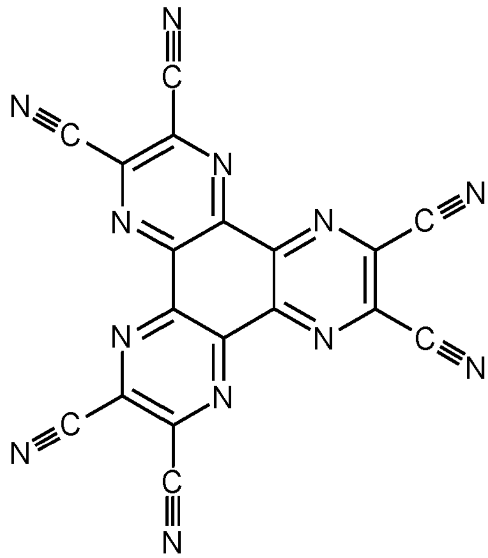

CuPC has the following structure:

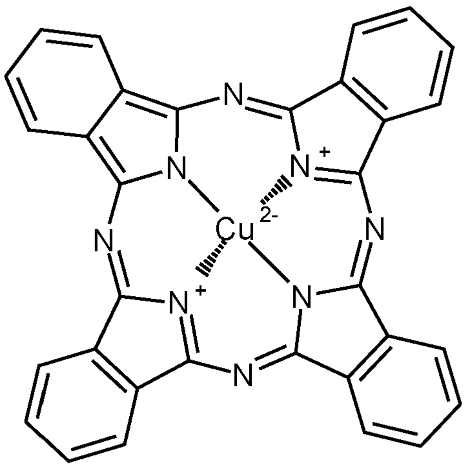

In the setup according to Table 1, several different compounds and were used for the intermediate layer, furthermore some comparative examples do not have an intermediate layer or and p-CGL-dopant layer.

The use of CNHAT as p-type charge generation layer and CNHAT as an intermediate layer (Comparative example 1b) instead of using compound F18 as hole transport matrix compound and compound A2 as p-type charge generation layer and without intermediate layer (comparative example 1a) leads to an increase of the voltage rise over time and decrease of the lifetime of the organic electroluminescent device.

The use of F18 as hole transport matrix compound and Compound A2 as p-type charge generation layer as p-type charge generation layer and compound CuPc as intermediate layer (comparative example 1c) instead of using compound F18 as hole transport matrix compound and Compound A2 as p-type charge generation layer and without intermediate layer (comparative example 1a) results in an increase of the voltage rise over time and decrease of the lifetime of the organic electroluminescent device.

The use of F18 as intermediate layer and Compound A2 as p-type charge generation layer and CNHAT as intermediate layer (comparative example 1d) instead of using compound F18 as hole transport matrix compound and Compound A2 as p-type charge generation layer and without intermediate layer (comparative example 1a) results in an increase of the voltage rise over time and decrease of the lifetime of the organic electroluminescent device.

In inventive example 1a, compound F18 as hole transport matrix compound and compound A2 as organic p-dopant in the p-type charge generation layer, and hole transport compound F18 as intermediate layer exhibits a remarkable decrease of the voltage rise over time and increase of the lifetime, and at the same time an increase or remaining and of the current efficiency of the organic electroluminescent device compared to comparative example 1.

In inventive example 1b, compound F18 as hole transport matrix compound and compound A2 as organic p-dopant in the p-type charge generation layer, and hole transport compound F3 as intermediate layer exhibits a remarkable

decrease of the voltage rise over time and increase of the lifetime, and at the same time an increase or remaining and of the current efficiency of the organic electroluminescent device compared to comparative example 1.

In inventive example 1c, compound F18 as hole transport matrix compound and compound A2 as organic p-dopant in the p-type charge generation layer, and hole transport compound F4 as intermediate layer exhibits a remarkable decrease of the voltage rise over time and increase of the lifetime, and at the same time an increase or remaining and of the current efficiency of the organic electroluminescent device compared to comparative example 1.

In the comparative example 1b and 1c, compound F18 was used as hole transport matrix compound and compound A2 as organic p-dopant in the p-type charge generation layer, and ,CuPc or CNHAT, respectively as intermediate layer. Comparative example 1b and 1b exhibit a higher voltage rise over time and lower lifetime of the organic electroluminescent devices than comparative example 1.

Further properties of comparative and inventive OLED devices are illustrated in Table 4:

**Table 2: Performance and lifetime data of comparative and inventive OLED devices**

| Entry | p-CGL matrix amount [wt.-%] | p-CGL dopant | p-CGL dopant amount [wt.-%] | Volta ge [V] | Voltage rise 85°C (1-100h) [V] | Ceff/CIEy [(cd/A] At 15 mA/cm$^2$ | LT97, 85°C [h] |
|---|---|---|---|---|---|---|---|
| C-2 | 89 | A3 | 11 | 6.71 | 0.942 | 317.99 | 21 |
| I- 2 | 89 | A3 | 11 | 6.72 | 0.365 | 320.76 | 20 |
| C- 3 | 91 | A11 | 9 | 6.73 | 0.999 | 310.80 | 28 |
| I- 3 | 91 | A11 | 9 | 6.77 | 0.532 | 311.00 | 30 |
| C- 4 | 91 | A16 | 9 | 6.71 | 0.314 | 286.02 | 16 |
| I- 4 | 91 | A16 | 9 | 6.82 | 0.233 | 287.73 | 18 |
| C- 5 | 91 | A5 | 9 | 6.77 | 0.377 | 281.91 | 19 |
| I- 5 | 91 | A5 | 9 | 6.97 | 0.271 | 287.02 | 20 |
| C- 6 | 84 | A6 | 16 | 6.78 | 0.455 | 321.31 | 20 |
| I- 6 | 84 | A6 | 16 | 6.79 | 0.300 | 324.52 | 20 |
| C- 7 | 92 | A15 | 8 | 6.77 | 0.902 | 298.78 | 17 |
| I- 7 | 92 | A15 | 8 | 6.80 | 0.410 | 300.24 | 18 |
| (C means comparative example, I means inventive example) | | | | | | | |

Table 2 shows properties of comparative and inventive decides. The inventive examples differ from the respective comparative examples that each time an intermediate layer, consisting of an 1nm layer of the compound of F18 was used. Furthermore all examples used compound N-1 as the n-CGL matrix compound and Yb as the n-CGL metal dopant, also compound F18 was used as the p-CGL matrix material in all examples.

It can be seen that - compared to the respective comparative example - in all of the devices according to the inventive examples 2 to 7 a decrease of the voltage rise over time, an increase of the lifetime and at the same time an increase or remaining of the current efficiency can be seen, when an intermediate layer containing an hole transport compound being an amine is used.

Thus, the voltage rise can be reduced by adding intermediate layer containing a hole transport compound being an amine.

The current efficiency can be increased by adding an intermediate layer containing a hole transport compound being an amine.

The voltage rise can be reduced and the current efficiency can be increased at the same time.

A high or good current efficiency may be beneficial for reduced power consumption and improved battery life, in particular in mobile devices.

A long lifetime may result in improved long-term stability of electronic devices.

A low voltage rise over time may result in improved long-term stability of electronic devices.

**Table 3: Performance and lifetime data of comparative and inventive OLED devices in dependence of the thickness of the intermediate layer**

| Entry | p-CGL matrix | p-CGL dopant | Thickness of interlayer [nm] | Voltage [V] | Voltage rise 20°C (1-100h) [V] |
|---|---|---|---|---|---|
| C-8 | F18 | A3 | --- | 6.67 | 0.35 |
| I-8a | F18 | A3 | 0.5 | 6.65 | 0.24 |
| I-8b | F18 | A3 | 1 | 6.68 | 0.22 |
| I-8c | F18 | A3 | 1.5 | 6.84 | 0.19 |
| I-8d | F18 | A3 | 2 | 7.13 | 0.11 |
| (C means comparative example, I means inventive example) | | | | | |

In Table 3, for all inventive examples compound F-18 was used as the intermediate layer. Furthermore, in all examples used compound N-1 as the n-CGL matrix compound and Yb as the n-CGL metal dopant. The thickness of the intermediate layer was varied. In all examples in Table 3 a mixture of 86 wt% of the respective p-CGL matrix material (as listed in the table) and 14 wt% of compound A3 as p-CGL dopant was used.

It is apparent that the addition of an intermediate layer containing a hole transport compound being an amine results in an decrease of the voltage rise over time of the organic electroluminescent device irrespective of the thickness of the organic electroluminescent device.

However, the operation voltage can even be decreased or kept stable in addition to the other improved performance data and life if the thickness of the intermediate layer equal or lower than 1nm.

A low or lower operating voltage may be important for the battery life of organic electroluminescent devices, in particular mobile devices.

A low voltage rise over time may result in improved long-term stability of electronic devices.

In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims. Furthermore, reference signs used in the description and claims do not limit the scope of the invention as claimed.

## Claims

**1.** An organic electroluminescent device comprising an anode layer (120), a cathode layer (190), a first light-emitting unit (140), a second light-emitting unit (240) and at least one intermediate connecting region (150),

wherein the at least one intermediate connecting region is arranged between the first and the second light-emitting unit,

wherein the first light-emitting unit comprises a first emission layer (143),
wherein the second light-emitting unit comprises a second emission layer (243),
wherein the at least one intermediate connecting region comprises an n-type charge generation layer (151), an intermediate layer (153), and a p-type charge generation layer (152),

wherein the n-type charge generation layer is arranged closer to the anode layer than the p-type charge generation layer;

wherein the p-type charge generation layer is arranged closer to the cathode layer than the n-type charge generation layer; and
wherein the intermediate layer is arranged between the n-type charge generation layer and the p-type charge generation layer

whereby
wherein the n-type charge generation layer comprises a matrix compound and metal dopant,
wherein the p-type charge generation layer comprises a hole transport matrix compound and a radialene of formula (I),

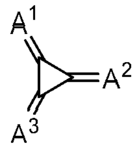

(I),

wherein in formula (I)

- $A^1$ is independently selected from a group of formula (Ia)

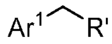

(Ia)

wherein $Ar^1$ is independently selected from substituted or unsubstituted aryl and substituted or unsubstituted heteroaryl
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (Ib)

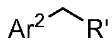

(Ib),

wherein $Ar^2$ is independently selected from substituted or unsubstituted aryl and substituted or unsubstituted heteroaryl
wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (Ic)

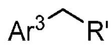

(Ic),

wherein $Ar^3$ is independently selected from substituted or unsubstituted aryl and substituted or unsubstituted heteroaryl
wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
and wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl,partially fluorinated $C_1$ to $C_8$ alkyl, perfluorinated $C_1$ to $C_8$ alkyl, halogen, F and CN;
wherein the intermediate layer comprises at least one hole transport compound selected from an arylamine compound, diarylamine compound, triarylamine compound, a compound of formula (IIa) or a compound of formula (IIb):

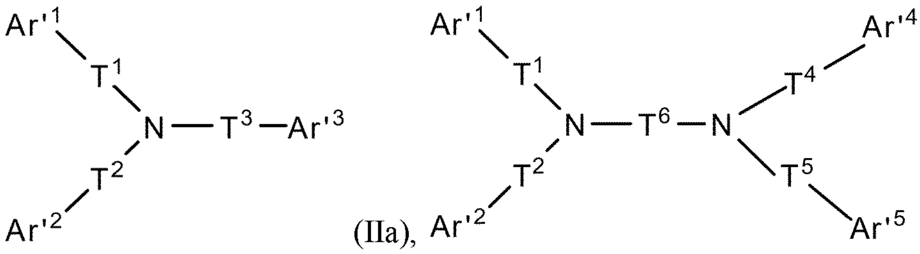

(IIa), (IIb),

wherein:
$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
$Ar'^1$, $Ar'^2$, $Ar'^3$, $Ar'^4$ and $Ar'^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of $Ar'^1$, $Ar'^2$, $Ar'^3$, $Ar'^4$ and $Ar'^5$ are selected the same or different from the group comprising H, D, F, $C(=O)R'^2$, CN, $Si(R'^2)_3$, $P(=O)(R'^2)_2$, $OR'^2$, $S(=O)R'^2$, $S(=O)_2R'^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R'^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

2. The organic electroluminescent device according to claim 1, wherein the intermediate layer essentially consists out of one or more of the hole transport compounds.

3. An organic electroluminescent device according to claim 1 or 2, wherein the intermediate layer has a layer thickness of ≤20 nm.

4. The organic electroluminescent device according to any one of claims 1 or 3, wherein the p-type charge generation layer is in direct contact to the intermediate layer

5. The organic electroluminescent device according to any one of claims 1 to 4, whereby the n-type charge generation layer is in direct contact to the intermediate layer.

6. The organic electroluminescent device according to any of the claims 1 to 5, wherein the hole transport compound of the intermediate layer has HOMO energy level calculated by using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, and the hole transport matrix compound of the p-type charge generation layer has a HOMO energy level calculated by using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, and wherein the absolute value of the difference between the HOMO energy level of the hole transport compound of the intermediate layer and the HOMO energy level of the hole transport matrix compound of the p-type charge generation layer is ≤0.5 eV; preferably ≤0.4 eV, more preferably ≤0.3 eV, even more preferably ≤0.2 eV, even more preferably ≤0.1 eV, and most preferably 0 eV.

7. The organic electroluminescent device according to any of the claims 1 to 6, wherein the at least one hole transport compound of the intermediate layer and the at least one hole transport matrix compound of the p-type charge generation layer are selected the same.

8. The organic electroluminescent device according to any one of claims 1 to 7, wherein the ratio of layer thickness between the intermediate layer and the p-type charge generation layer is in the range of ≥0.01 to ≤10.0.

9. The organic electroluminescent device according to any one of claims 1 to 8, whereby the ratio of layer thickness between the intermediate layer and the n-type charge generation layer is in the range of ≥0.01 to ≤10.0.

10. The organic electroluminescent device according to any one of claims 1 to 9, wherein in formula (I), $Ar^1$, $Ar^2$ and/or $Ar^3$ are independently selected from one of the following groups and preferably each R' is selected from CN:

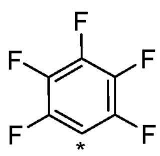 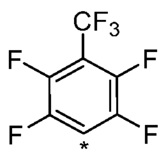 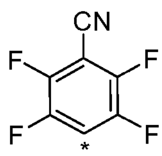 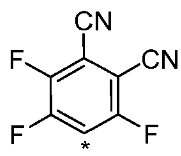 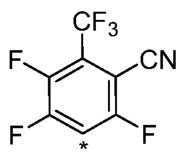

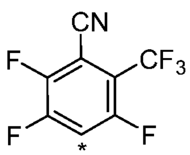 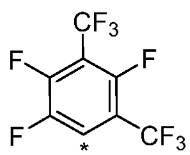 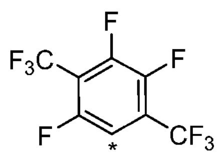 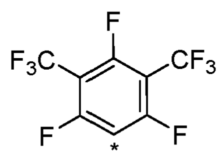 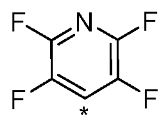

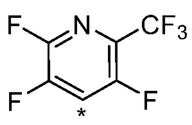 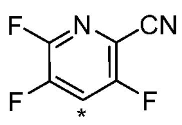 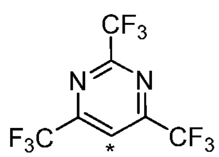 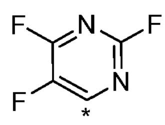 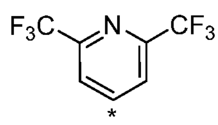

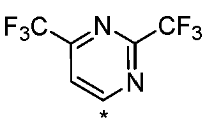 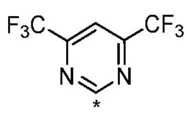 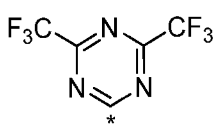 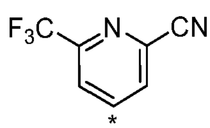 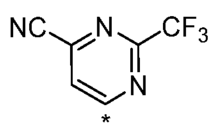

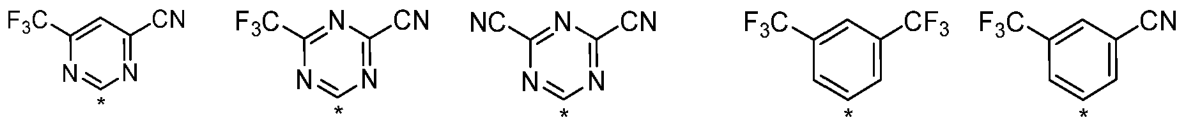

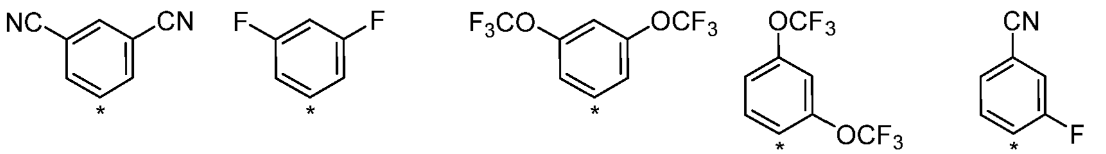

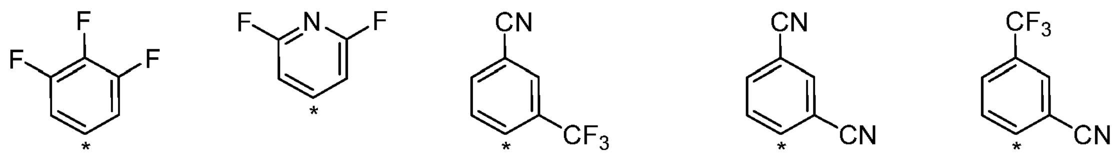

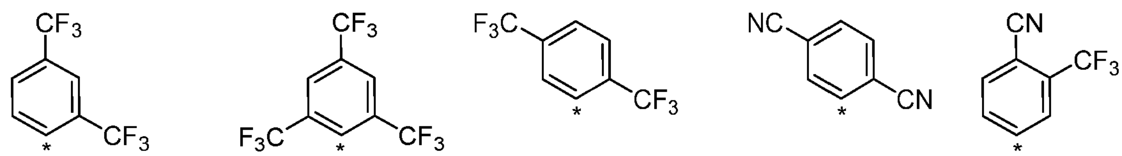

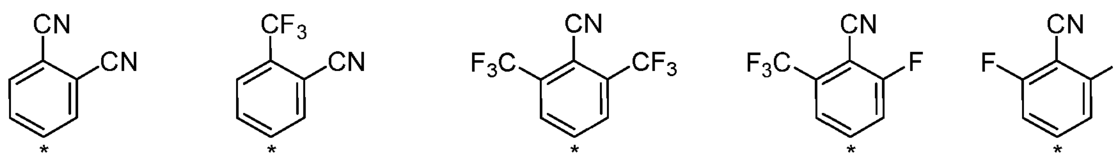

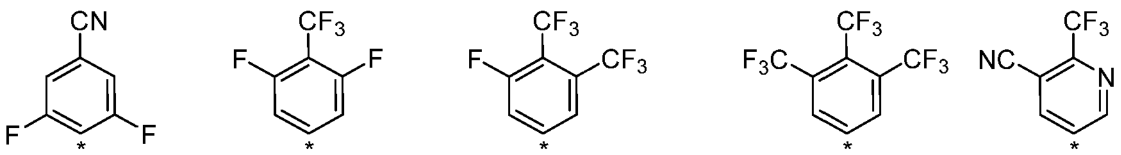

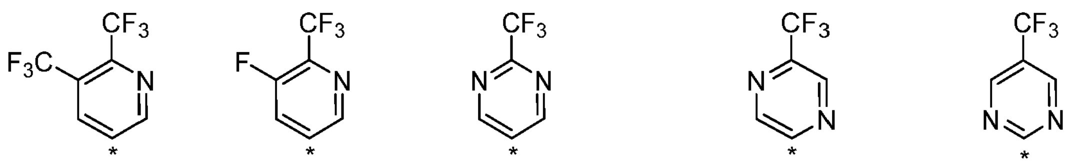

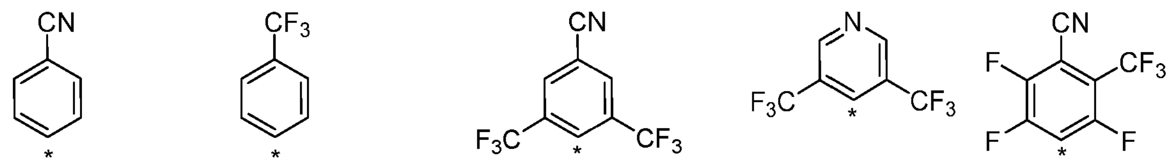

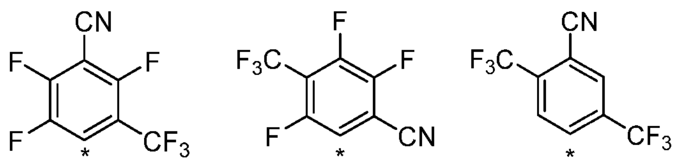

wherein the asterisk "*" denotes the binding position.

**11.** The organic electroluminescent device according to any one of claims 1 to 10, whereby the at least one hole transport

compound consists essentially of at least one compound selected from formula (IIa) and formula (IIb), preferably at least one hole transport compound consists essentially of at least one compound selected from formula (IIa).

**12.** The organic electroluminescent device according to any one of claims 1 to 11, whereby in formulae (IIa) and/or (IIb) - wherever applicable - Ar'1, Ar'2, Ar'3, Ar'4 and/or Ar'5 are independently selected from D1 to D16:

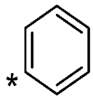 (D1), 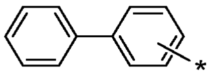 (D2), 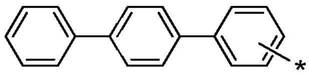 (D3), 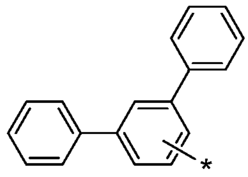 (D4),

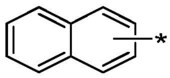 (D5), 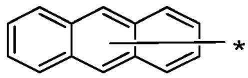 (D6), 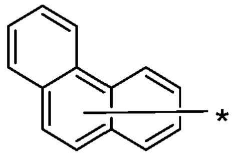 (D7),

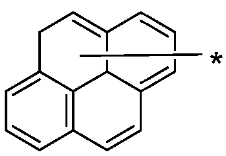 (D8),

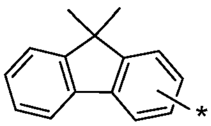 (D9), 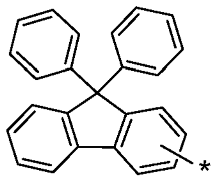 (D10), 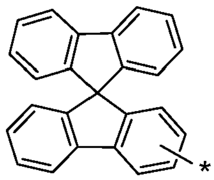 (D11),

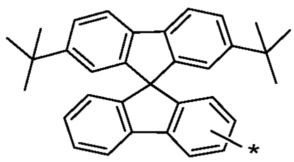 (D12), 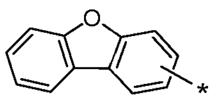 (D13), 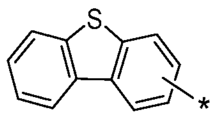 (D14),

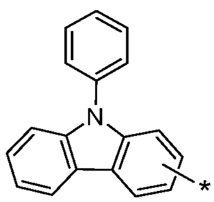 (D15), 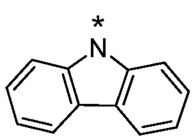 (D16),

wherein the asterix "*" denotes the binding position.

**13.** The organic electroluminescent device according to any one of claims 1 to 12, whereby the at least one hole transport compound and/or formulae (IIa) and/or (IIb) - wherever applicable - are selected from F1 to F18:

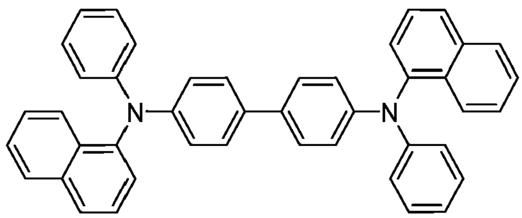 (F1), 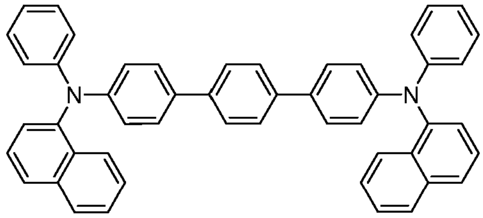 (F2),

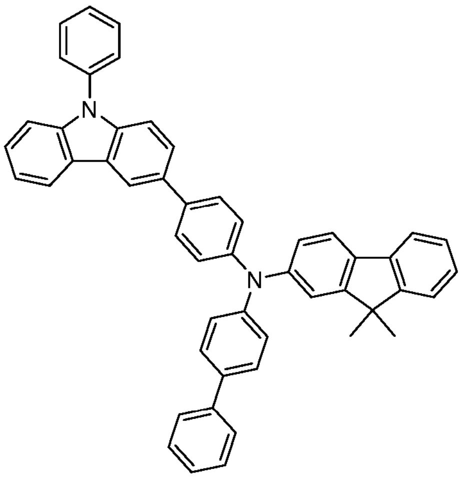 (F3), 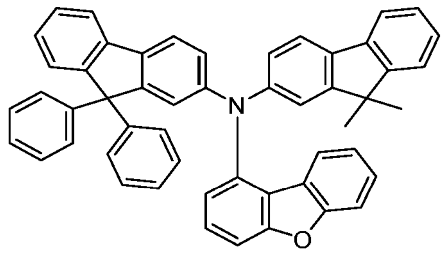 (F4),

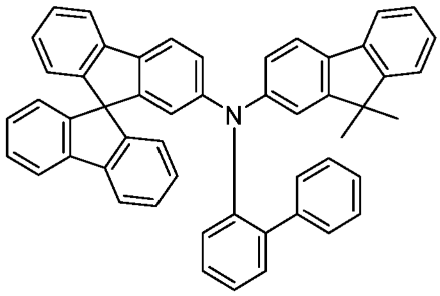 (F5), 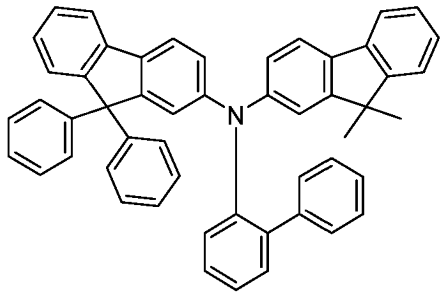 (F6),

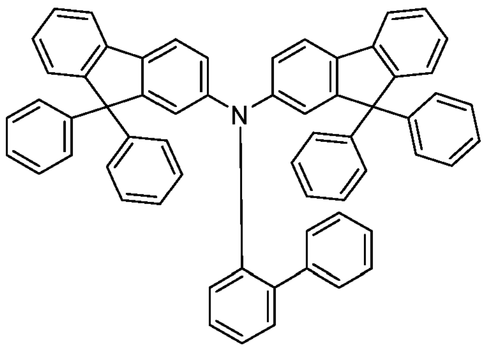 (F7), 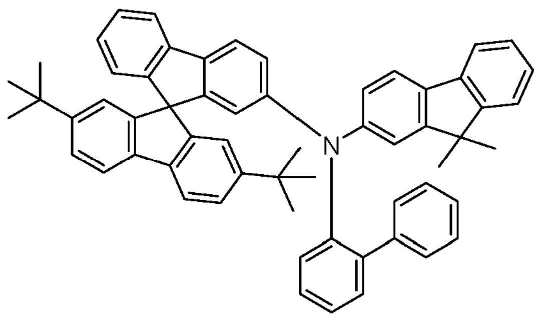 (F8),

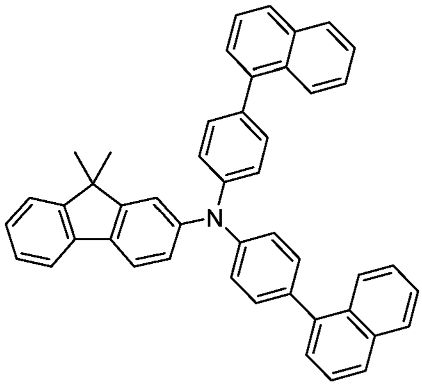 (F9), 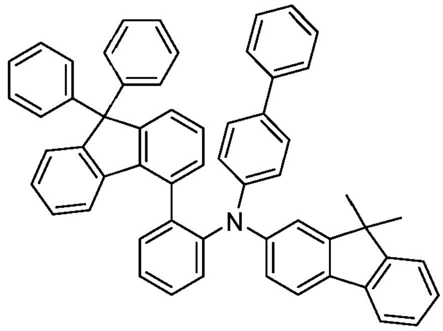 (F10),

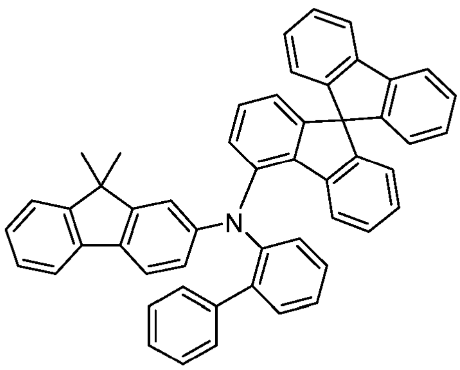 (F11), 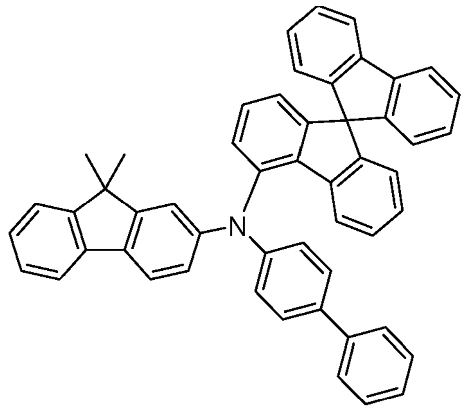 (F12),

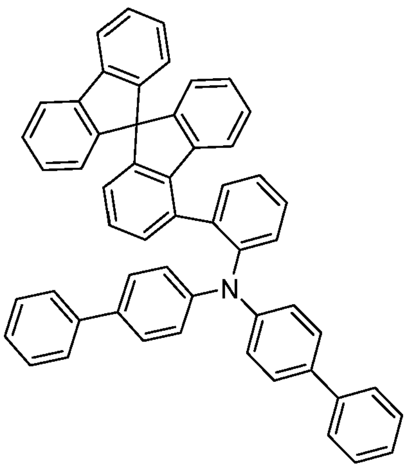 (F13), 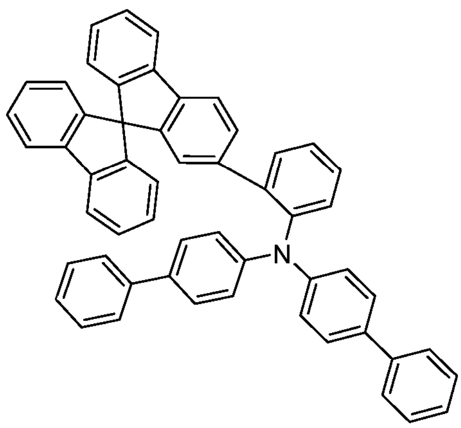 (F14),

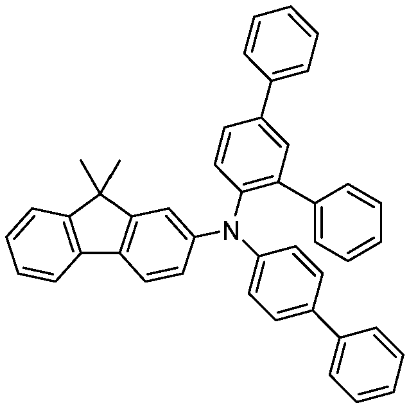
(F15),

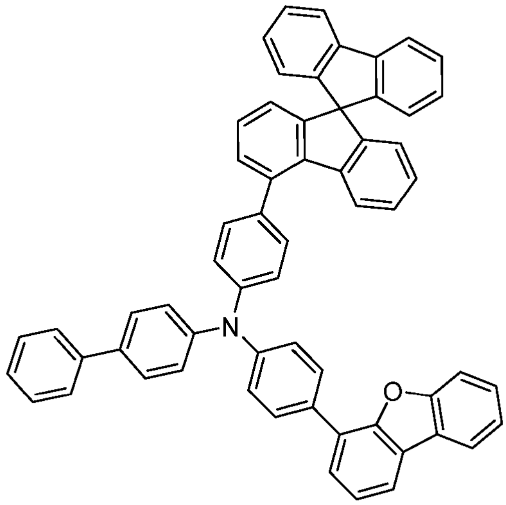
(F16),

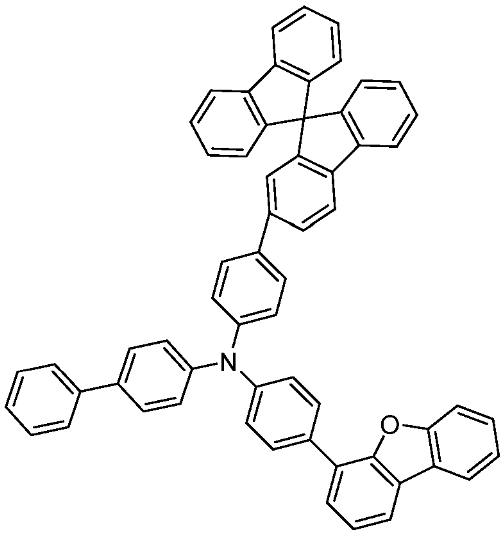
(F17)

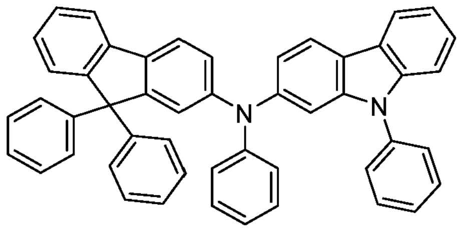
(F18).

**14.** A display device comprising an organic electroluminescent device according to any of the claims 1 to 13.

**15.** A method for preparation of an organic electroluminescent device, preferably an organic electroluminescent device according to any of the claims 1 to 13, comprising the steps of:

- forming a n-type charge generation layer by depositing a matrix compound and depositing a metal dopant;
- forming an intermediate layer by depositing a hole transport compound consisting essentially of at least one compound selected from arylamine, diarylamine, triarylamine, (IIa), and formula (IIb)
- forming a p-type charge generation layer by depositing a hole transport matrix compound consisting essentially of at least one compound selected from arylamine, diarylamine, triarylamine, formula(IIa) and formula (IIb) and depositing a radialene of formula (I).

**Patentansprüche**

**1.** Organische Elektrolumineszenzvorrichtung, umfassend eine Anodenschicht (120), eine Kathodenschicht (190),

eine erste lichtemittierende Einheit (140), eine zweite lichtemittierende Einheit (240) und mindestens einen Zwischenverbindungsbereich (150),
wobei der mindestens eine Zwischenverbindungsbereich zwischen der ersten und der zweiten lichtemittierenden Einheit angeordnet ist,

wobei die erste lichtemittierende Einheit eine erste Emissionsschicht (143) umfasst,
wobei die zweite lichtemittierende Einheit eine zweite Emissionsschicht (243) umfasst,
wobei der mindestens eine Zwischenverbindungsbereich eine Ladungserzeugungsschicht vom n-Typ (151), eine Zwischenschicht (153) und eine Ladungserzeugungsschicht vom p-Typ (152) umfasst,
wobei die Ladungserzeugungsschicht vom n-Typ näher an der Anodenschicht angeordnet ist als die Ladungserzeugungsschicht vom p-Typ;
wobei die Ladungserzeugungsschicht vom p-Typ näher an der Kathodenschicht angeordnet ist als die Ladungserzeugungsschicht vom n-Typ; und
wobei die Zwischenschicht zwischen der Ladungserzeugungsschicht vom n-Typ und der Ladungserzeugungsschicht vom p-Typ angeordnet ist,
wobei
wobei die Ladungserzeugungsschicht vom n-Typ eine Matrixverbindung und einen Metalldotierstoff umfasst,
wobei die Ladungserzeugungsschicht vom p-Typ eine Lochtransportmatrixverbindung und ein Radialen der Formel (I) umfasst,

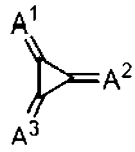

(I),

wobei in Formel (I)

- $A^1$ unabhängig aus einer Gruppe der Formel (Ia) ausgewählt ist:

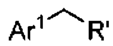

(Ia)

wobei $Ar^1$ unabhängig aus substituiertem oder unsubstituiertem Aryl und substituiertem oder unsubstituiertem Heteroaryl ausgewählt ist,
wobei für den Fall, dass $Ar^1$ substituiert ist, einer oder mehrere der Substituenten unabhängig aus der Gruppe bestehend aus D, einer elektronenziehenden Gruppe, Halogen, Cl, F, CN, $-NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind und
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

- $A^2$ unabhängig aus einer Gruppe der Formel (Ib) ausgewählt ist:

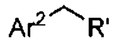

(Ib),

wobei $Ar^2$ unabhängig aus substituiertem oder unsubstituiertem Aryl und substituiertem oder unsubstituiertem Heteroaryl ausgewählt ist,
wobei für den Fall, dass $Ar^2$ substituiert ist, einer oder mehrere der Substituenten unabhängig aus der Gruppe bestehend aus D, einer elektronenziehenden Gruppe, Halogen, Cl, F, CN, $-NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind und

wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;

- $A^3$ unabhängig aus einer Gruppe der Formel (Ic) ausgewählt ist:

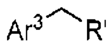

(Ic),

wobei $Ar^3$ unabhängig aus substituiertem oder unsubstituiertem Aryl und substituiertem oder unsubstituiertem Heteroaryl ausgewählt ist,
wobei für den Fall, dass $Ar^3$ substituiert ist, einer oder mehrere der Substituenten unabhängig aus der Gruppe bestehend aus D, einer elektronenziehenden Gruppe, Halogen, Cl, F, CN, $-NO_2$, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, substituiertem oder unsubstituiertem $C_1$- bis $C_8$-Alkoxy, teilfluoriertem $C_1$- bis $C_8$-Alkoxy, perfluoriertem $C_1$- bis $C_8$-Alkoxy, substituiertem oder unsubstituiertem $C_6$- bis $C_{30}$-Aryl und substituiertem oder unsubstituiertem $C_6$- bis $C_{30}$-Heteroaryl ausgewählt sind und
wobei der eine oder die mehreren Substituenten von $C_6$-bis $C_{30}$-Aryl, $C_6$- bis $C_{30}$-Heteroaryl, $C_1$- bis $C_8$-Alkyl, $C_1$- bis $C_8$-Alkoxy unabhängig aus D, einer elektronenziehenden Gruppe, Halogen, Cl, F, CN, $-NO_2$, teilfluoriertem $C_1$- bis $C_8$-Alkyl, perfluoriertem $C_1$- bis $C_8$-Alkyl, teilfluoriertem $C_1$- bis $C_8$-Alkoxy, perfluoriertem $C_1$- bis $C_8$-Alkoxy ausgewählt sind;
und wobei in $A^1$, $A^2$, $A^3$ jedes R' unabhängig aus substituiertem oder unsubstituiertem $C_6$- bis $C_{18}$-Aryl, $C_3$-bis $C_{18}$-Heteroaryl, einer elektronenziehenden Gruppe, substituiertem oder unsubstituiertem $C_1$- bis $C_8$-Alkyl, teilfluoriertem $C_1$- bis $C_8$-Alkyl, perfluoriertem $C_1$- bis $C_8$-Alkyl, Halogen, F und CN ausgewählt ist;
wobei die Zwischenschicht mindestens eine Lochtransportverbindung umfasst, die aus einer Arylaminverbindung, Diarylaminverbindung, Triarylaminverbindung, einer Verbindung der Formel (IIa) oder einer Verbindung der Formel (IIb) ausgewählt ist:

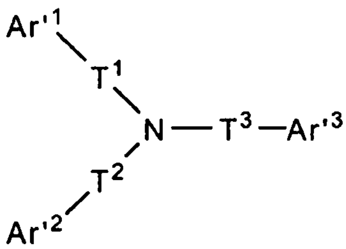

(IIa),

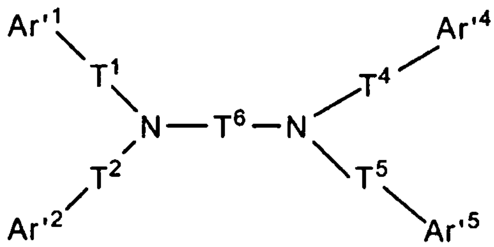

(IIb),

wobei:

$T^1$, $T^2$, $T^3$, $T^4$ und $T^5$ unabhängig aus einer Einfachbindung, Phenylen, Biphenylen, Terphenylen oder Naphthenylen, vorzugsweise einer Einfachbindung oder Phenylen, ausgewählt sind;
$T^6$ für Phenylen, Biphenylen, Terphenylen oder Naphthenylen steht;
$Ar'^1$, $Ar'^2$, $Ar'^3$, $A'^{,4}$ und $Ar'^5$ unabhängig aus substituiertem oder unsubstituiertem $C_6$- bis $C_{20}$-Aryl oder substituiertem oder unsubstituiertem $C_3$- bis $C_{20}$-Heteroarylen, substituiertem oder unsubstituiertem Biphenylen, substituiertem oder unsubstituiertem Fluoren, substituiertem 9-Fluoren, substituiertem 9,9-Fluoren, substituiertem oder unsubstituiertem Naphthalin, substituiertem oder unsubstituiertem Anthracen, substituiertem oder unsubstituiertem Phenanthren, substituiertem oder unsubstituiertem Pyren, substituiertem oder unsubstituiertem Perylen, substituiertem oder unsubstituiertem Triphenylen, substituiertem oder unsubstituiertem Tetracen, substituiertem oder unsubstituiertem Tetraphen, substituiertem oder unsubstituiertem Dibenzofuran, substituiertem oder unsubstituiertem Dibenzothiophen, substituiertem oder unsubstituiertem Xanthen, substituiertem oder unsubstituiertem Carbazol, substituiertem 9-Phenylcarbazol, substituiertem oder unsubstituiertem Azepin, substituiertem oder unsubstituiertem Dibenzo[b,f]azepin, substituiertem oder unsubstituiertem 9,9'-Spirobi[fluoren], substituiertem oder unsubstituiertem Spiro[fluoren-9,9'-xanthen] oder einem substituierten oder unsubstituierten aromatischen anellierten Ringsystem mit mindestens drei substituierten oder unsubstituierten aromatischen Ringen, die aus der Gruppe umfassend

substituierte oder unsubstituierte Nichthetero-, substituierte oder unsubstituierte 5-gliedrige Heteroringe, substituierte oder unsubstituierte 6-gliedrige Ringe und/oder substituierte oder unsubstituierte 7-gliedrige Ringe ausgewählt sind, substituiertem oder unsubstituiertem Fluoren oder einem anellierten Ringsystem mit 2 bis 6 substituierten oder unsubstituierten 5- bis 7-gliedrigen Ringen, wobei die Ringe aus der Gruppe umfassend (i) einen ungesättigten 5- bis 7-gliedrigen Ring eines Heterocyclus, (ii) einen 5- bis 6-gliedrigen Ring eines aromatischen Heterocyclus, (iii) einen ungesättigten 5-bis 7-gliedrigen Ring eines Nichtheterocyclus, (iv) einen 6-gliedrigen Ring eines aromatischen Nichtheterocyclus ausgewählt sind, ausgewählt sind;

wobei

die Substituenten von $Ar'^1$, $Ar'^2$, $Ar'^3$, $Ar'^4$ und $Ar'^5$ gleich oder verschieden aus der Gruppe umfassend H, D, F, $C(=O)R'^2$, CN, $Si(R'^2)_3$, $P(=O)(R'^2)_2$, $OR'^2$, $S(=O)R'^2$, $S(=O)_2R'^2$, substituiertes oder unsubstituiertes geradkettiges Alkyl mit 1 bis 20 Kohlenstoffatomen, substituiertes oder unsubstituiertes verzweigtes Alkyl mit 1 bis 20 Kohlenstoffatomen, substituiertes oder unsubstituiertes cyclisches Alkyl mit 3 bis 20 Kohlenstoffatomen, substituierte oder unsubstituierte Alkenyl- oder Alkinylgruppen mit 2 bis 20 Kohlenstoffatomen, substituierte oder unsubstituierte Alkoxygruppen mit 1 bis 20 Kohlenstoffatomen, substituierte oder unsubstituierte aromatische Ringsysteme mit 6 bis 40 aromatischen Ringatomen und substituierte oder unsubstituierte heteroaromatische Ringsysteme mit 5 bis 40 aromatischen Ringatomen, unsubstituiertes $C_6$- bis $C_{18}$-Aryl, unsubstituiertes $C_3$-bis $C_{18}$-Heteroaryl, ein anelliertes Ringsystem mit 2 bis 6 unsubstituierten 5- bis 7-gliedrigen Ringen, wobei die Ringe aus der Gruppe umfassend einen ungesättigten 5- bis 7-gliedrigen Ring eines Heterocyclus, einen 5- bis 6-gliedrigen Ring eines aromatischen Heterocyclus, einen ungesättigten 5- bis 7-gliedrigen Ring eines Nichtheterocyclus und einen 6-gliedrigen Ring eines aromatischen Nichtheterocyclus ausgewählt sind, ausgewählt sind,

wobei $R'^2$ aus H, D, geradkettigem Alkyl mit 1 bis 6 Kohlenstoffatomen, verzweigtem Alkyl mit 1 bis 6 Kohlenstoffatomen, cyclischem Alkyl mit 3 bis 6 Kohlenstoffatomen, Alkenyl- oder Alkinylgruppen mit 2 bis 6 Kohlenstoffatomen, $C_6$- bis $C_{18}$-Aryl oder $C_3$- bis $C_{18}$-Heteroaryl ausgewählt sein kann.

**2.** Organische Elektrolumineszenzvorrichtung nach Anspruch 1, wobei die Zwischenschicht im Wesentlichen aus einer oder mehreren der Lochtransportverbindungen besteht.

**3.** Organische Elektrolumineszenzvorrichtung nach Anspruch 1 oder 2, wobei die Zwischenschicht eine Schichtdicke von ≤20 nm aufweist.

**4.** Organische Elektrolumineszenzvorrichtung nach einem der Ansprüche 1 oder 3, wobei die Ladungserzeugungsschicht vom p-Typ in direktem Kontakt mit der Zwischenschicht steht.

**5.** Organische Elektrolumineszenzvorrichtung nach einem der Ansprüche 1 bis 4, wobei die Ladungserzeugungsschicht vom n-Typ in direktem Kontakt mit der Zwischenschicht steht.

**6.** Organische Elektrolumineszenzvorrichtung nach einem der Ansprüche 1 bis 5, wobei die Lochtransportverbindung der Zwischenschicht ein unter Verwendung von TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase berechnetes HOMO-Energieniveau aufweist und die Lochtransportmatrixverbindung der Ladungserzeugungsschicht vom p-Typ ein unter Verwendung von TURBOMOLE V6.5 (TURBOMOLE GmbH, Litzenhardtstraße 19, 76135 Karlsruhe, Deutschland) durch Anwenden des Hybridfunktionals B3LYP mit einem 6-31G*-Basissatz in der Gasphase berechnetes HOMO-Energieniveau aufweist und wobei der Absolutwert der Differenz zwischen dem HOMO-Energieniveau der Lochtransportverbindung der Zwischenschicht und dem HOMO-Energieniveau der Lochtransportmatrixverbindung der Ladungserzeugungsschicht vom p-Typ ≤0,5 eV, vorzugsweise ≤0,4 eV, weiter bevorzugt ≤0,3 eV, noch weiter bevorzugt ≤0,2 eV, noch weiter bevorzugt ≤0,1 eV und ganz besonders bevorzugt 0 eV beträgt.

**7.** Organische Elektrolumineszenzvorrichtung nach einem der Ansprüche 1 bis 6, wobei die mindestens eine Lochtransportverbindung der Zwischenschicht und die mindestens eine Lochtransportmatrixverbindung der Ladungserzeugungsschicht vom p-Typ gleich gewählt sind.

**8.** Organische Elektrolumineszenzvorrichtung nach einem der Ansprüche 1 bis 7, wobei das Verhältnis der Schichtdicke zwischen der Zwischenschicht und der Ladungserzeugungsschicht vom p-Typ im Bereich von ≥0,01 bis ≤10,0 liegt.

**9.** Organische Elektrolumineszenzvorrichtung nach einem der Ansprüche 1 bis 8, wobei das Verhältnis der Schichtdicke

zwischen der Zwischenschicht und der Ladungserzeugungsschicht vom n-Typ im Bereich von ≥0,01 bis ≤10,0 liegt.

**10.** Organische Elektrolumineszenzvorrichtung nach einem der Ansprüche 1 bis 9, wobei in Formel (I) $Ar^1$, $Ar^2$ und/oder $Ar^3$ unabhängig aus einer der folgenden Gruppen ausgewählt sind und vorzugsweise R' jeweils aus CN ausgewählt ist:

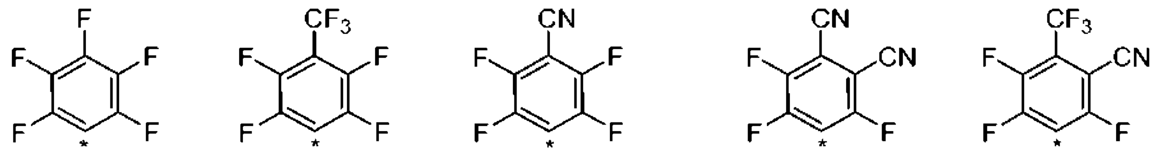

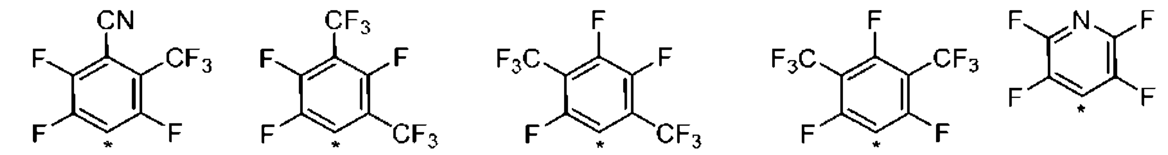

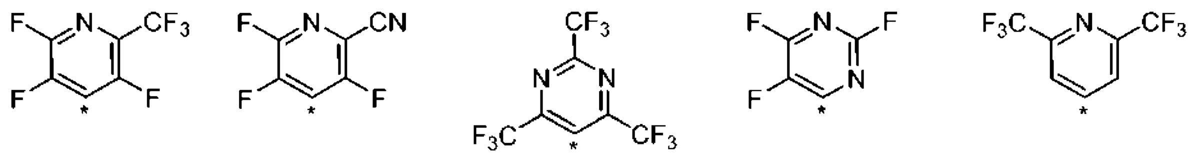

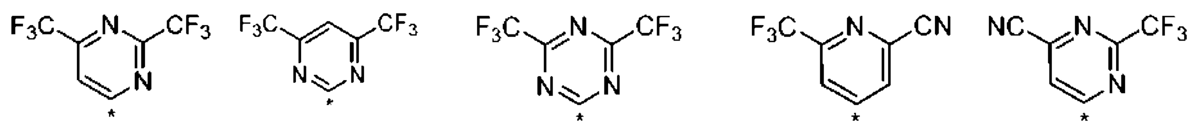

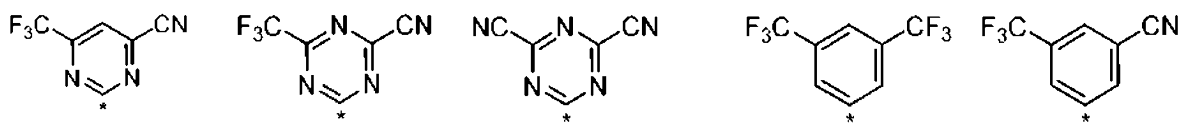

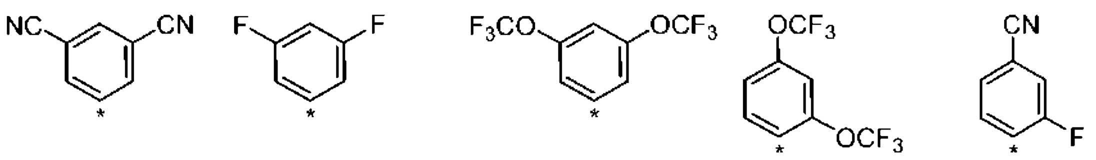

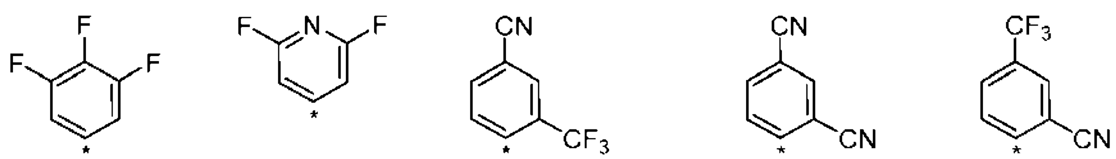

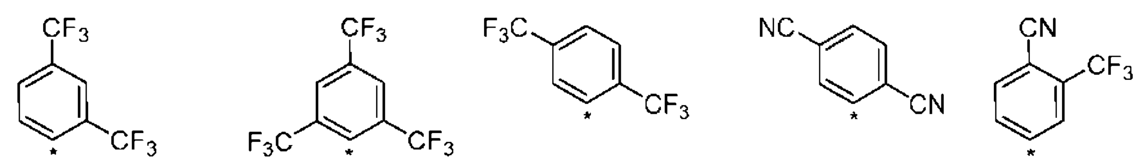

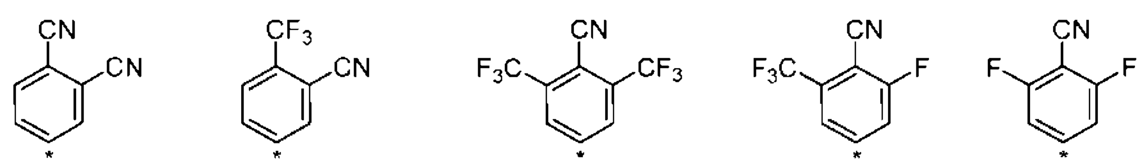

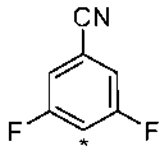 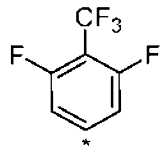 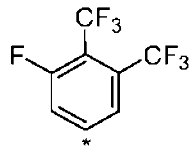 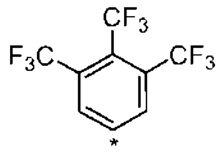 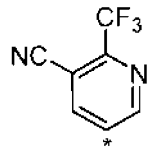

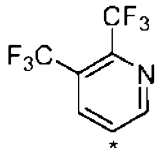 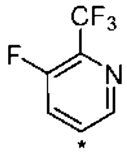 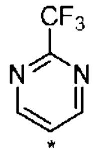 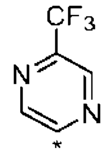 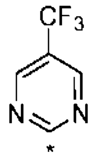

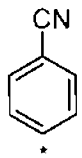 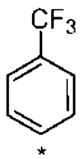 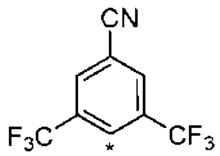 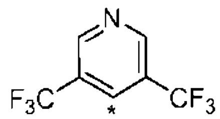 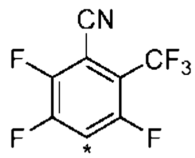

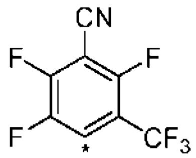 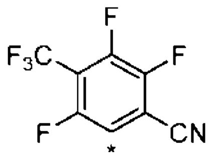 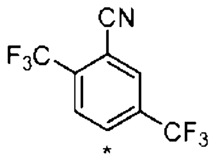

wobei das Sternchen "*" die Bindungsposition bezeichnet.

**11.** Organische Elektrolumineszenzvorrichtung nach einem der Ansprüche 1 bis 10, wobei die mindestens eine Lochtransportverbindung im Wesentlichen aus mindestens einer Verbindung, die aus Formel (IIa) und Formel (IIb) ausgewählt ist, besteht, vorzugsweise mindestens eine Lochtransportverbindung im Wesentlichen aus mindestens einer Verbindung, die aus Formel (IIa) ausgewählt ist, besteht.

**12.** Organische Elektrolumineszenzvorrichtung nach einem der Ansprüche 1 bis 11, wobei in den Formeln (IIa) und/oder (IIb) - wo immer zutreffend - $Ar'^1$, $Ar'^2$, $Ar'^3$, $Ar'^4$ und/oder $Ar'^5$ unabhängig aus D1 bis D16 ausgewählt sind:

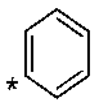 (D1), 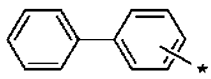 (D2), 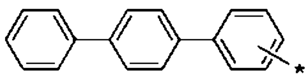 (D3), 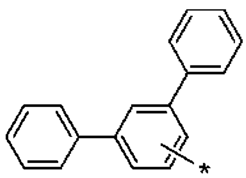 (D4),

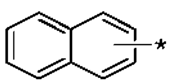 (D5), 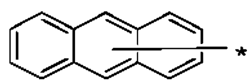 (D6), 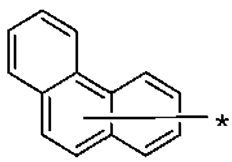 (D7),

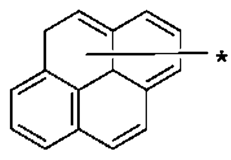 (D8),

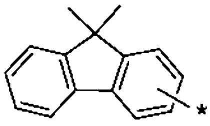 (D9), 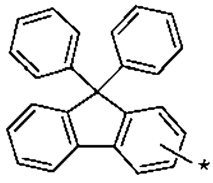 (D10), 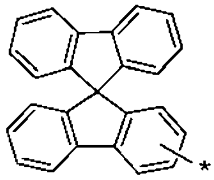 (D11),

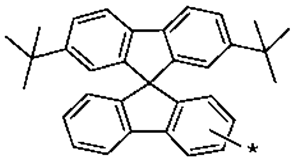 (D12), 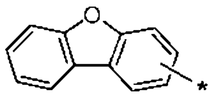 (D13), 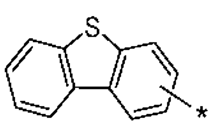 (D14),

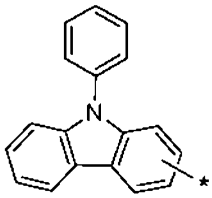 (D15), 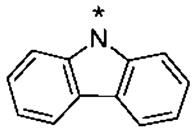 (D16),

wobei das Sternchen "*" die Bindungsposition bezeichnet.

**13.** Organische Elektrolumineszenzvorrichtung nach einem der Ansprüche 1 bis 12, wobei die mindestens eine Lochtransportverbindung und/oder die Formeln (IIa) und/oder (IIb) - wo immer zutreffend - aus F1 bis F18 ausgewählt sind:

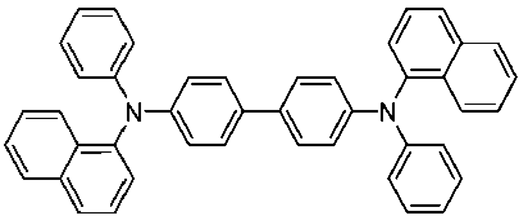 (F1), 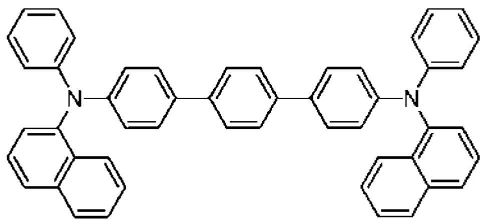 (F2),

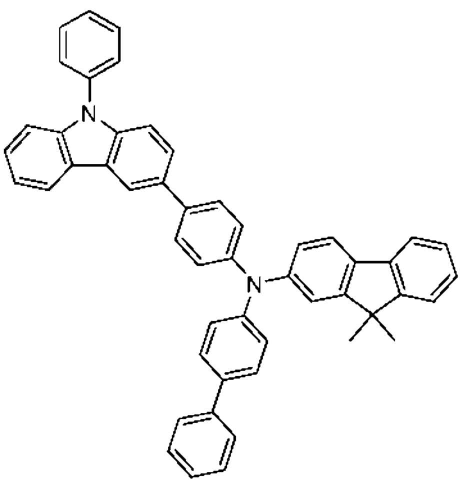 (F3), 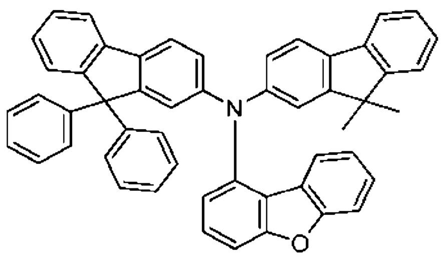 (F4),

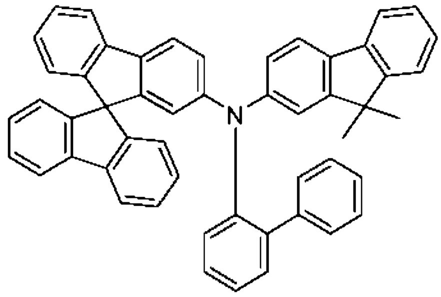 (F5),

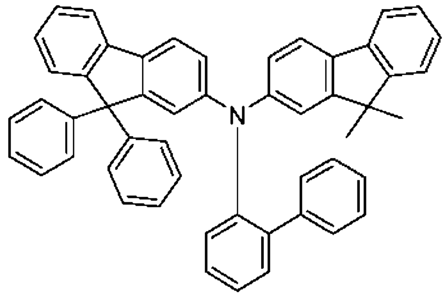 (F6),

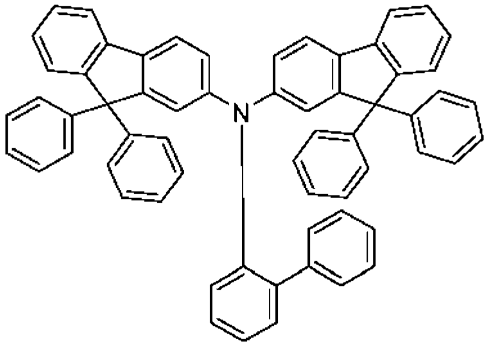 (F7),

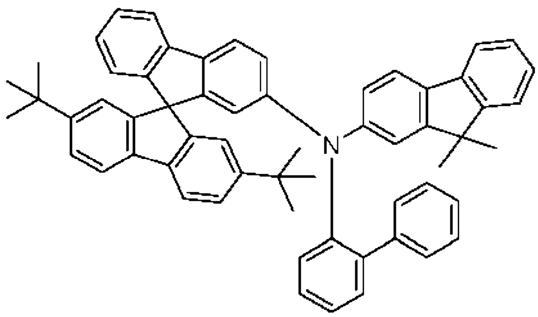 (F8),

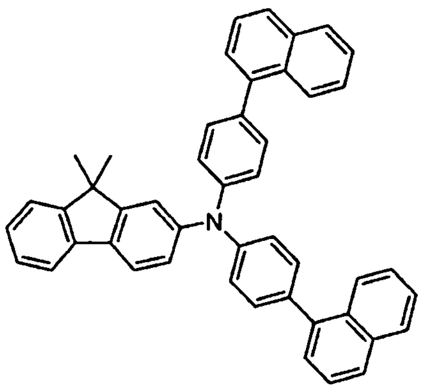 (F9),

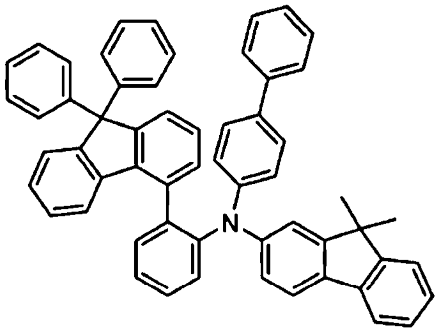 (F10),

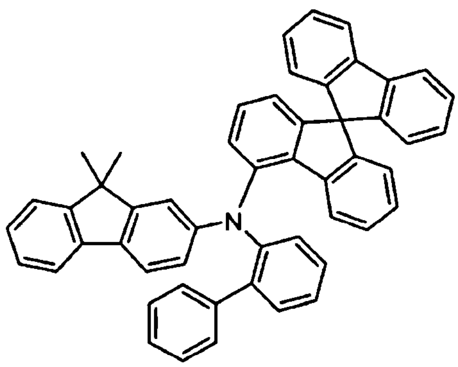 (F11),

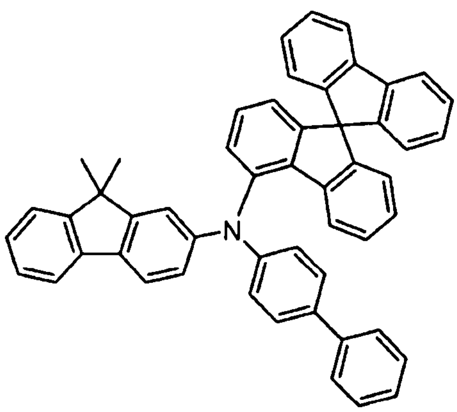 (F12),

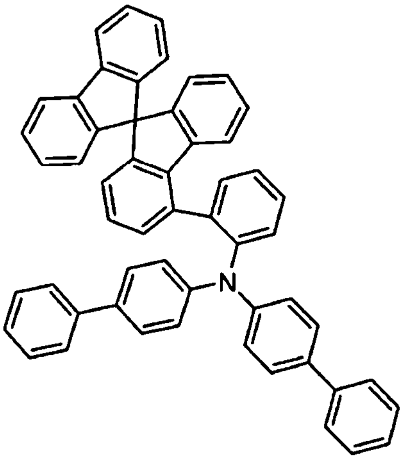 (F13), 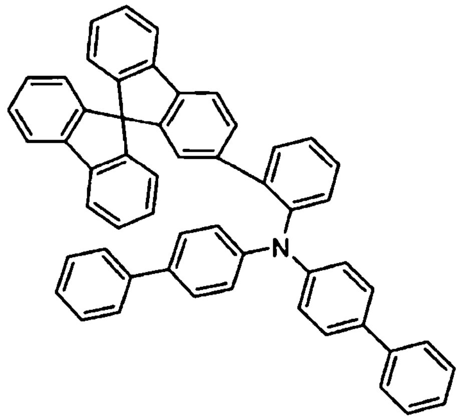 (F14),

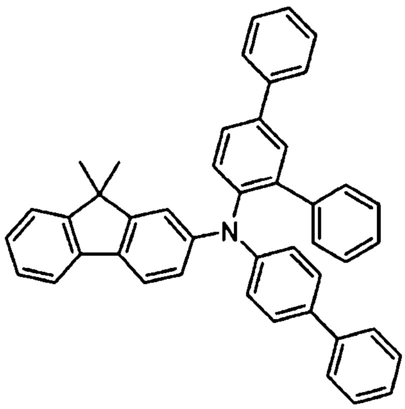 (F15), 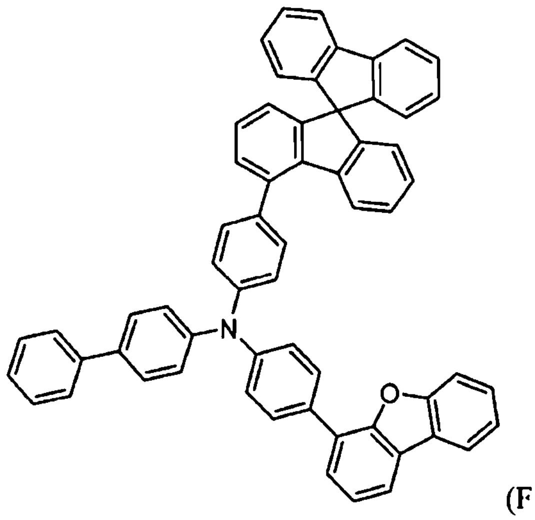 (F16),

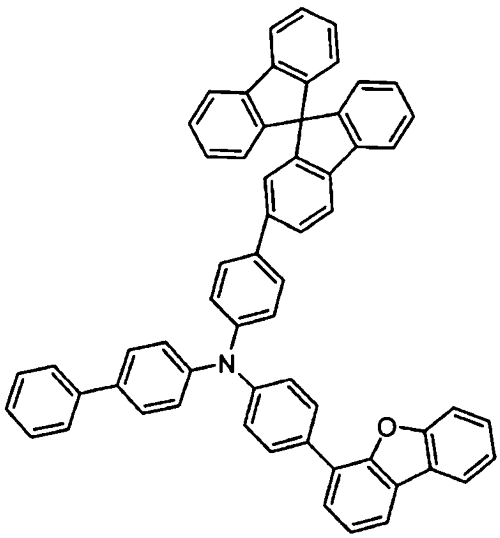 (F17) 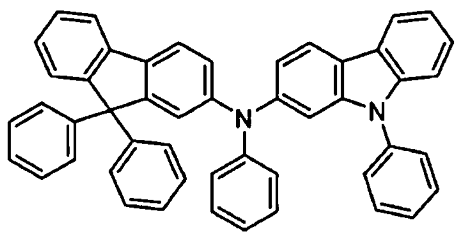 (F18).

**14.** Anzeigevorrichtung, umfassend eine organische Elektrolumineszenzvorrichtung nach einem der Ansprüche 1 bis 13.

**15.** Verfahren zur Herstellung einer organischen Elektrolumineszenzvorrichtung, vorzugsweise einer organischen Elektrolumineszenzvorrichtung nach einem der Ansprüche 1 bis 13, umfassend die Schritte:

- Bilden einer Ladungserzeugungsschicht vom n-Typ durch Abscheiden einer Matrixverbindung und Abscheiden eines Metalldotierstoffs;
- Bilden einer Zwischenschicht durch Abscheiden einer Lochtransportverbindung, die im Wesentlichen aus mindestens einer Verbindung, die aus Arylamin, Diarylamin, Triarylamin, (IIa) und Formel (IIb) ausgewählt ist, besteht;
- Bilden einer Ladungserzeugungsschicht vom p-Typ durch Abscheiden einer Lochtransportmatrixverbindung, die im Wesentlichen aus mindestens einer Verbindung, die aus Arylamin, Diarylamin, Triarylamin, Formel (IIa) und Formel (IIb) ausgewählt ist, besteht, und Abscheiden eines Radialens der Formel (I).

## Revendications

**1.** Dispositif électroluminescent organique comprenant une couche d'anode (120), une couche de cathode (190), une première unité émettrice de lumière (140), une deuxième unité émettrice de lumière (240), et au moins une zone de connexion intermédiaire (150),

dans lequel l'au moins une zone de connexion intermédiaire est agencée entre la première et la deuxième unité émettrice de lumière,
dans lequel la première unité émettrice de lumière comprend une première couche d'émission (143),
dans lequel la deuxième unité émettrice de lumière comprend une deuxième couche d'émission (243),
dans lequel l'au moins une zone de connexion intermédiaire comprend une couche de génération de charge de type n (151), une couche intermédiaire (153), et une couche de génération de charge de type p (152),
dans lequel la couche de génération de charge de type n est agencée plus proche de la couche d'anode que la couche de génération de charge de type p ;
dans lequel la couche de génération de charge de type p est agencée plus proche de la couche de cathode que la couche de génération de charge de type n ; et
dans lequel la couche intermédiaire est agencée entre la couche de génération de charge de type n et la couche de génération de charge de type p,
moyennant quoi
la couche de génération de charge de type n comprenant un composé de matrice et un dopant métallique,
la couche de génération de charge de type p comprenant un composé de matrice de transport de trous et un radialène de formule (I),

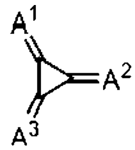

(I),

dans la formule (I)

- $A^1$ étant indépendamment choisi parmi un groupe de formule (Ia)

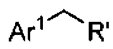

(Ia)

$Ar^1$ étant indépendamment choisi parmi aryle substitué ou non substitué et hétéroaryle substitué ou non substitué, dans le cas où $Ar^1$ est substitué, un ou plusieurs des substituants étant indépendamment choisis dans le groupe constitué par D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;

- $A^2$ étant indépendamment choisi parmi un groupe de formule (Ib)

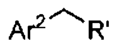

(Ib),

$Ar^2$ étant indépendamment choisi parmi aryle substitué ou non substitué et hétéroaryle substitué ou non substitué, dans le cas où $Ar^2$ est substitué, un ou plusieurs des substituants étant indépendamment choisis dans le groupe constitué par D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;

- $A^3$ étant indépendamment choisi parmi un groupe de formule (Ic)

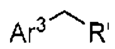

(Ic),

$Ar^3$ étant indépendamment choisi parmi aryle substitué ou non substitué et hétéroaryle substitué ou non substitué, dans le cas où $Ar^3$ est substitué, un ou plusieurs des substituants étant indépendamment choisis dans le groupe constitué par D, un groupe électroattracteur, halogène, Cl, F, CN, $-NO_2$, $C_1$ à $C_8$ alkyle substitué ou non substitué, $C_1$ à $C_8$ alkyle partiellement fluoré, $C_1$ à $C_8$ alkyle perfluoré, $C_1$ à $C_8$ alcoxy substitué ou non substitué, $C_1$ à $C_8$ alcoxy partiellement fluoré, $C_1$ à $C_8$ alcoxy perfluoré, $C_6$ à $C_{30}$ aryle substitué ou non substitué, et $C_6$ à $C_{30}$ hétéroaryle substitué ou non substitué et ;
le ou les substituants de $C_6$ à $C_{30}$ aryle, $C_6$ à $C_{30}$ hétéroaryle, $C_1$ à $C_8$ alkyle, $C_1$ à $C_8$ alcoxy étant indépendamment choisis parmi D, un groupe électroattracteur, halogène, Cl, F, CN, $-NO_2$, $C_1$ à $C_8$ alkyle partiellement fluoré, $C_1$ à $C_8$ alkyle perfluoré, $C_1$ à $C_8$ alcoxy partiellement fluoré, $C_1$ à $C_8$ alcoxy perfluoré ;
et dans $A^1$, $A^2$, $A^3$, chaque R' étant indépendamment choisi parmi $C_6$ à $C_{18}$ aryle substitué ou non substitué, $C_3$ à $C_{18}$ hétéroaryle, un groupe électroattracteur, $C_1$ à $C_8$ alkyle substitué ou non substitué, $C_1$ à $C_8$ alkyle partiellement fluoré, $C_1$ à $C_8$ alkyle perfluoré, halogène, F et CN ;
la couche intermédiaire comprenant au moins un composé de transport de trous choisi parmi un composé arylamine, un composé diarylamine, un composé triarylamine, un composé de formule (IIa) ou un composé de formule (IIb) :

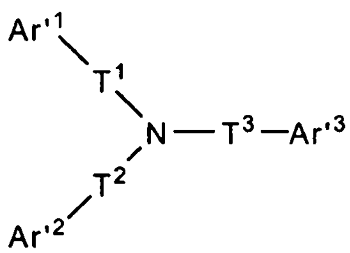

(IIa),

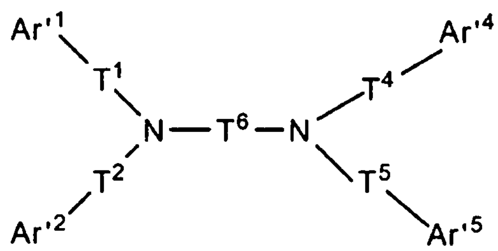

(IIb),

$T^1$, $T^2$, $T^3$, $T^4$ et $T^5$ étant choisis indépendamment parmi une simple liaison, phénylène, biphénylène, terphénylène ou naphténylène, de préférence une liaison simple ou phénylène ;
$T^6$ étant phénylène, biphénylène, terphénylène ou naphténylène ;
$Ar'^1$, $Ar'^2$, $Ar'^3$, $Ar'^4$ et $Ar'^5$ étant indépendamment choisis parmi $C_6$ à $C_{20}$ aryle substitué ou non substitué, ou $C_3$ à $C_{20}$ hétéroarylène substitué ou non substitué, biphénylène substitué ou non substitué, fluorène substitué ou non substitué, 9-fluorène substitué, 9,9-fluorène substitué, naphtalène substitué ou non substitué, anthracène substitué ou non substitué, phénanthrène substitué ou non substitué, pyrène substitué ou non substitué, pérylène substitué ou non substitué, triphénylène substitué ou non substitué, tétracène substitué ou non substitué, tétraphène substitué ou non substitué, dibenzofurane substitué ou non substitué, dibenzothiophène

substitué ou non substitué, xanthène substitué ou non substitué, carbazole substitué ou non substitué, 9-phénylcarbazole substitué, azépine substituée ou non substituée, dibenzo[b,f]azépine substituée ou non substituée, 9,9'-spirobi[fluorène] substitué ou non substitué, spiro[fluorène-9,9'-xanthène] substitué ou non substitué, ou un système cyclique condensé aromatique substitué ou non substitué comprenant au moins trois cycles aromatiques substitués ou non substitués choisis dans le groupe comprenant un non hétéro substitué ou non substitué, des cycles à 5 chaînons hétéro substitués ou non substitués, des cycles à 6 chaînons substitués ou non substitués et/ou des cycles à 7 chaînons substitués ou non substitués, fluorène substitué ou non substitué, ou un système cyclique condensé comprenant 2 à 6 cycles à 5 à 7 chaînons substitués ou non substitués, les cycles étant choisis parmi le groupe comprenant (i) un cycle insaturé à 5 à 7 chaînons d'un hétérocycle, (ii) un cycle à 5 ou 6 chaînons d'un hétérocycle aromatique, (iii) un cycle insaturé à 5 ou 7 chaînons d'un non-hétérocycle, (iv) un cycle à 6 chaînons d'un non-hétérocycle aromatique ;

les substituants de $Ar'^1$, $Ar'^2$, $Ar'^3$, $Ar'^4$ et $Ar'^5$ étant choisis identiques ou différents dans le groupe comprenant H, D, F, C (=O) $R'^2$, CN, Si $(R'^2)_3$, $P(=O)(R'^2)_2$, $OR'^2$, $S(=O)R'^2$, $S(=O)_2R'^2$, alkyle linéaire substitué ou non substitué ayant 1 à 20 atomes de carbone, alkyle ramifié substitué ou non substitué ayant 1 à 20 atomes de carbone, alkyle cyclique substitué ou non substitué ayant 3 à 20 atomes de carbone, groupes alcényle ou alcynyle substitués ou non substitués ayant 2 à 20 atomes de carbone, groupes alcoxy substitués ou non substitués ayant 1 à 20 atomes de carbone, systèmes cycliques aromatiques substitués ou non substitués ayant 6 à 40 atomes cycliques aromatiques, et systèmes cycliques hétéroaromatiques substitués ou non substitués ayant 5 à 40 atomes cycliques aromatiques, $C_6$ à $C_{18}$ aryle non substitué, $C_3$ à $C_{18}$ hétéroaryle non substitué, un système cyclique condensé comprenant 2 à 6 cycles non substitués à 5 à 7 chaînons et les cycles étant choisis dans le groupe comprenant un cycle insaturé à 5 à 7 chaînons d'un hétérocycle, à 5 à 6 chaînons d'un hétérocycle aromatique, un cycle insaturé à 5 à 7 chaînons d'un non hétérocycle, et un cycle à 6 chaînons d'un non hétérocycle aromatique, $R'^2$ pouvant être choisi parmi H, D, alkyle linéaire ayant 1 à 6 atomes de carbone, alkyle ramifié ayant 1 à 6 atomes de carbone, alkyle cyclique ayant 3 à 6 atomes de carbone, groupes alcényle ou alcynyle ayant 2 à 6 atomes de carbone, $C_6$ à $C_{18}$ aryle ou $C_3$ à $C_{18}$ hétéroaryle.

**2.** Dispositif électroluminescent organique selon la revendication 1, dans lequel la couche intermédiaire est essentiellement constituée par un ou plusieurs des composés de transport de trous.

**3.** Dispositif électroluminescent organique selon la revendication 1 ou 2, dans lequel la couche intermédiaire a une épaisseur de couche de ≤ 20 nm.

**4.** Dispositif électroluminescent organique selon l'une quelconque des revendications 1 ou 3, dans lequel la couche de génération de charge de type p est en contact direct avec la couche intermédiaire.

**5.** Dispositif électroluminescent organique selon l'une quelconque des revendications 1 à 4, dans lequel la couche de génération de charge de type n est en contact direct avec la couche intermédiaire.

**6.** Dispositif électroluminescent organique selon l'une quelconque des revendications 1 à 5, dans lequel le composé de transport de trous de la couche intermédiaire a un niveau d'énergie HOMO calculé en utilisant TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse, et le composé de matrice de transport de trous de la couche de génération de charge de type p a un niveau d'énergie HOMO calculé en utilisant TURBOMOLE V6.5 (TURBOMOLE GmbH, Litzenhardtstrasse 19, 76135 Karlsruhe, Allemagne) en appliquant le B3LYP fonctionnel hybride avec un ensemble de base 6-31G* dans la phase gazeuse, et dans lequel la valeur absolue de la différence entre le niveau d'énergie HOMO du composé de transport de trous de la couche intermédiaire et le niveau d'énergie HOMO du composé de matrice de transport de trous de la couche de génération de charge de type p est ≤ 0,5 eV ; préférablement ≤ 0,4 eV, plus préférablement ≤ 0,3 eV, encore plus préférablement ≤ 0,2 eV, encore plus préférablement ≤ 0,1 eV, et le plus préférablement 0 eV.

**7.** Dispositif électroluminescent organique selon l'une quelconque des revendications 1 à 6, dans lequel l'au moins un composé de transport de trous de la couche intermédiaire et l'au moins un composé de matrice de transport de trous de la couche de génération de charge de type p sont choisis identiques.

**8.** Dispositif électroluminescent organique selon l'une quelconque des revendications 1 à 7, dans lequel le rapport de l'épaisseur de couche entre la couche intermédiaire et la couche de génération de charge de type p est dans la plage de ≥ 0,01 à ≤ 10,0.

**9.** Dispositif électroluminescent organique selon l'une quelconque des revendications 1 à 8, dans lequel le rapport de l'épaisseur de couche entre la couche intermédiaire et la couche de génération de charge de type n est dans la plage de ≥ 0,01 à ≤ 10,0.

**10.** Dispositif électroluminescent organique selon l'une quelconque des revendications 1 à 9, dans lequel, dans la formule (I), $Ar^1$, $Ar^2$ et/ou $Ar^3$ sont choisis indépendamment parmi l'un des groupes suivants et préférablement chaque R' est choisi parmi CN :

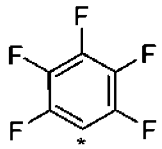 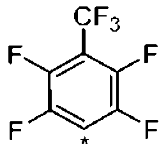 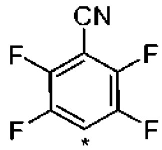 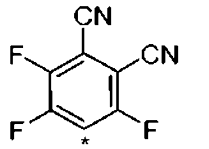 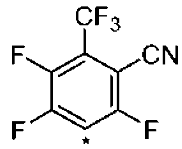

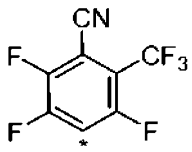 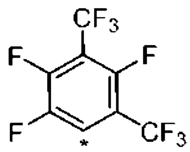 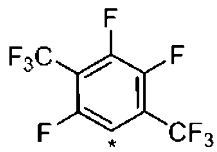 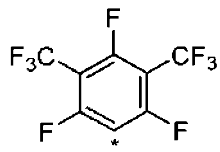 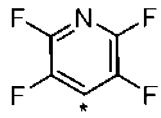

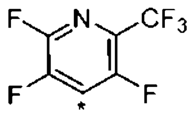 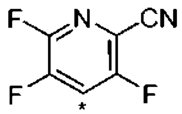 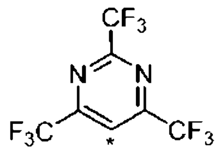 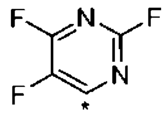 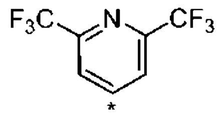

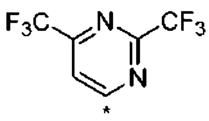 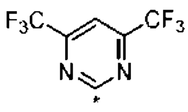 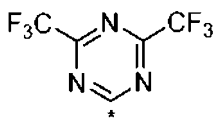 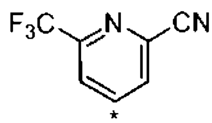 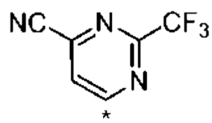

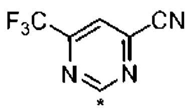 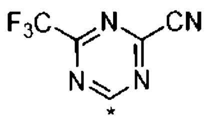 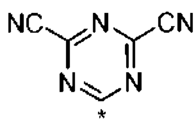 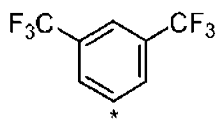 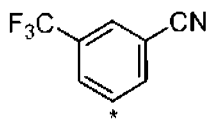

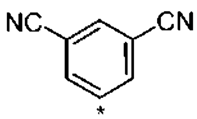 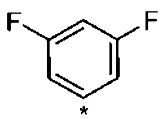 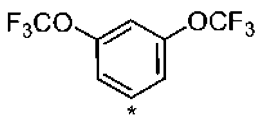 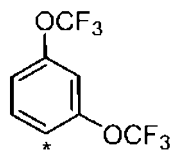 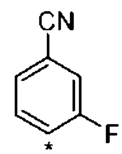

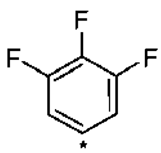 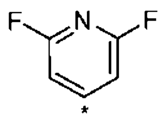 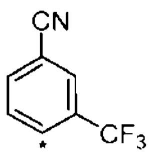 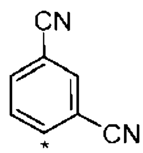 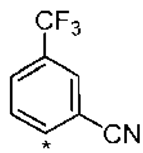

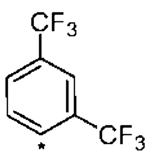 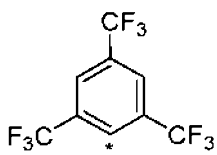 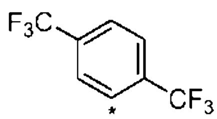 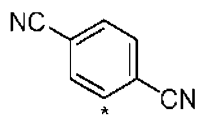 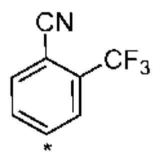

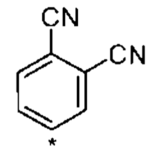 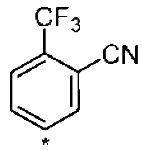 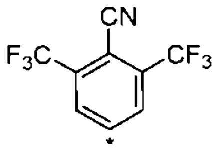 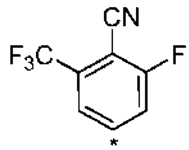 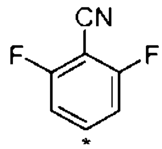

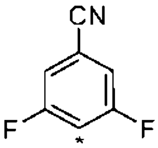 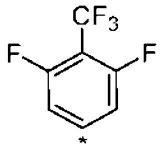 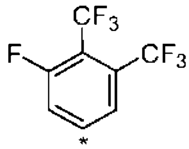 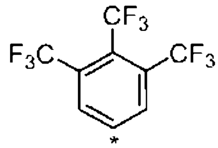 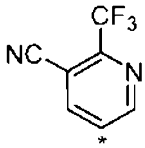

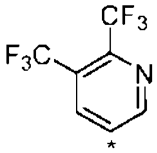 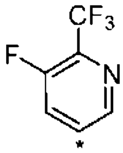 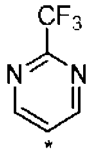 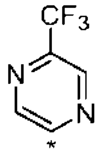 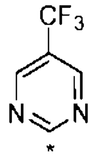

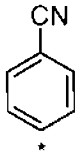 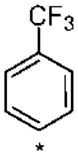 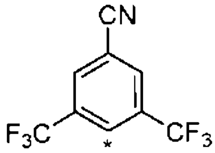 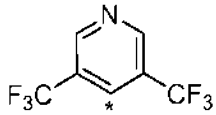 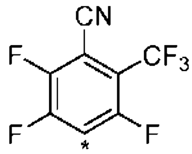

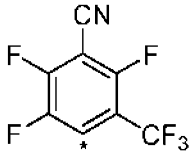 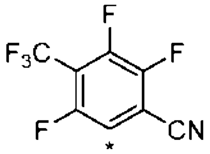 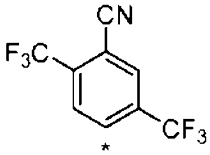

l'astérisque « * » désignant la position de liaison.

**11.** Dispositif électroluminescent organique selon l'une quelconque des revendications 1 à 10, dans lequel l'au moins un composé de transport de trous est constitué essentiellement par au moins un composé choisi parmi la formule (IIa) et la formule (IIb), de préférence au moins un composé de transport de trous est constitué essentiellement par au moins un composé choisi parmi la formule (IIa).

**12.** Dispositif électroluminescent organique selon l'une quelconque des revendications 1 à 11, dans lequel, dans les formules (IIa) et/ou (IIb) - le cas échéant - Ar'[1], Ar'[2], Ar'[3], Ar'[4] et/ou Ar'[5] sont indépendamment choisis parmi D1 à D16 :

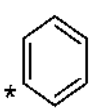 (D1), 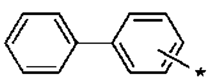 (D2), 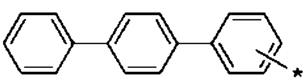 (D3), 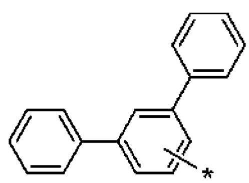 (D4),

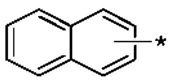 (D5), 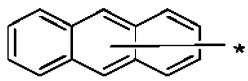 (D6), 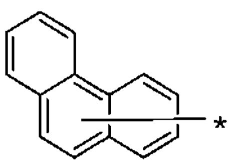 (D7),

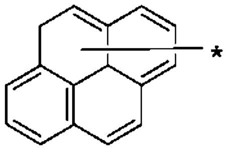 (D8),

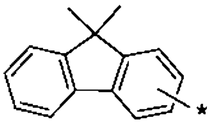 (D9), 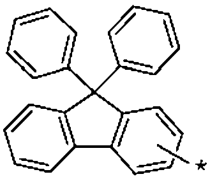 (D10), 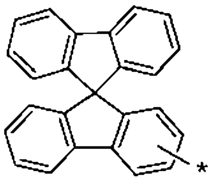 (D11),

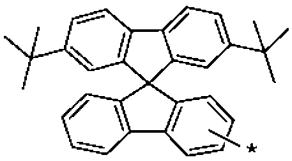 (D12), 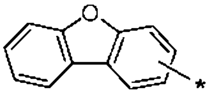 (D13), 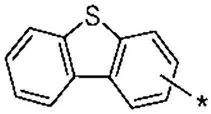 (D14),

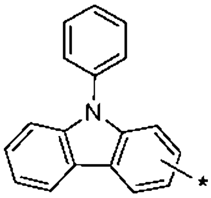 (D15), 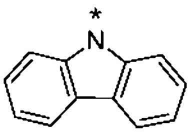 (D16),

l'astérisque « * » désignant la position de liaison.

**13.** Dispositif organique électroluminescent selon l'une quelconque des revendications 1 à 12, dans lequel l'au moins un composé de transport de trous et/ou les formules (IIa) et/ou (IIb) - le cas échéant - sont choisi(e)s parmi F1 à F18 :

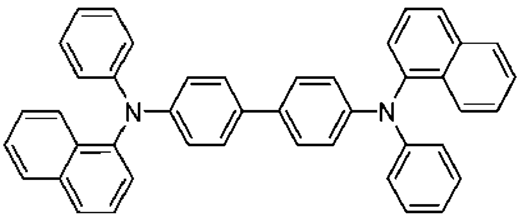 (F1), 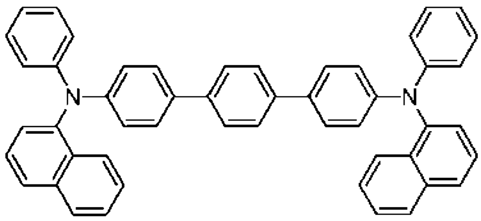 (F2),

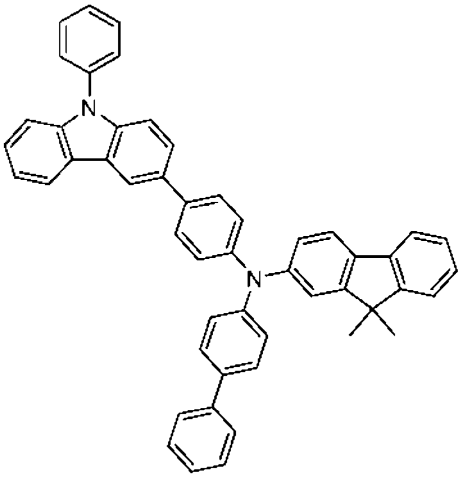
(F3),

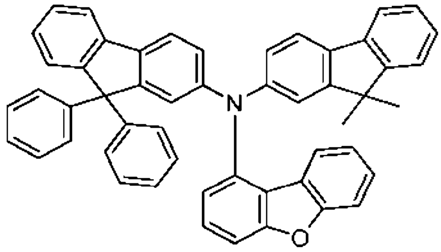
(F4),

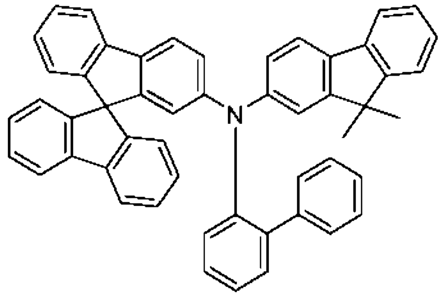
(F5),

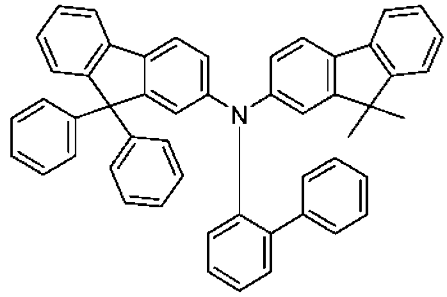
(F6),

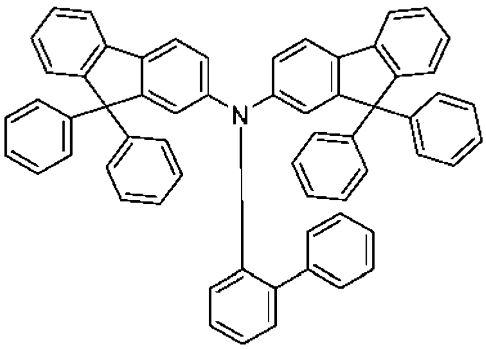
(F7),

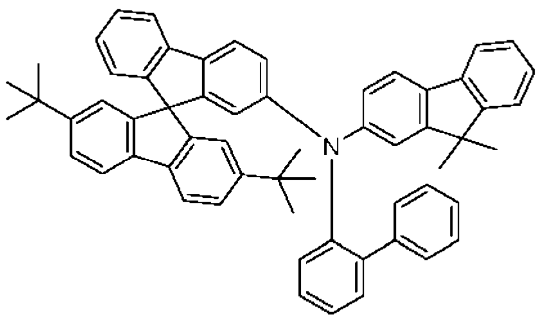
(F8),

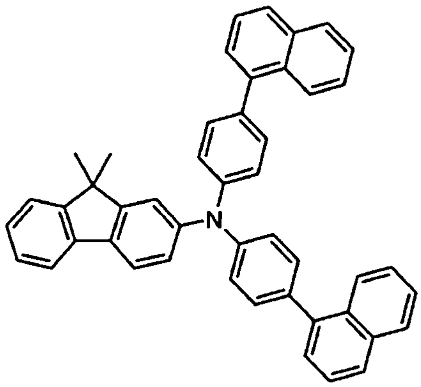
(F9),

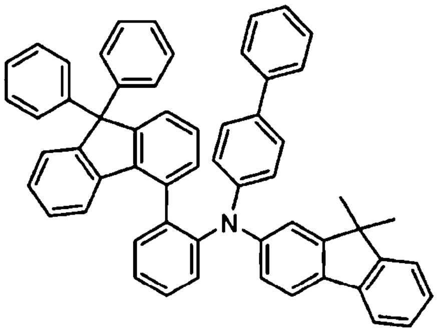
(F10),

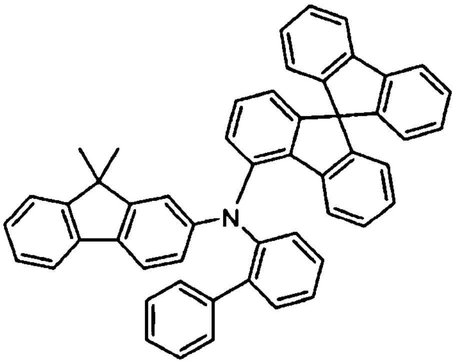
(F11),

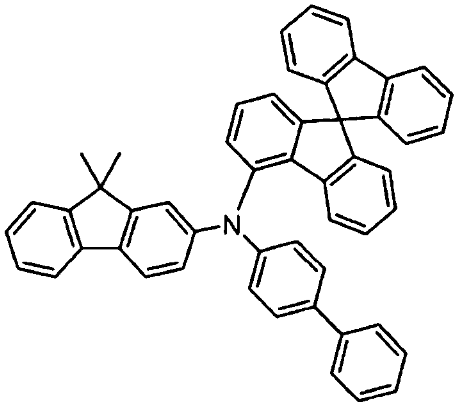
(F12),

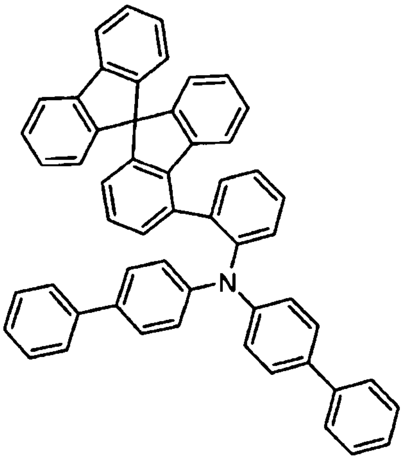
(F13),

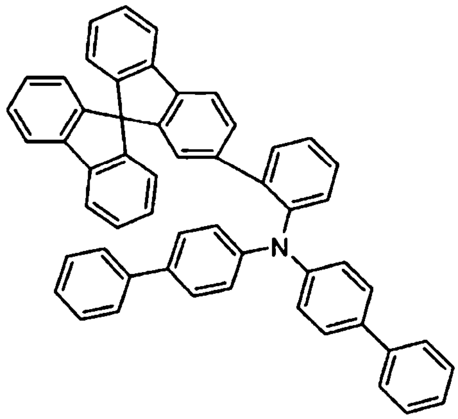
(F14),

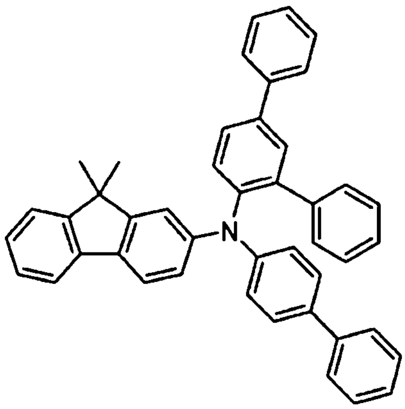
(F15),

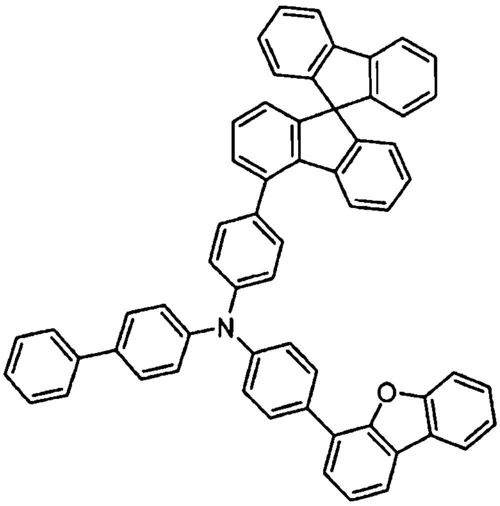
(F16),

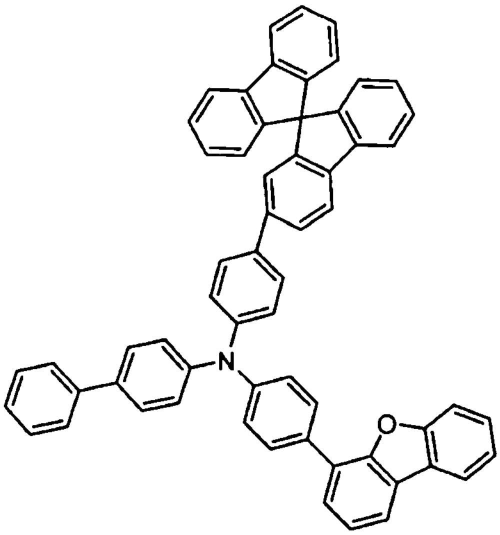

(F17)

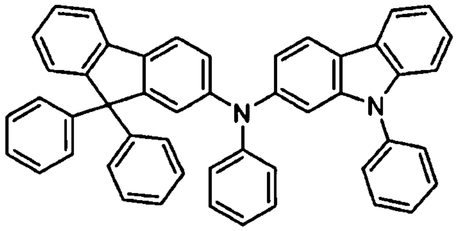

(F18).

**14.** Dispositif d'affichage comprenant un dispositif électroluminescent organique selon l'une quelconque des revendications 1 à 13.

**15.** Procédé de préparation d'un dispositif organique électroluminescent, préférablement d'un dispositif organique électroluminescent selon l'une quelconque des revendications 1 à 13, comprenant les étapes de :

- formation d'une couche de génération de charge de type n par dépôt d'un composé de matrice et dépôt d'un dopant métallique ;
- formation d'une couche intermédiaire par dépôt d'un composé de transport de trous constitué essentiellement par au moins un composé choisi parmi une arylamine, une diarylamine, une triarylamine, (IIa), et la formule (IIb)
- formation d'une couche de génération de charge de type p par dépôt d'un composé de matrice de transport de trous constitué essentiellement par au moins un composé choisi parmi une arylamine, une diarylamine, une triarylamine, la formule (IIa) et la formule (IIb), et dépôt d'un radialène de formule (I).

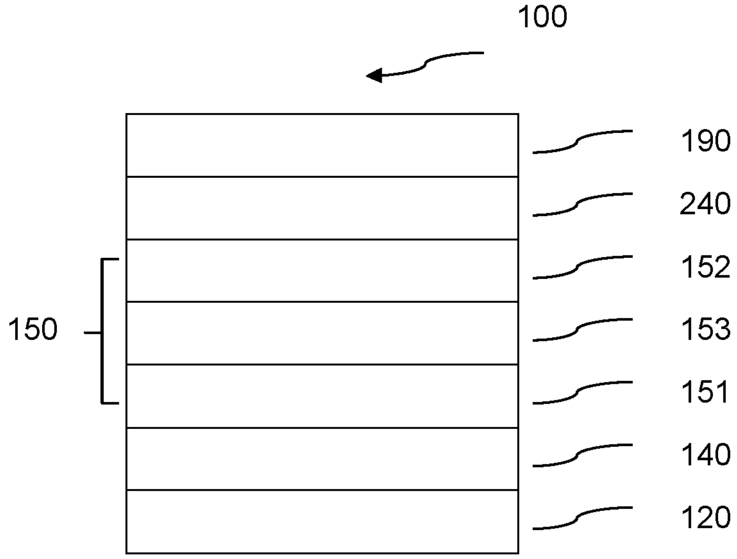
100
190
240
152
153
151
140
120
150

Fig. 1

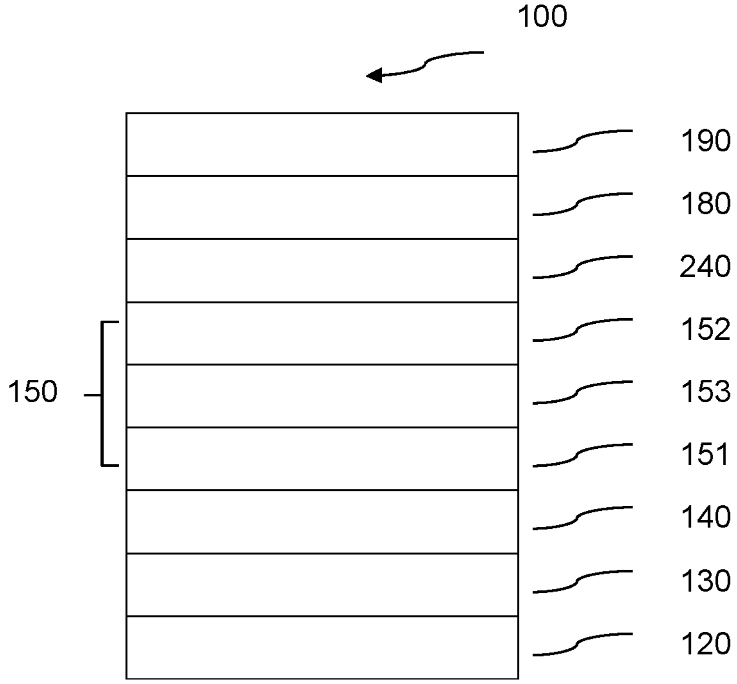
100
190
180
240
152
153
151
140
130
120
150

Fig. 2

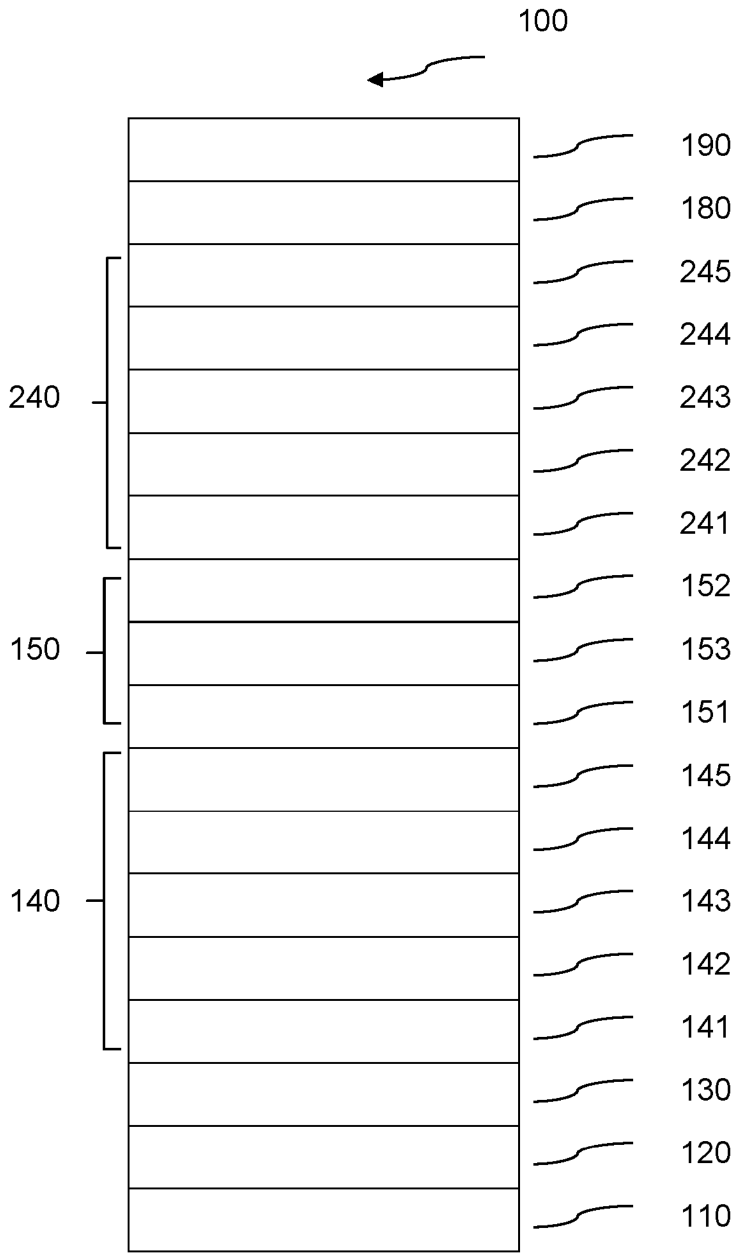
100
190
180
245
244
243
242
241
152
153
151
145
144
143
142
141
130
120
110
240
150
140

Fig. 3

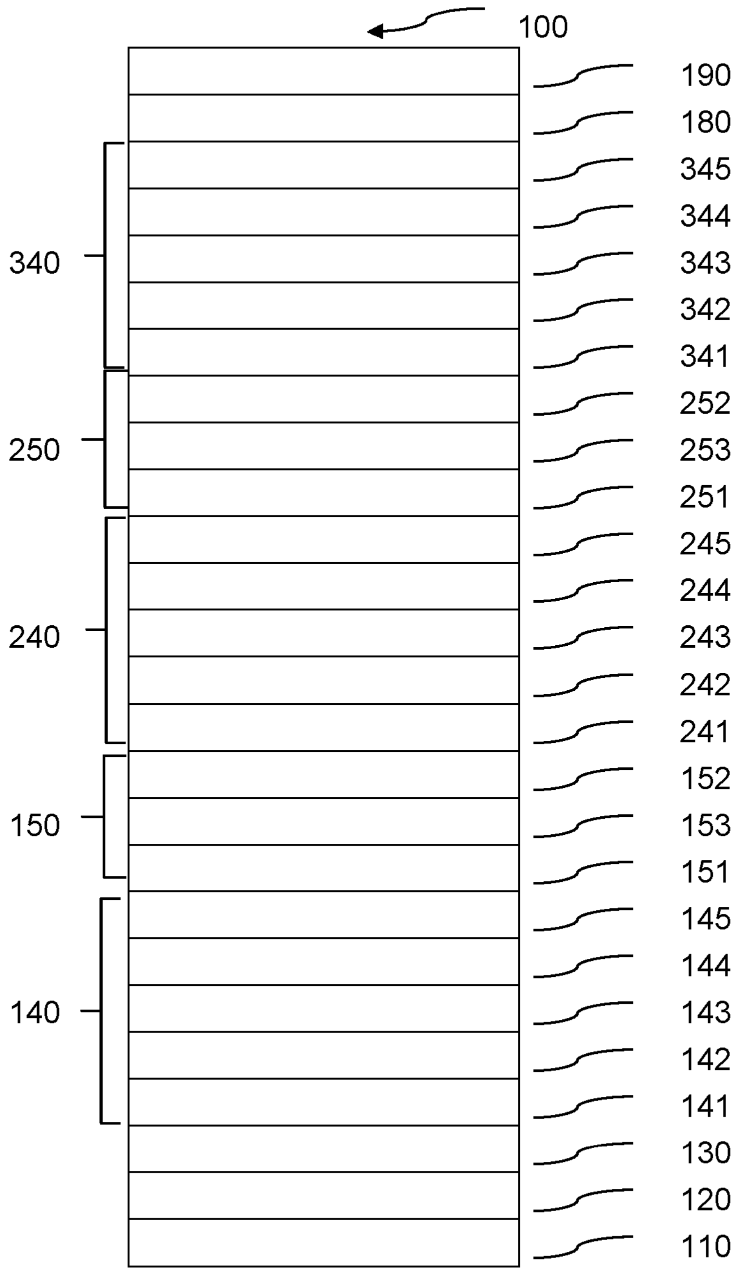
100
190
180
345
344
343
342
341
252
253
251
245
244
243
242
241
152
153
151
145
144
143
142
141
130
120
110
340
250
240
150
140

Fig. 4

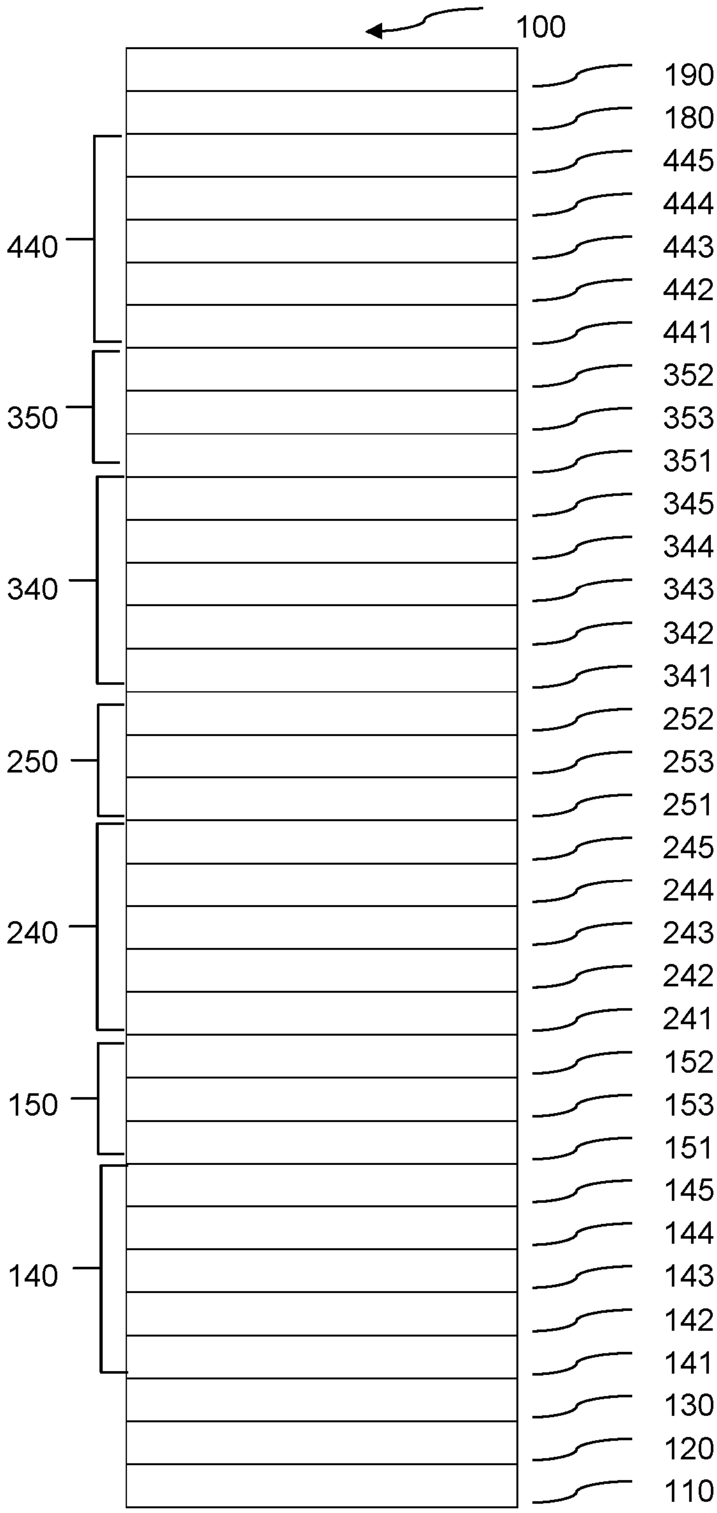
100
190
180
445
444
443
442
441
352
353
351
345
344
343
342
341
252
253
251
245
244
243
242
241
152
153
151
145
144
143
142
141
130
120
110
440
350
340
250
240
150
140

Fig. 5

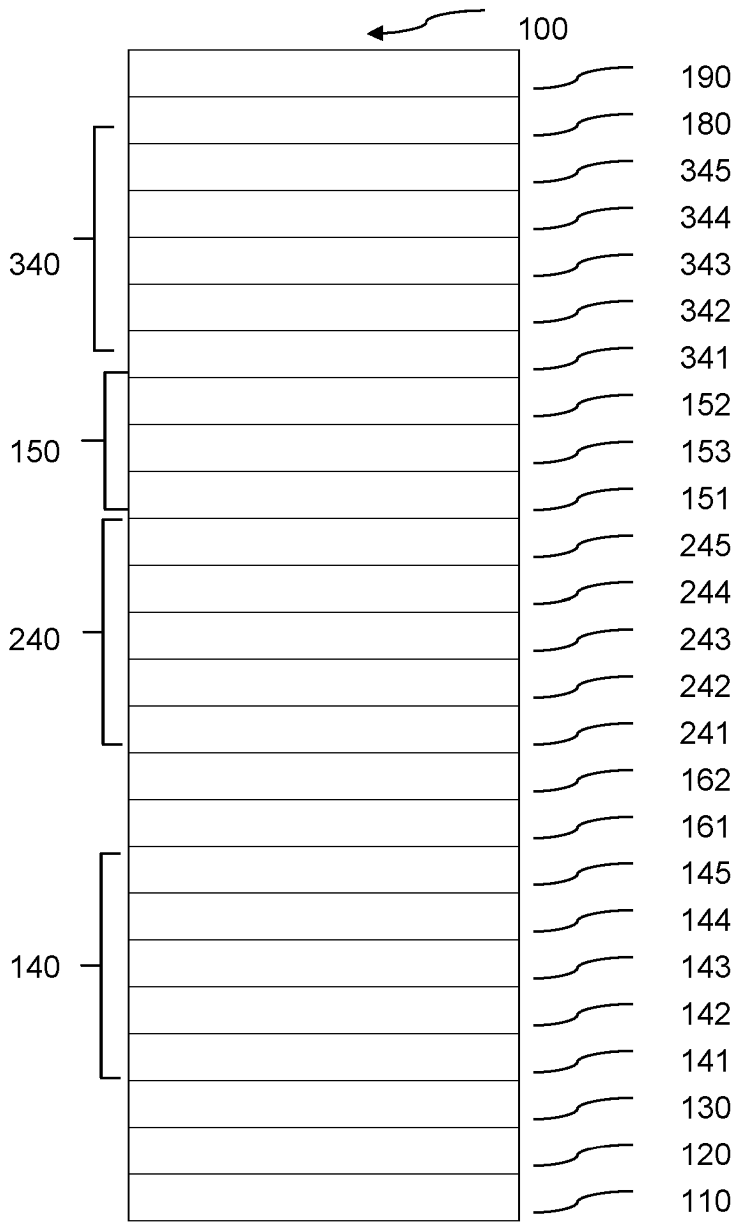
100
190
180
345
344
343
342
341
152
153
151
245
244
243
242
241
162
161
145
144
143
142
141
130
120
110
340
150
240
140

Fig. 6

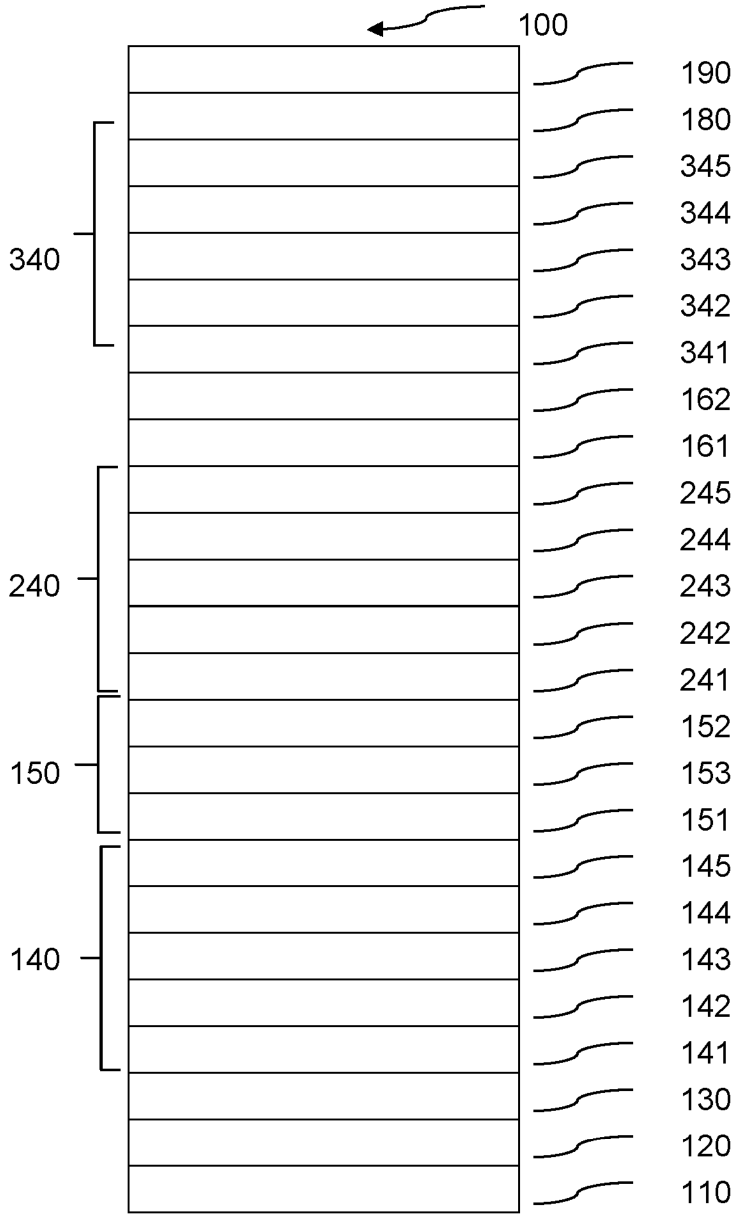
100
190
180
345
344
343
342
341
162
161
245
244
243
242
241
152
153
151
145
144
143
142
141
130
120
110
340
240
150
140

Fig. 7

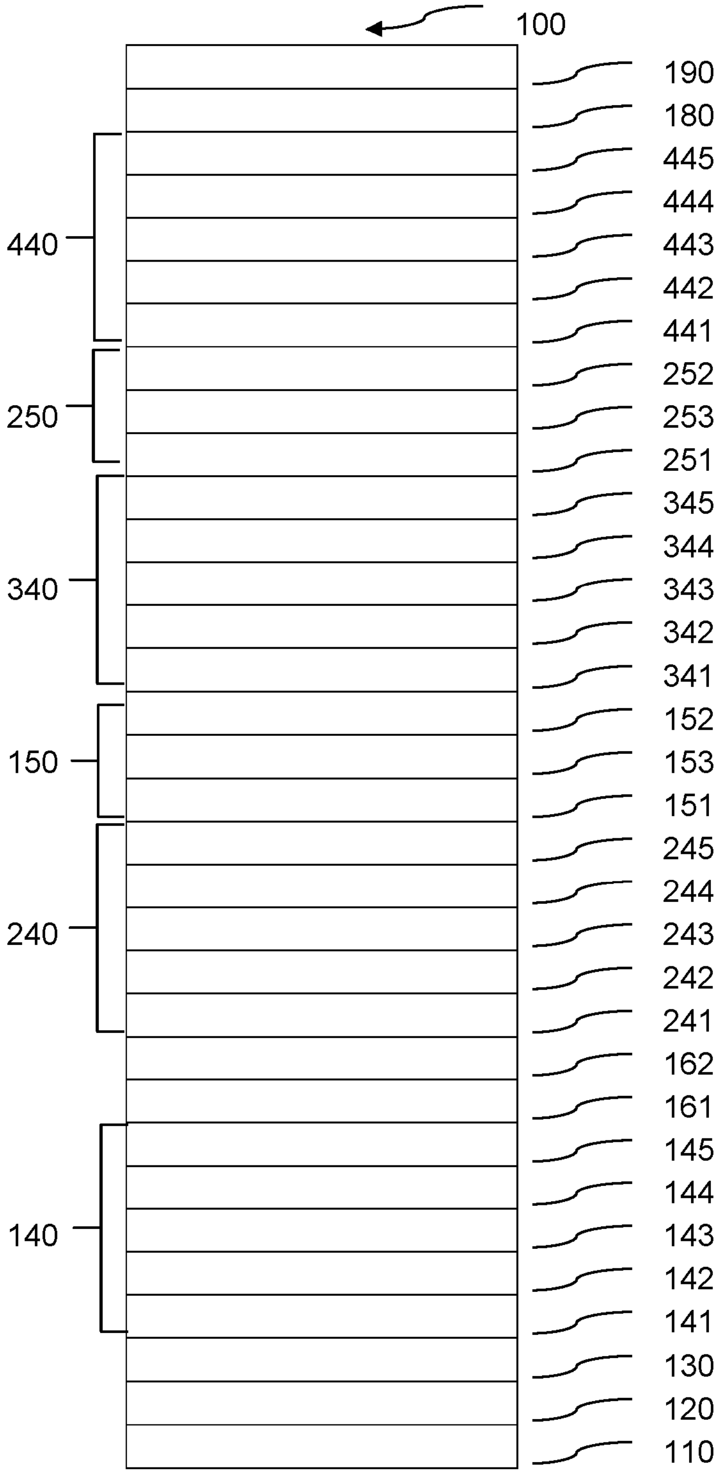
100
190
180
445
444
443
442
441
252
253
251
345
344
343
342
341
152
153
151
245
244
243
242
241
162
161
145
144
143
142
141
130
120
110
440
250
340
150
240
140

Fig. 8

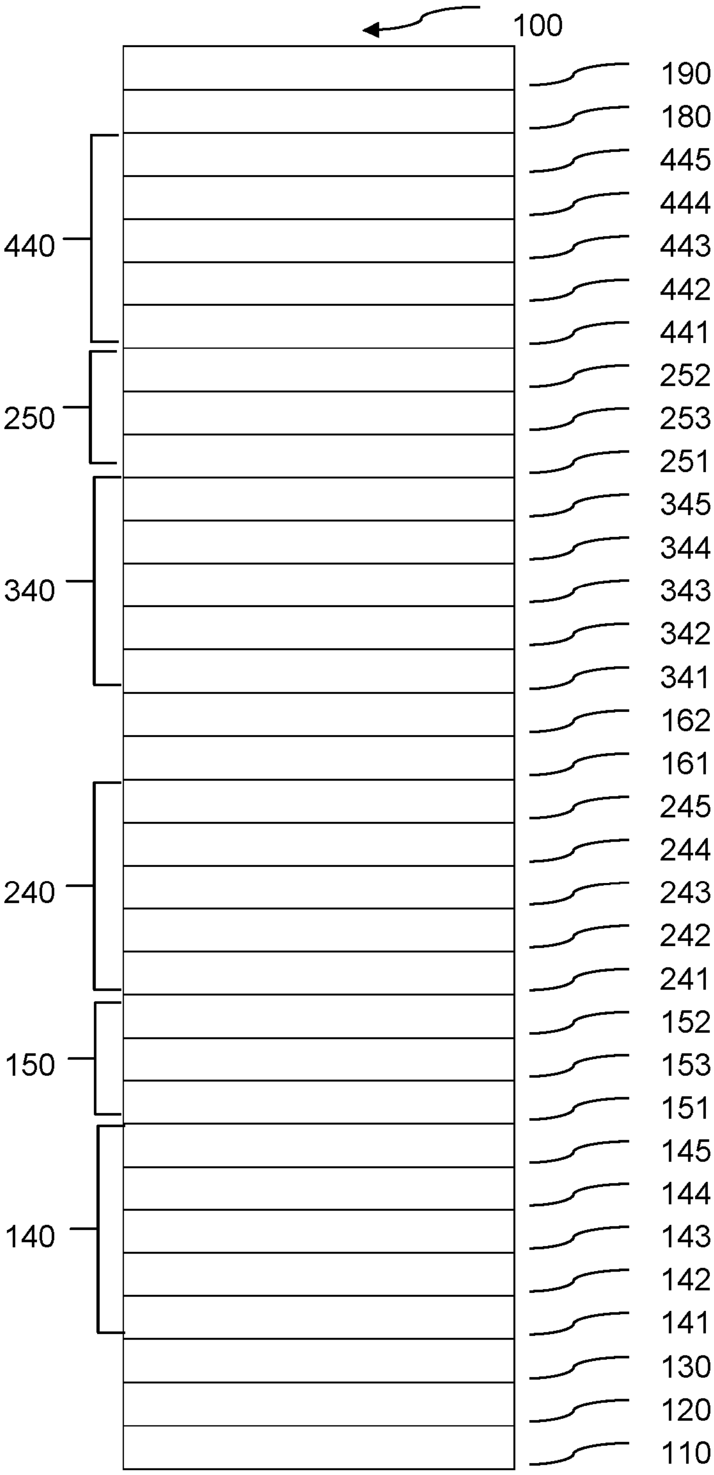
100
190
180
445
444
443
442
441
252
253
251
345
344
343
342
341
162
161
245
244
243
242
241
152
153
151
145
144
143
142
141
130
120
110
440
250
340
240
150
140

Fig. 9

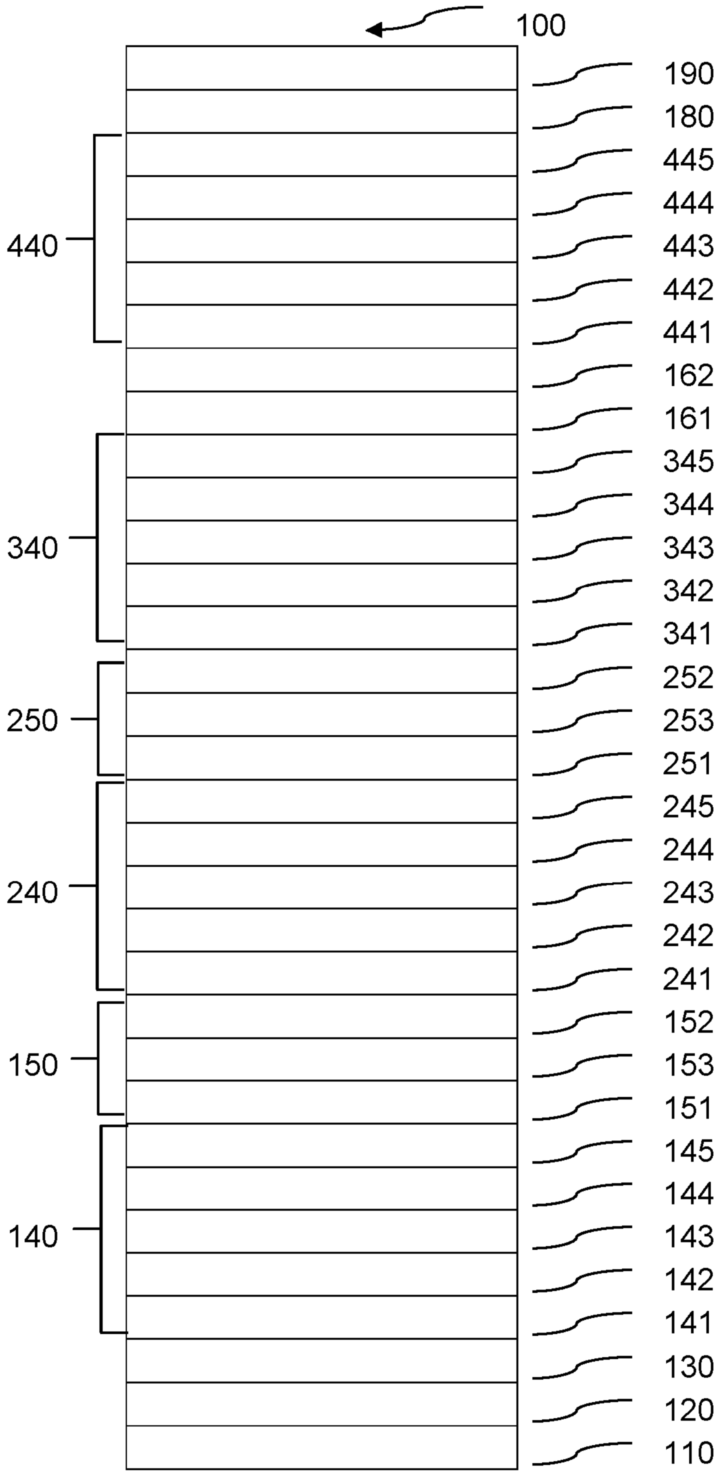
100
190
180
445
444
443
442
441
162
161
345
344
343
342
341
252
253
251
245
244
243
242
241
152
153
151
145
144
143
142
141
130
120
110
440
340
250
240
150
140

Fig. 10

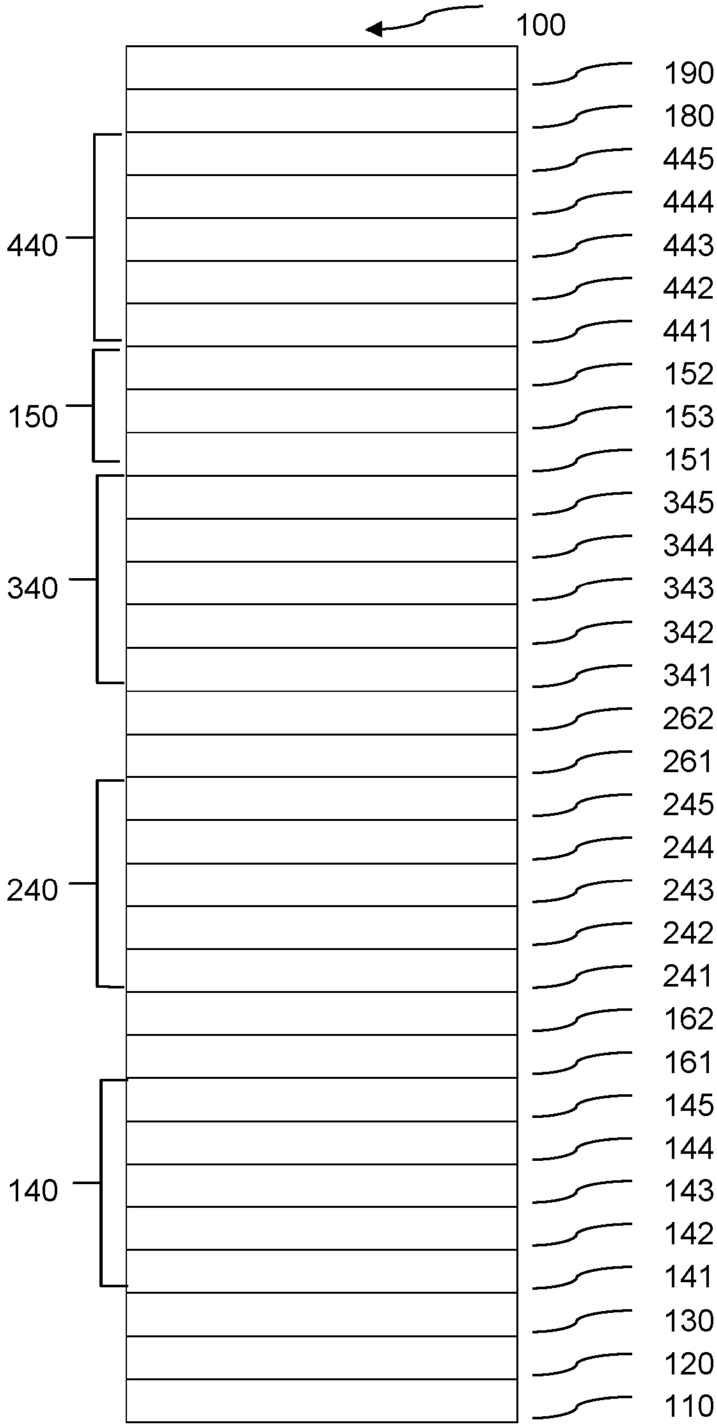
100
190
180
445
444
443
442
441
152
153
151
345
344
343
342
341
262
261
245
244
243
242
241
162
161
145
144
143
142
141
130
120
110
440
150
340
240
140

**Fig. 11**

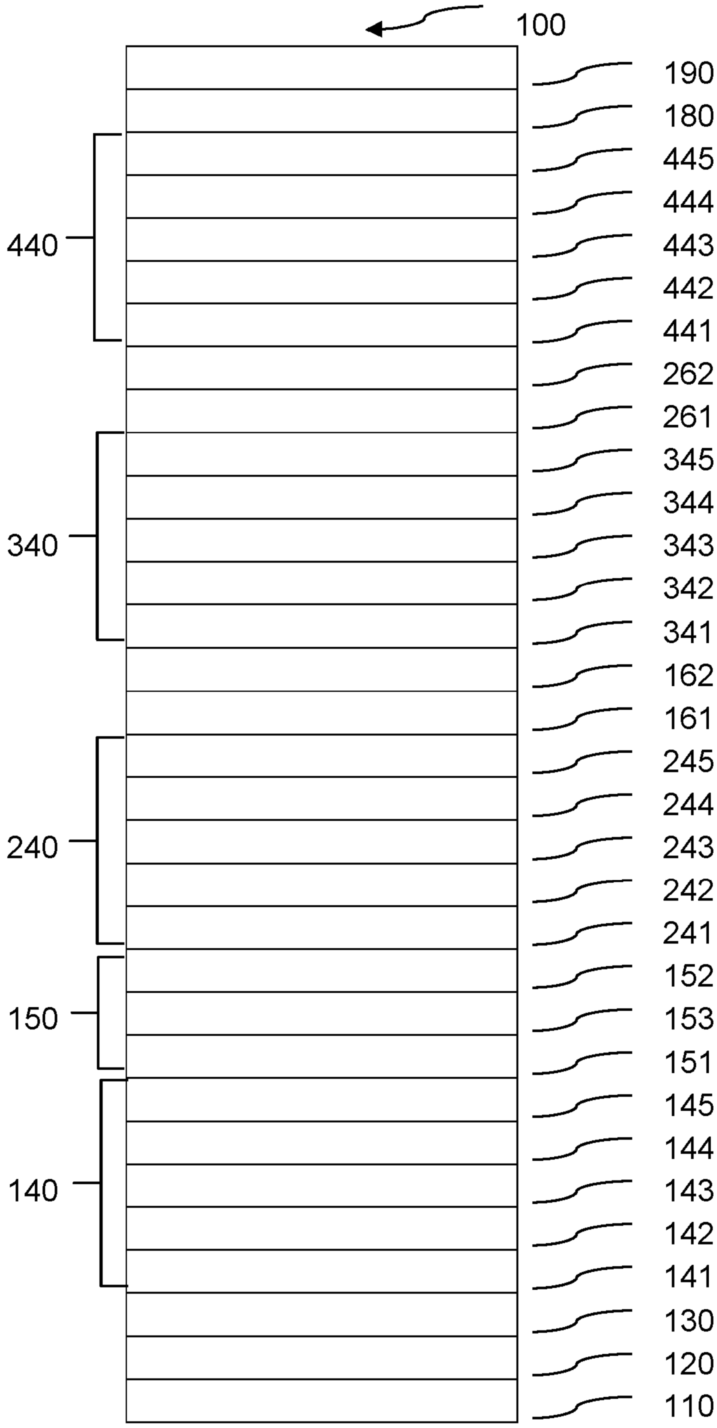
100
190
180
445
444
443
442
441
262
261
345
344
343
342
341
162
161
245
244
243
242
241
152
153
151
145
144
143
142
141
130
120
110
440
340
240
150
140

Fig. 12

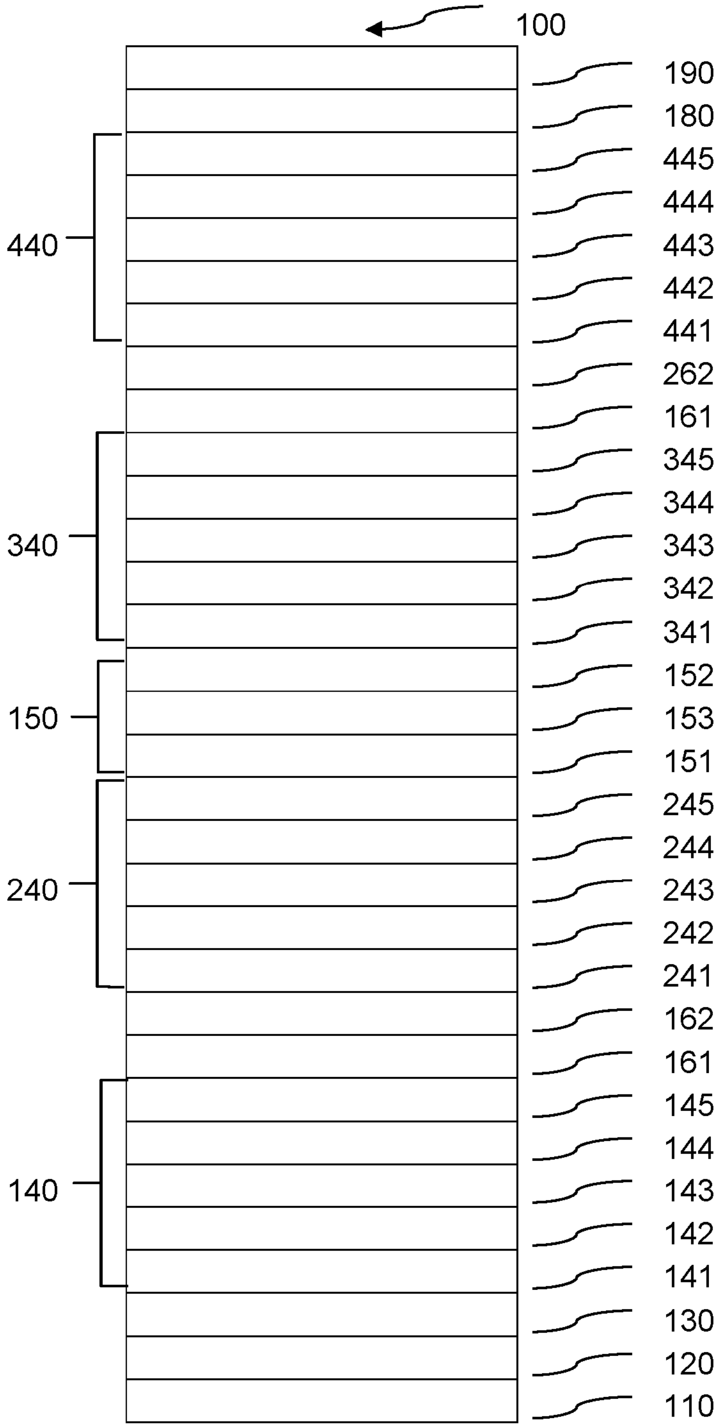
100
190
180
445
444
443
442
441
262
161
345
344
343
342
341
152
153
151
245
244
243
242
241
162
161
145
144
143
142
141
130
120
110
440
340
150
240
140

Fig. 13

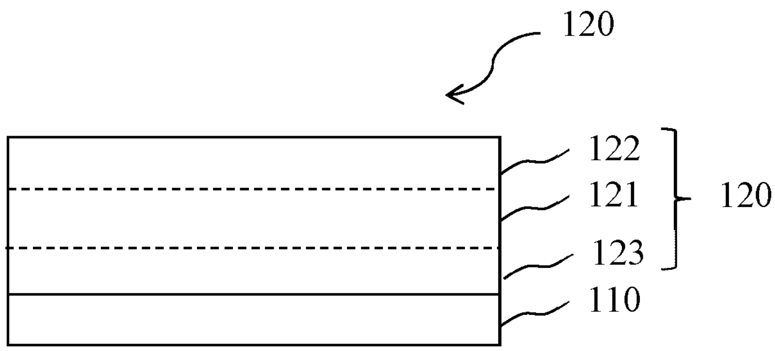


Fig. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 8603642 B2
- EP 3989305 A1
- EP 2722908 A1
- EP 2180029 A1
- WO 2016097017 A1


### Non-patent literature cited in the description


- **YASUHIKO SHIROTA** ; **HIROSHI KAGEYAMA**. *Chem. Rev.*, 2007, vol. 107, 953-1010